# EUROPEAN PATENT APPLICATION

(11) **EP 4 613 754 A1**
(43) Date of publication of application: **10.09.2025**
(21) Application number: 25159610.2
(22) Date of filing: 24.02.2025
(51) Int. Cl.: C07F 15/00, C09K 11/06, H10K 85/30

(54) **ORGANOMETALLIC COMPOUND, LIGHT-EMITTING DEVICE INCLUDING THE SAME, AND ELECTRONIC APPARATUS INCLUDING THE LIGHT-EMITTING DEVICE**

(30) Priority: 07.03.2024 KR 20240032837
(71) Applicant: Samsung Electronics Co., Ltd., Suwon-si, Gyeonggi-do 16677 (KR)
(72) Inventor: LEE, Hongsoo, 16678 Suwon-si (KR); KIM, Jiheon, 16678 Suwon-si (KR); KIM, Taekjung, 16678 Suwon-si (KR); LEE, Sunghun, 16678 Suwon-si (KR); LEE, Yong Joo, 16678 Suwon-si (KR); CHOI, Byoungki, 16678 Suwon-si (KR); CHU, Jungok, 16678 Suwon-si (KR); KOISHIKAWA, Yasushi, 16678 Suwon-si (KR); HONG, Sunghun, 16678 Suwon-si (KR)
(74) Representative: Elkington and Fife LLP

(57) **Abstract**

An organometallic compound represented by Formula 1:

Formula 1 M(L₁)ₙ₁(L₂)ₙ₂

wherein M is a transition metal, L₁ is a ligand represented by Formula 2-1, L₂ is a ligand represented by Formula 2-2, n1 and n2 are each independently 1 or 2, and L₁ and L₂ are different from each other: 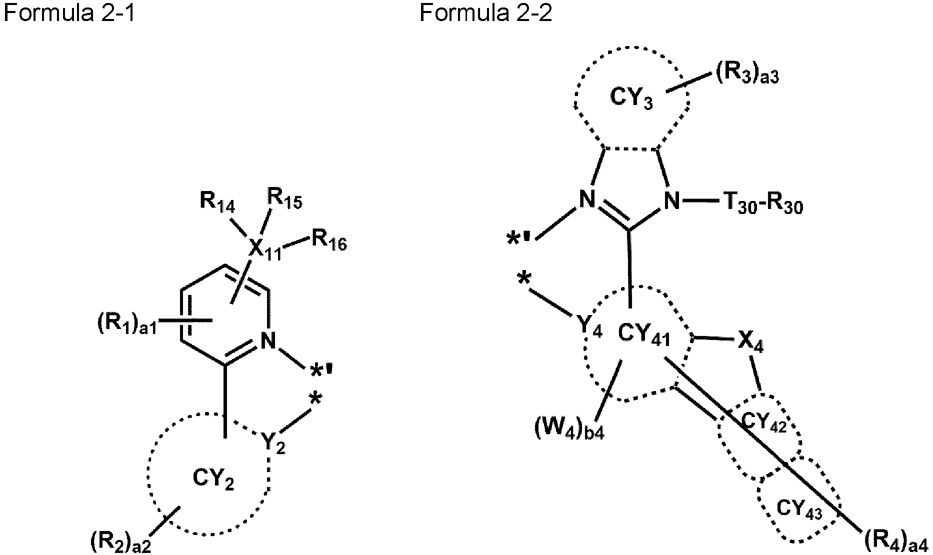 wherein Y₂ and Y₄ are each independently C or N; ring CY₂, ring CY₃, and ring CY₄₁ to ring CY₄₃ are each independently a C₅-C₃₀ carbocyclic group or a C₁-C₃₀ heterocyclic group; X₁₁ is C, Si, or Ge; X₄ is O, S, Se, N(R₄₈), C(R₄₈)(R₄₉), or Si(R₄₈)(R₄₉); b4 is an integer from 1 to 10; * and *' each indicate a binding site to M in Formula 1; and the remaining substituents are as described herein.

## Description

### FIELD OF THE INVENTION

The disclosure relates to an organometallic compound, a light-emitting device including the same, and an electronic apparatus including the light-emitting device.

### BACKGROUND OF THE INVENTION

From among light-emitting devices (OLEDs), organic light-emitting devices are self-emission devices, which have improved characteristics in terms of viewing angles, response time, luminance, driving voltage, and response speed. In addition, OLEDs can produce full-color images.

In an example, an organic light-emitting device includes an anode, a cathode, and an interlayer that is arranged between the anode and the cathode and includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

### SUMMARY OF THE INVENTION

Provided are an organometallic compound, a light-emitting device using the same, and an electronic apparatus including the light-emitting device.

Additional aspects will be set forth in part in the detailed description that follows and, in part, will be apparent from the detailed description, or may be learned by practice of the presented exemplary embodiments described herein.

According to an aspect, an organometallic compound represented by Formula 1 is provided:

Formula 1 M(L₁)ₙ₁(L₂)ₙ₂

wherein, in Formula 1,
M is a transition metal,
L₁ is a ligand represented by Formula 2-1,
L₂ is a ligand represented by Formula 2-2,
n1 and n2 are each independently 1 or 2, wherein, when n1 is 2, two of L₁ are identical to or different from each other, and when n2 is 2, two of L₂ are identical to or different from each other,
L₁ and L₂ are different from each other, 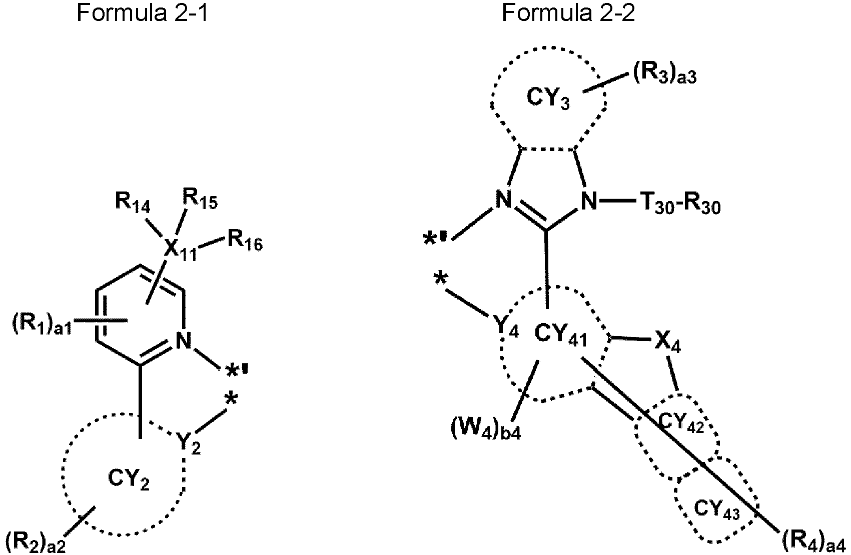 wherein, in Formulae 2-1 and 2-2,
   Y₂ and Y₄ are each independently C or N,
   ring CY₂, ring CY₃, and ring CY₄₁ to ring CY₄₃ are each independently a C₅-C₃₀ carbocyclic group or a C₁-C₃₀ heterocyclic group,
   X₁₁ is C, Si, or Ge,
   T₃₀ is a single bond, a C₁-C₂₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ,
   X₄ is O, S, Se, N(R₄₈), C(R₄₈)(R₄₉), or Si(R₄₈)(R₄₉),
   R₁ to R₄, R₁₄ to R₁₆, R₃₀, R₄₈, and R₄₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), - B(Q₆)(Q₇), -P(=O)(Q₈)(Q₉), or -P(Q₈)(Q₉),
   a1 is an integer from 0 to 3,
   a2 to a4 are each independently an integer from 0 to 20,
   W₄ is a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group,
   b4 is an integer from 1 to 10,
   two or more of a plurality of R₁ are optionally linked to each other to form a C₅-C₃₀ carbocyclic group unsubstituted or substituted with at least one R₁₆ₐ, or a C₁-C₃₀ heterocyclic group unsubstituted or substituted with at least one R₁₀ₐ,
   two or more of a plurality of R₂ are optionally be linked to each other to form a C₅-C₃₀ carbocyclic group that is unsubstituted or substituted with at least one R₁₆ₐ, or a C₁-C₃₀ heterocyclic group that is unsubstituted or substituted with at least one R₁₀ₐ,
   two or more of a plurality of R₃ are optionally linked to each other to form a C₅-C₃₀ carbocyclic group unsubstituted or substituted with at least one R₁₆ₐ, or a C₁-C₃₀ heterocyclic group unsubstituted or substituted with at least one R₁₀ₐ,
   two or more of a plurality of R₄ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
   two or more of R₁ to R₄ and R₃₀ are optionally linked to each other to form a C₅-C₃₀ carbocyclic group unsubstituted or substituted with at least one R₁₆ₐ, or a C₁-C₃₀ heterocyclic group unsubstituted or substituted with at least one R₁₆ₐ,
   R₁₀ₐ is as described in connection with R₂,
   * and *' each indicate a binding site to M in Formula 1,
   a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
      deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
      a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), - P(=O)(Q₁₈)(Q₁₉), -P(Q₁₈)(Q₁₉), or a combination thereof,
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(=O)(Q₂₈)(Q₂₉), P(Q₂₈)(Q₂₉), or a combination thereof,
      -Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(=O)(Q₃₈)(Q₃₉), or -P(Q₃₈)(Q₃₉), or
      a combination thereof, and
      Q₁ to Q₉, Q₁₁ to Q₁₉, Q₂₁ to Q₂₉ and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to another aspect, a light-emitting device includes a first electrode, a second electrode, and an interlayer disposed between the first electrode and the second electrode, wherein the interlayer includes an emission layer, and wherein the interlayer further includes at least one of the organometallic compounds represented by Formula 1.

According to another aspect, an electronic apparatus includes the light-emitting device.

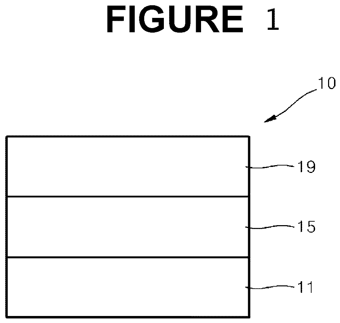

### BRIEF DESCRIPTION OF THE DRAWING

The above and other aspects, features, and advantages of certain exemplary embodiments will be more apparent from the following detailed description taken in conjunction with the FIGURE, which shows a schematic cross-sectional view of a light-emitting device according to one or more embodiments.

### DETAILED DESCRIPTION OF THE EMBODIMENTS

Reference will now be made in detail to exemplary embodiments, examples of which are illustrated in the accompanying drawing, wherein like reference numerals refer to like elements throughout the specification. In this regard, the present embodiments may have different forms and should not be construed as being limited to the descriptions set forth herein. Accordingly, the embodiments are merely described below, by referring to the figure, to explain certain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

As used herein, an "energy level" (e.g., a triplet (T₁) energy level) is expressed as an absolute value from a vacuum level. In addition, when the energy level is referred to as being "deep," "high," or "large," the energy level has a large absolute value based on "0 electron Volts (eV)" of the vacuum level, and when the energy level is referred to as being "shallow," "low," or "small," the energy level has a small absolute value based on "0 eV" of the vacuum level.

An organometallic compound according to an aspect is represented by Formula 1:

Formula 1 M(L₁)ₙ₁(L₂)ₙ₂

wherein M in Formula 1 is a transition metal.

For example, M may be a first row transition metal of the Periodic Table of Elements, a second row transition metal of the Periodic Table of Elements, or a third row transition metal of the Periodic Table of Elements.

In one or more embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In one or more embodiments, M may be iridium (Ir), platinum (Pt), osmium (Os), or rhodium (Rh).

In Formula 1, L₁ is a ligand represented by Formula 2-1, and L₂ is a ligand represented by Formula 2-2:

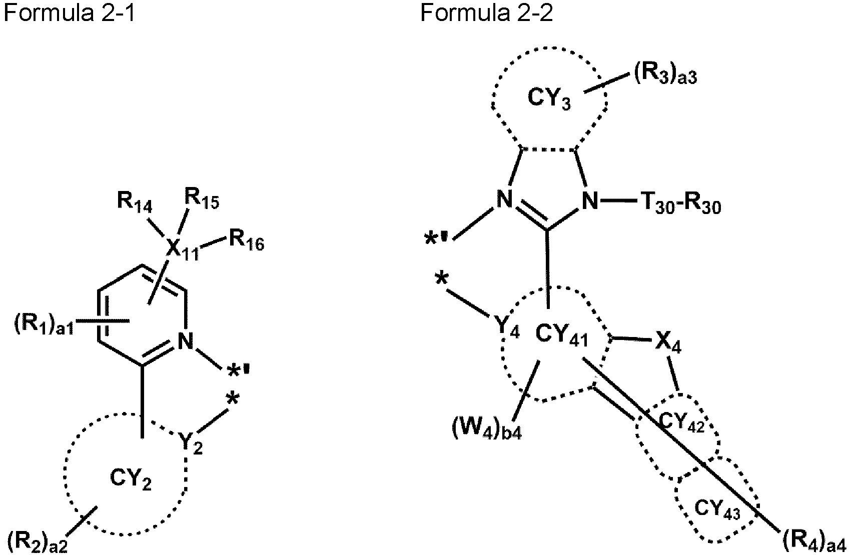

Formula 2-1 and Formula 2-2 may each be the same as described herein.
n1 and n2 in Formula 1 respectively represent the number of ligand(s) L₁ and the number of ligand(s) L₂, and are each independently 1 or 2. When n1 is 2, two L₁ are the same as or different from each other, and when n2 is 2, two L₂ are the same as or different from each other.

For example, in Formula 1, i) n1 may be 2 and n2 may be 1; or ii) n1 may be 1 and n2 may be 2.

In one or more embodiments, in Formula 1, i) M may be iridium (Ir) or osmium (Os) and a sum of n1 and n2 may be 3 or 4; or ii) M may be platinum (Pt) and the sum of n1 and n2 may be 2. In Formula 1, M may be iridium (Ir), and a sum of n1 and n2 may be 3.

L₁ and L₂ in Formula 1 are different from each other.

Y₂ and Y₄ in Formula 2-1 and Formula 2-2 are each independently C or N.

For example, Y₂ and Y₄ may each be C.

Ring CY₂, ring CY₃, and ring CY₄₁ to ring CY₄₃ in Formula 2-1 and Formula 2-2 are each independently a C₅-C₃₀ carbocyclic group or a C₁-C₃₀ heterocyclic group.

For example, ring CY₂, ring CY₃, and ring CY₄₁ to ring CY₄₃ may each independently be i) a first ring, ii) a second ring, iii) a condensed ring group in which two or more first rings are condensed with each other, iv) a condensed ring group in which two or more second rings are condensed with each other, or v) a condensed ring group in which one or more first rings and one or more second rings are condensed with each other,
wherein the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
wherein the second ring may be an adamantane group, a norbornane group (bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

According to one or more embodiments, ring CY₂, ring CY₃, and ring CY₄₁ to ring CY₄₃ may each independently be a cyclopentane group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group , an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

According to one or more embodiments, ring CY₂ may be a benzene group, a naphthalene group, an anthracene group, a phenanthrene group, a 1,2,3,4-tetrahydronaphthalene group, a carbazole group, a fluorene group, a dibenzosilole group, a dibenzothiophene group, a dibenzofuran group, a dibenzoselenophene group, a pyridine group, a benzoxazole group, a benzothiazole group, or a benzene group that is condensed with a norbornane group.

According to one or more embodiments, in Formula 2-2, ring CY₃ and ring CY₄₁ to ring CY₄₃ may each independently be i) a Group A, ii) a polycyclic group in which two or more Group A are condensed with each other, or iii) a polycyclic group in which one or more Group A and one or more Group B are condensed with each other,
Group A may be a benzene group, a pyridine group, a pyrimidine group, a pyridazine group, a pyrazine group, or a triazine group, and
Group B may be a cyclohexane group, a norbornane group, a furan group, a thiophene group, a selenophene group, a pyrrole group, a cyclopentadiene group, or a silole group.

According to one or more embodiments, ring CY₃ and ring CY₄₁ to ring CY₄₃ may each independently be:
a benzene group, a pyridine group, a pyrimidine group, a pyridazine group, a pyrazine group, a triazine group, a pyrrole group, a cyclopentadiene group, a silole group, a thiophene group, or a furan group; or
a benzene group, a pyridine group, a pyrimidine group, a pyridazine group, a pyrazine group, a triazine group, a pyrrole group, a cyclopentadiene group, a silole group, a thiophene group, or a furan group, each condensed with at least one of a benzene group, a pyridine group, a pyrimidine group, a pyridazine group, a pyrazine group, a triazine group, a cyclohexane group, a norbornane group, an adamantane group, a pyrrole group, a cyclopentadiene group, a silole group, a thiophene group, a furan group, or a combination thereof.

According to one or more embodiments, ring CY₃ and ring CY₄₁ to ring CY₄₃ may each independently be:
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group; or
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group, each condensed with at least one of a cyclohexane group, a norbornane group, an adamantane group, or a combination thereof.

According to one or more embodiments, ring CY₄₁ and ring CY₄₂ in Formula 2-2 may each independently be a benzene group, a naphthalene group, a benzene group condensed with a cyclohexane group, or a benzene group condensed with a norbornane group.

According to one or more embodiments, ring CY₄₃ in Formula 2-2 may be:
a benzene group, a naphthalene group, a phenanthrene group, an anthracene group, or a chrysene group; or
a benzene group, a naphthalene group, a phenanthrene group, an anthracene group, or a chrysene group, each condensed with at least one of a cyclohexane group, a norbornane group, or a combination thereof.

According to one or more embodiments, L₂ may be a ligand represented by Formula 2-2A: 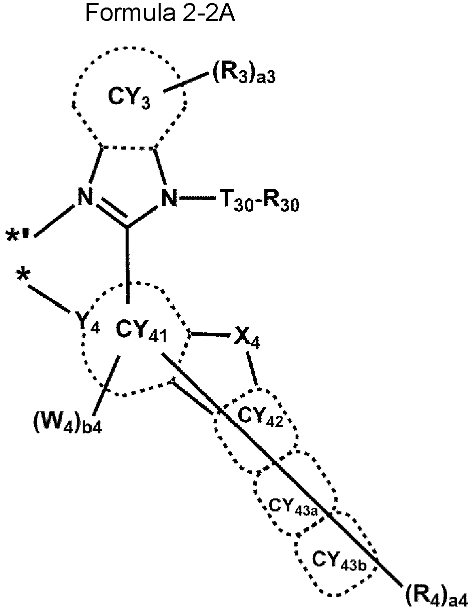 wherein, in Formula 2-2A,
each of Y₄, ring CY₃, ring CY₄₁, ring CY₄₂, T₃₀, X₄, R₃, R₄, R₃₀, a3, a4, W₄, and b4 is as described herein,
ring CY₄₃ₐ and ring CY_{43b} may each independently be a C₆-C₁₅ carbocyclic group or a C₁-C₁₅ heterocyclic group, and
* and *' each indicate a binding site to M in Formula 1.

For example, ring CY₄₃ₐ and ring CY_{43b} may each independently be:
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group; or
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group, each condensed with a cyclohexane group, a norbornane group, an adamantane group, or a combination thereof.

X₁₁ in Formula 2-1 is C, Si, or Ge.

T₃₀ in Formula 2-2 is a single bond, a C₁-C₂₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ.

For example, T₃₀ in Formula 2-2 may be:
a single bond; or
a C₁-C₂₀ alkylene group, a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one R₁₀ₐ.

According to one or more embodiments, T₃₀ in Formula 2-2 may be:
a single bond; or
a benzene group unsubstituted or substituted with at least one R₁₆ₐ.

According to one or more embodiments, T₃₀ may be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

According to one or more embodiments, T₃₀ may be a benzene group having substituents on 2nd position and 6th position and optionally 4th position. The substituents on the 2th position, 6th position and 4th position may each independently deuterium, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, or a combination thereof. The C₁-C₂₀ alkyl group, the deuterated C₁-C₂₀ alkyl group, and the fluorinated C₁-C₂₀ alkyl group may be linear or branched. For example, the C₁-C₂₀ alkyl group, the deuterated C₁-C₂₀ alkyl group, and the fluorinated C₁-C₂₀ alkyl group may be a C₁-C₂₀ linear alkyl group or C₃-C₂₀ branched alkyl group, a deuterated C₁-C₂₀ linear alkyl group or C₃-C₂₀ branched alkyl group, and a fluorinated C₁-C₂₀ linear alkyl group or C₃-C₂₀ branched alkyl group.

X₄ in Formula 2-2 is O, S, Se, N(R₄₈), C(R₄₈)(R₄₉), or Si(R₄₈)(R₄₉). Each of R₄₈ and R₄₉ is as described herein.

For example, X₄ may be O or S.

R₁ to R₄, R₁₄ to R₁₆, R₃₀, R₄₈, and R₄₉ in Formula 2-1 and Formula 2-2 are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - N(Q₄)(Q₅), -B(Q₆)(Q₇), -P(=O)(Q₈)(Q₉), or -P(Q₈)(Q₉). Q₁ to Q₉ are each as described herein.

According to one or more embodiments, R₁ to R₄, R₁₄ to R₁₆, R₃₀, R₄₈, and R₄₉ in Formula 2-1 and Formula 2-2 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a cyclopentyl group, a cyclohexyl group, a cycloheptyl group, a cyclooctyl group, a adamantanyl group, a norbornanyl(bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁ -C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1. 1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, a adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a ( C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazole group, an isothiazole group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, - Si(Q₃₁)(Q₃₂)(Q₃₃), -Ge(Q₃₁)(Q₃₂)(Q₃₃), or a combination thereof; or
-Si(Q₁)(Q₂)(Q₃), -Ge(Q₁)(Q₂)(Q₃), -N(Q₄)(Q₅), -B(Q₆)(Q₇), - P(=O)(Q₈)(Q₉), or -P(Q₈)(Q₉),
wherein Q₁ to Q₉ and Q₃₁ to Q₃₃ are each independently:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₂₀ alkyl group, a phenyl group, or a combination thereof.

According to one or more embodiments, R₁ to R₄, R₃₀, R₄₈, and R₄₉ may each independently be:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, - Si(Q₃₁)(Q₃₂)(Q₃₃),
   -Ge(Q₃₁)(Q₃₂)(Q₃₃), or a combination thereof.

According to one or more embodiments, R₁₄ to R₁₆ may each independently be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

According to one or more embodiments, R₁₄ to R₁₆ in Formula 2-1 may each independently be -CH₃, -CH₂CH₃, -CD₃, -CD₂H, -CDH₂, -CH₂CD₃ or -CD₂CH₃.

According to one or more embodiments, R₁₄ to R₁₆ in Formula 2-1 may be identical to or different from each other.
a1 to a4 in Formula 2-1 and Formula 2-2 each represent the number of R₁ to the number of R₄, where a1 is an integer of 0 to 3, a2 to a4 are each independently an integer of 0 to 20 (for example, an integer of 0 to 10, an integer of 0 to 6, an integer of 0 to 9, or an integer of 0 to 4). When a1 is 2 or more, two or more of R₁ may be identical to or different from each other, when a2 is 2 or more, two or more of R₂ may be identical to or different from each other, when a3 is 2 or more, two or more of R₃ may be identical to or different from each other, and when a4 is 2 or more, two or more of R₄ may be identical to or different from each other.

W₄ in Formula 2-2 is a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to one or more embodiments, W₄ may be -CH₃ (a methyl group).

According to one or more embodiments, W₄ may be -CD₃ (a fully deuterated methyl group).

According to one or more embodiments, W₄ may not be -CH₃ (a methyl group).

According to one or more embodiments, W₄ may not be -CD₃ (a fully deuterated methyl group).

According to one or more embodiments, the number of carbon atoms included in W₄ may be 2 or greater.

According to one or more embodiments, W₄ may be -CD₂H, -CDH₂, -CF₃, - CF₂H, -CFH₂, a substituted or unsubstituted C₂-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to one or more embodiments, W₄ may be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₁)(Q₃₂)(Q₃₃), - Ge(Q₃₁)(Q₃₂)(Q₃₃), or a combination thereof.

According to one or more embodiments, W₄ may be a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₁)(Q₃₂)(Q₃₃), - Ge(Q₃₁)(Q₃₂)(Q₃₃), or a combination thereof.

b4 in Formula 2-2 represents the number of W₄ and is an integer from 1 to 10. When b4 is 2 or more, two or more of W₄ may be identical to or different from each other.

In one or more embodiments, b4 may be 1, 2, or 3.

According to one or more embodiments, b4 may be 1 or 2.

According to one or more embodiments, R₁ to R₄, R₁₄ to R₁₆, R₃₀, R₄₈, and R₄₉ in Formula 2-1 and Formula 2-2 may each independently be hydrogen, deuterium, -F, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, - CH₃, -CD₃, -CD₂H, - CDH₂, -CF₃, -CF₂H, -CFH₂, -OCH₃, -OCDH₂, -OCD₂H, -OCD₃, -SCH₃, -SCDH₂, - SCD₂H, -SCD₃, a group represented by one of Formulae 9-1 to 9-39, a group in which at least one hydrogen of one of Formulae 9-1 to 9-39 is substituted with deuterium, a group in which at least one hydrogen of one of Formulae 9-1 to 9-39 is substituted with -F, a group represented by one of Formulae 9-201 to 9-230, a group in which at least one hydrogen of one of Formulae 9-201 to 9-230 is substituted with deuterium, a group in which at least one hydrogen of one of Formulae 9-201 to 9-230 is substituted with - F, a group represented by one of Formulae 10-1 to 10-145, a group in which at least one hydrogen of one of Formulae 10-1 to 10-145 is substituted with deuterium, a group in which at least one hydrogen of one of Formulae 10-1 to 10-145 is substituted with - F, a group represented by one of Formulae 10-201 to 10-354, a group in which at least one hydrogen of one of Formulae 10-201 to 10-354 is substituted with deuterium, and a group in which at least one hydrogen of one of Formulae 10-201 to 10-354 is substituted with -F, -Si(Q₁)(Q₂)(Q₃), or -Ge(Q₁)(Q₂)(Q₃), wherein each of Q₁ to Q₃ is as described herein.

According to one or more embodiments, at least one of a1 R₁ of Formula 2-1 (for example, R₁₁ in Formula CY1-1) may be a group represented by one of Formulae 9-1 to 9-39, a group in which at least one hydrogen of one of Formulae 9-1 to 9-39 is substituted with deuterium, a group in which at least one hydrogen of one of Formulae 9-1 to 9-39 is substituted with -F, a group represented by one of Formulae 9-201 to 9-230, a group in which at least one hydrogen of one of Formulae 9-201 to 9-230 is substituted with deuterium, a group in which at least one hydrogen of one of Formulae 9-201 to 9-230 is substituted with -F, a group represented by one of Formulae 10-1 to 10-145, a group in which at least one hydrogen of one of Formulae 10-1 to 10-145 is substituted with deuterium, a group in which at least one hydrogen of one of Formulae 10-1 to 10-145 is substituted with -F, a group represented by one of Formulae 10-201 to 10-354, a group in which at least one hydrogen of one of Formulae 10-201 to 10-354 is substituted with deuterium, or a group in which at least one hydrogen of one of Formulae 201 to 10-354 is substituted with -F.

According to one or more embodiments, R₃₀ in Formula 2-2 may be a group represented by one of Formulae 10-12 to 10-145, a group in which at least one hydrogen of one of Formulae 10-12 to 10-145 is substituted with deuterium, a group in which at least one hydrogen of one of Formulae 10-12 to 10-145 is substituted with -F, a group represented by one of Formulae 10-201 to 10-354, a group in which at least one hydrogen of one of Formulae 10-201 to 10-354 is substituted with deuterium, or a group in which at least one hydrogen of one of Formulae 10-201 to 10-354 is substituted with -F.

According to one or more embodiments, W₄ in Formula 2-2 may be -CH₃, -CD₃, -CD₂H, -CDH₂, -CF₃, -CF₂H, -CFH₂, a group represented by one of Formulae 9-1 to 9-39, a group in which at least one hydrogen of one of Formulae 9-1 to 9-39 is substituted with deuterium, a group in which at least one hydrogen of one of Formulae 9-1 to 9-39 is substituted with -F, a group represented by one of Formulae 9-201 to 9-230, a group in which at least one hydrogen of one of Formulae 9-201 to 9-230 is substituted with deuterium, a group in which at least one hydrogen of one of Formulae 9-201 to 9-230 is substituted with -F, a group represented by one of Formulae 10-1 to 10-145, a group in which at least one hydrogen of one of Formulae 10-1 to 10-145 is substituted with deuterium, a group in which at least one hydrogen of one of Formulae 10-1 to 10-145 is substituted with -F, a group represented by one of Formulae 10-201 to 10-354, a group in which at least one hydrogen of one of Formulae 10-201 to 10-354 is substituted with deuterium, or a group in which at least one hydrogen of one of Formulae 201 to 10-354 is substituted with -F:

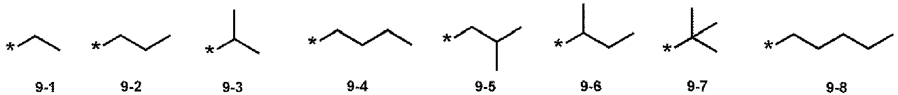

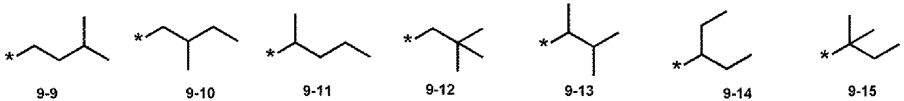

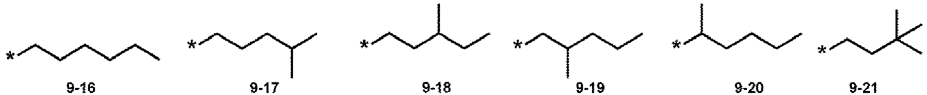

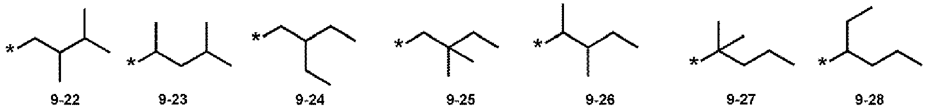

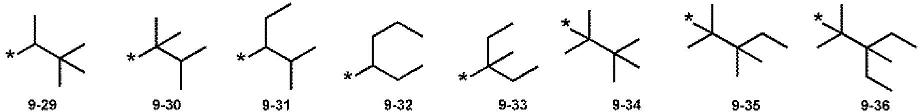

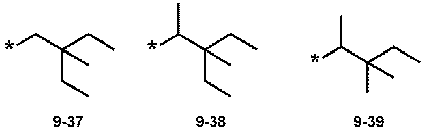

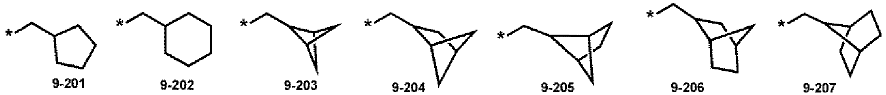

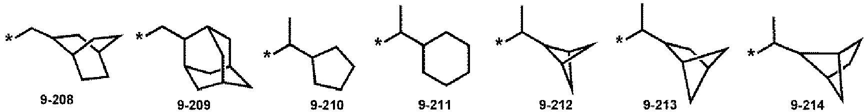

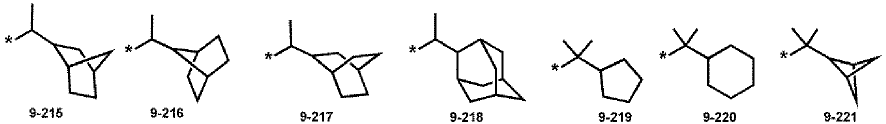

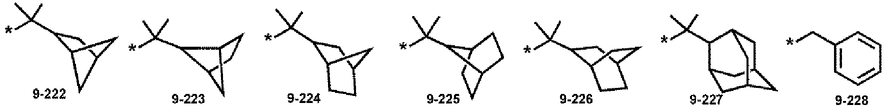

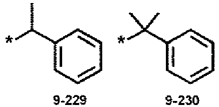

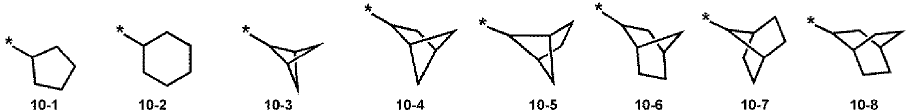

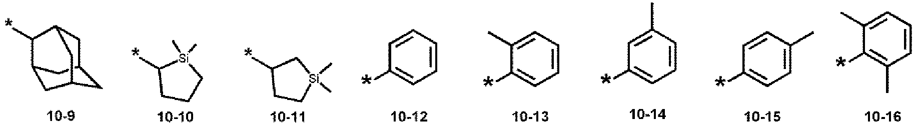

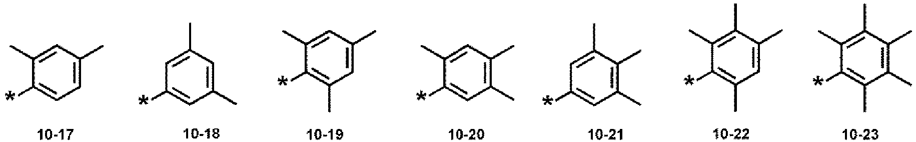

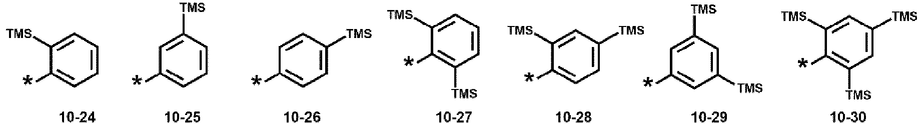

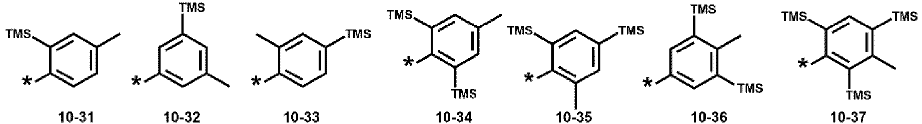

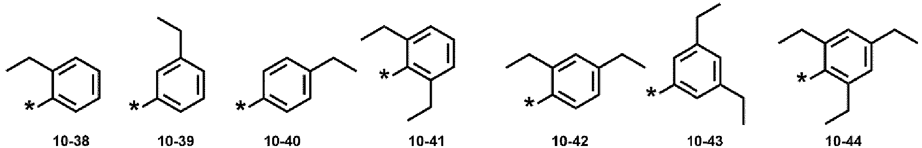

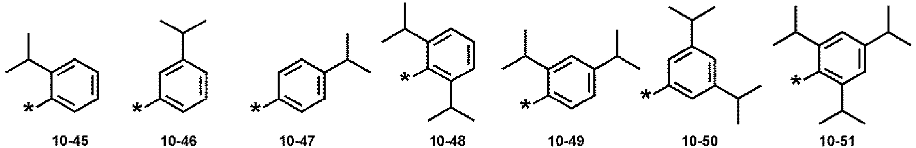

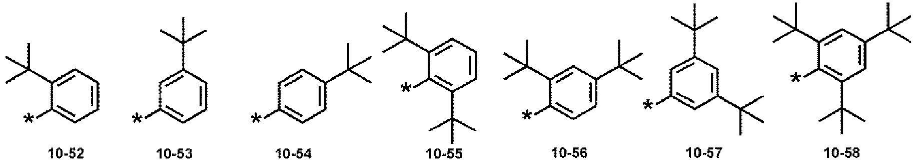

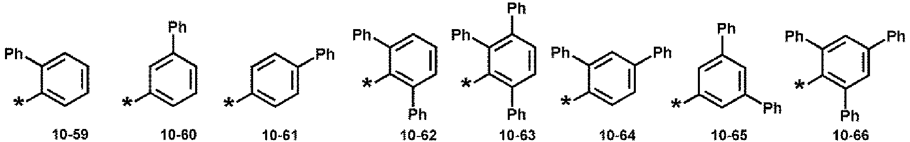

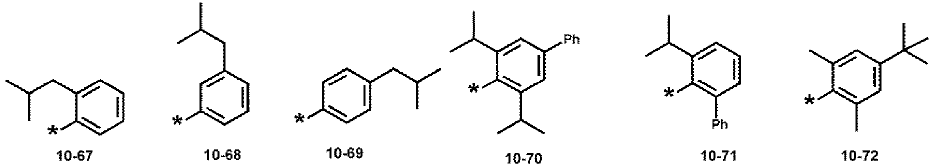

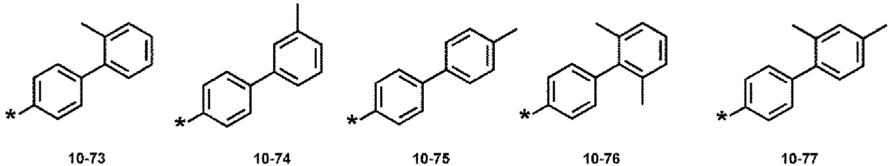

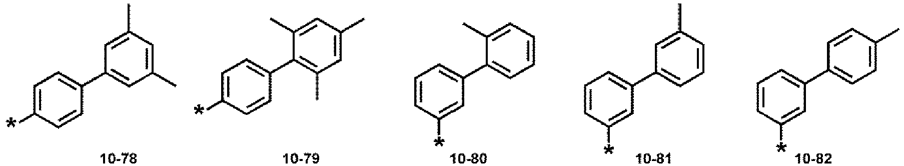

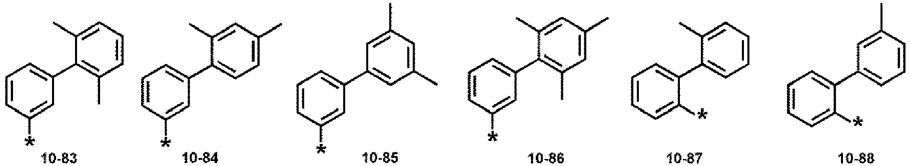

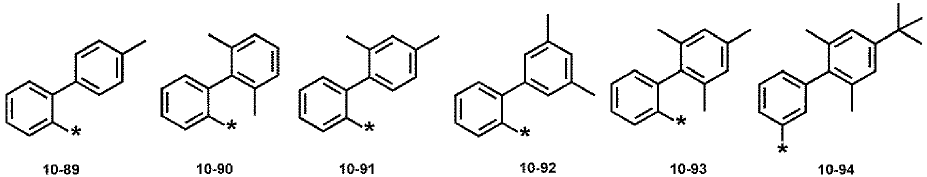

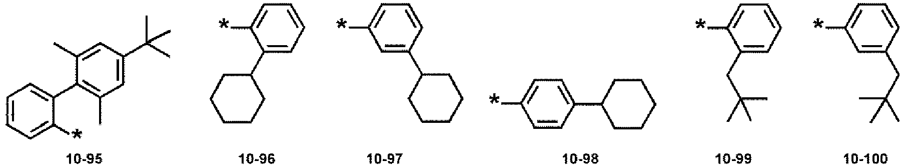

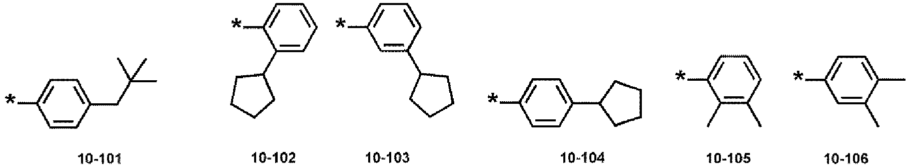

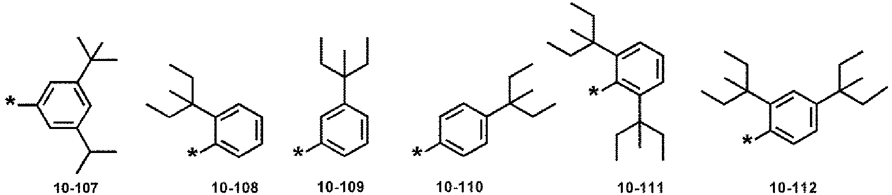

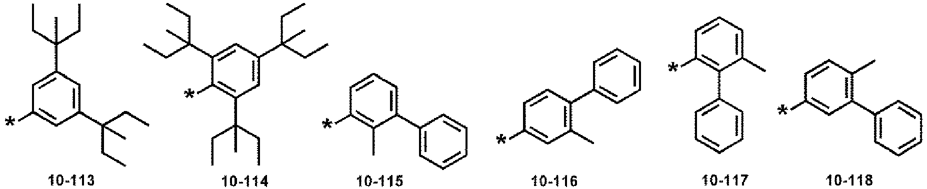

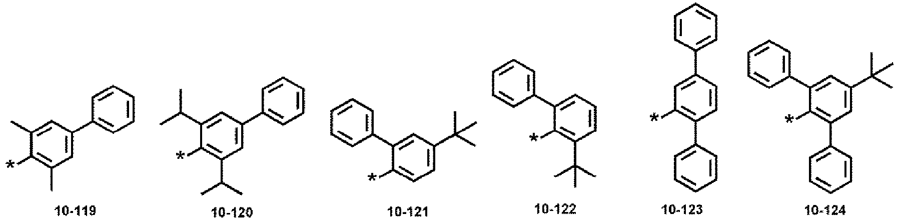

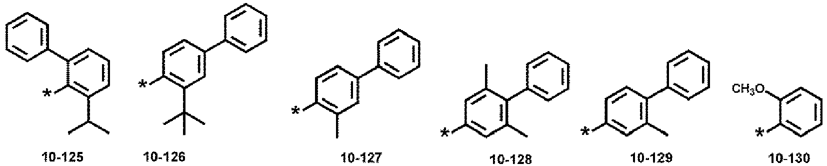

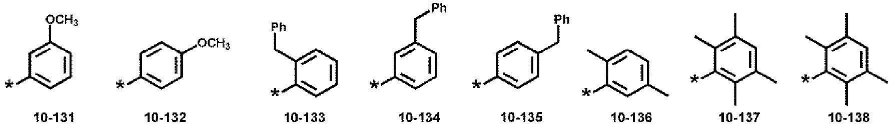

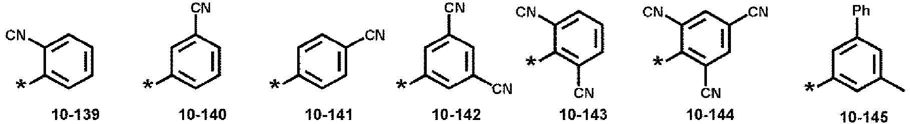

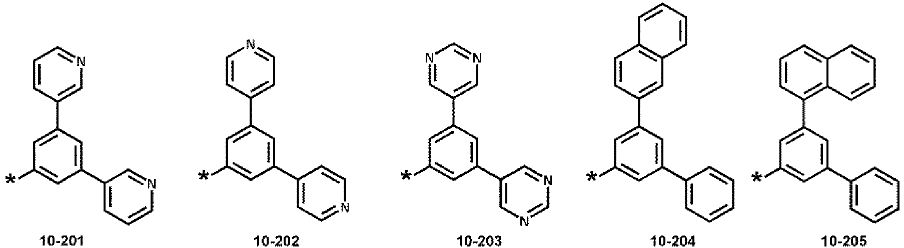

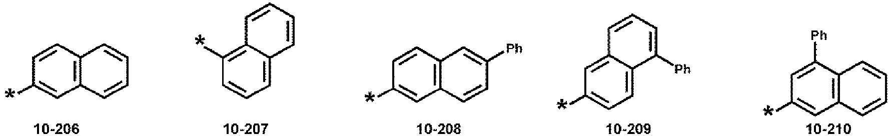

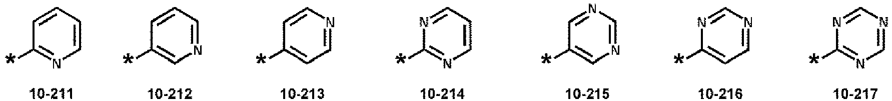

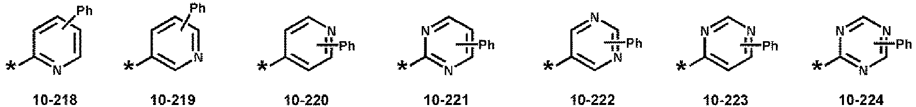

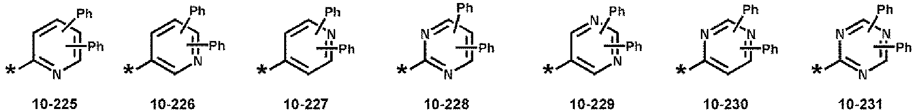

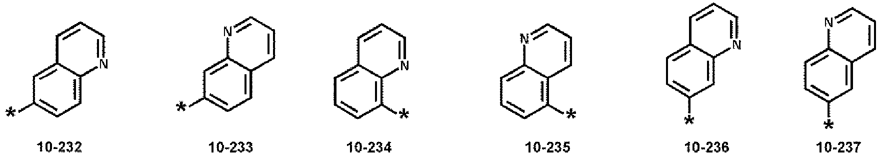

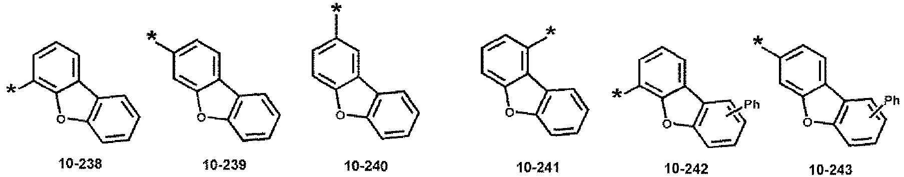

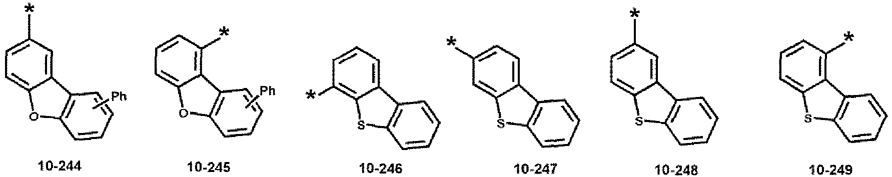

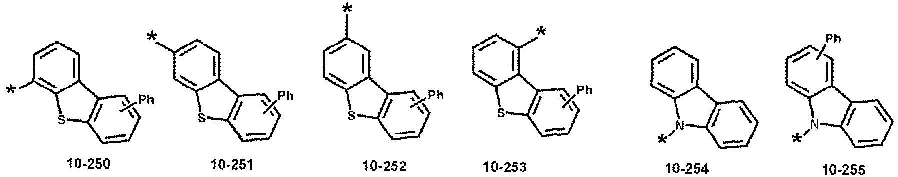

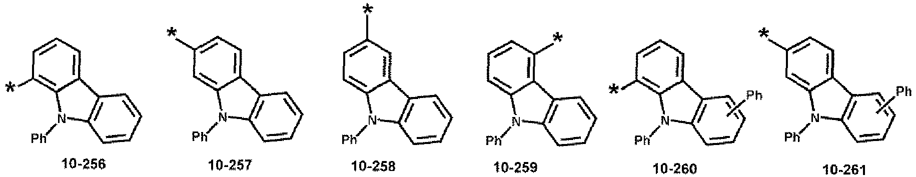

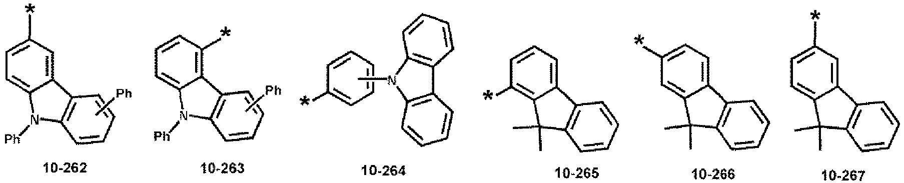

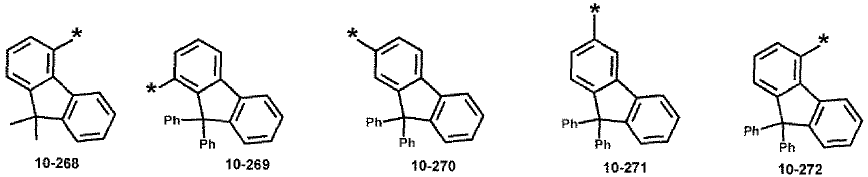

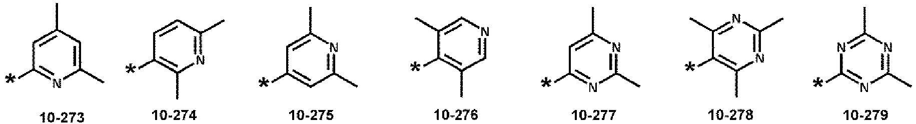

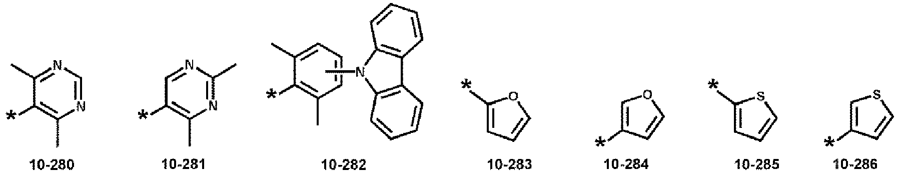

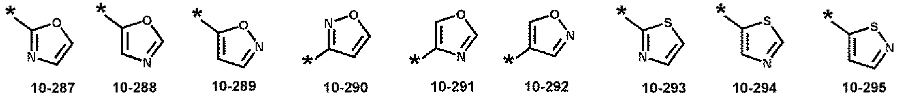

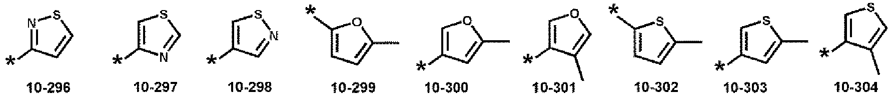

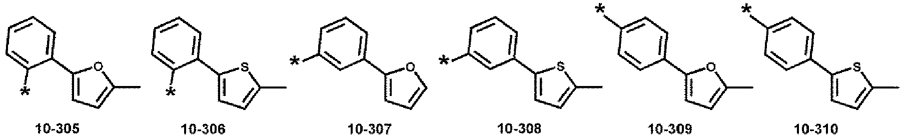

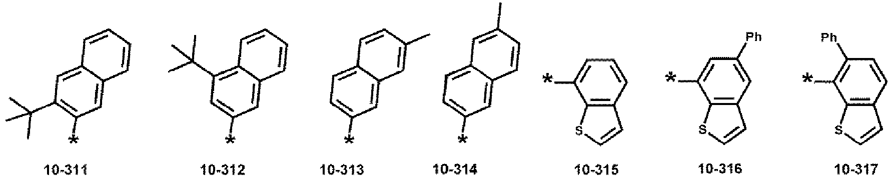

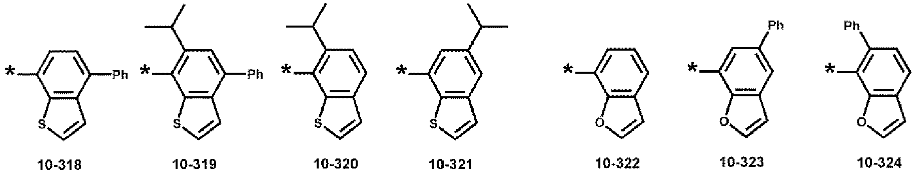

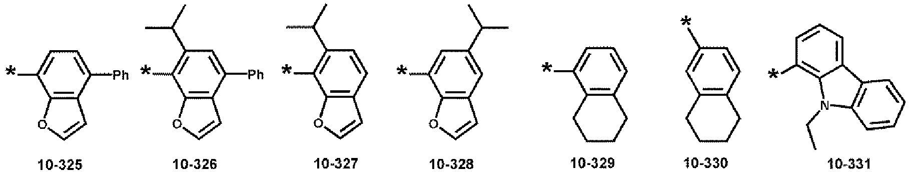

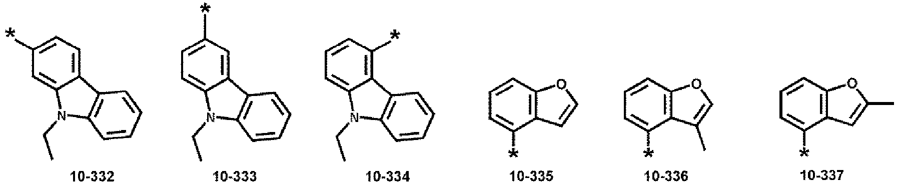

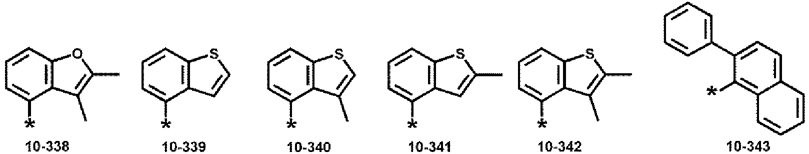

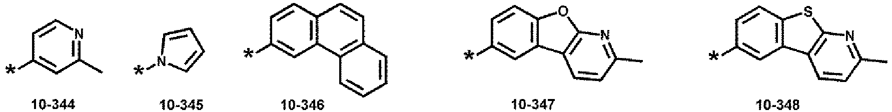

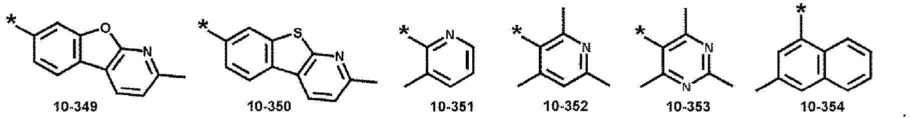

In Formulae 9-1 to 9-39, 9-201 to 9-230, 10-1 to 10-145 and 10-201 to 10-354, * indicates a binding site to a neighboring atom, "Ph" is a phenyl group, "TMS" is a trimethylsilyl group, and "TMG" is a trimethylgermyl group.

The "group in which at least one hydrogen of one of Formulae 9-1 to 9-39 is substituted with deuterium" and the "group in which at least one hydrogen of one of Formulae 9-201 to 9-230 is substituted with deuterium" may be, for example, a group represented by one of Formulae 9-501 to 9-514 or 9-601 to 9-637:

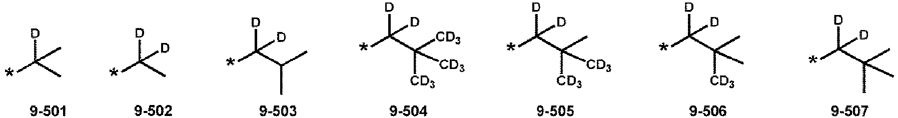

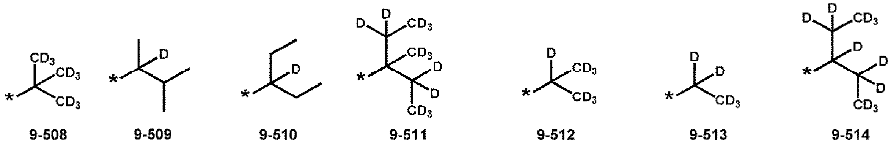

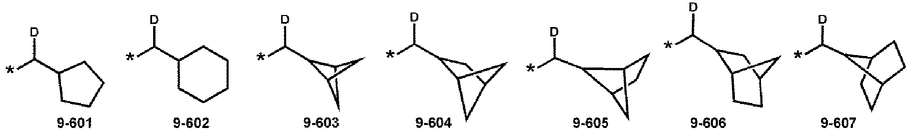

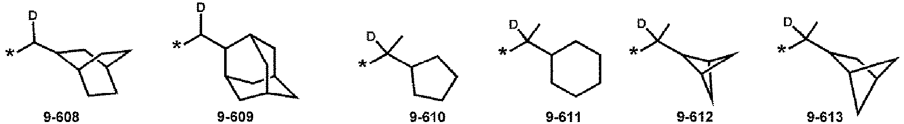

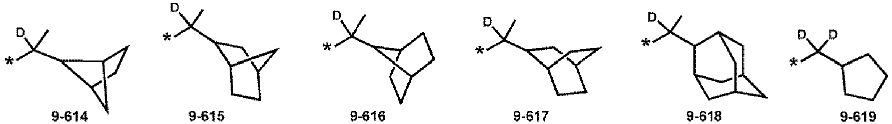

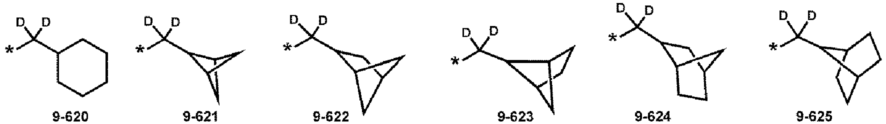

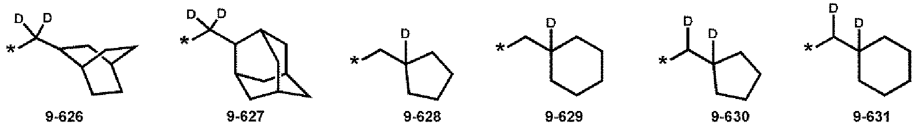

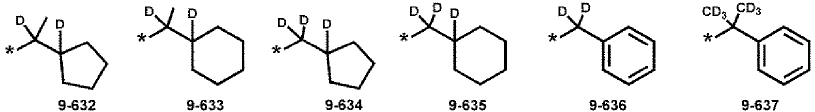

The "group in which at least one hydrogen of one of Formulae 9-1 to 9-39 is substituted with -F" and the "group in which at least one hydrogen of one of Formulae 9-201 to 9-230 is substituted with -F" may be, for example, a group represented by one of Formulae 9-701 to 9-710:

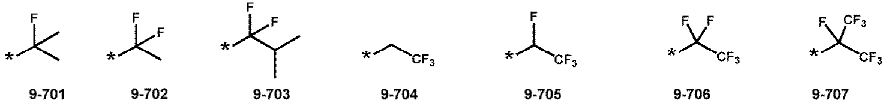

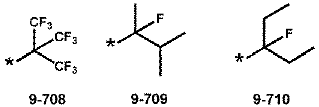

The "group in which at least one hydrogen of one of Formulae 10-1 to 10-145 is substituted with deuterium" and the "group in which at least one hydrogen of one of Formulae 10-201 to 10-354 is substituted with deuterium" may be, for example, a group represented by one of Formulae 10-501 to 10-553:

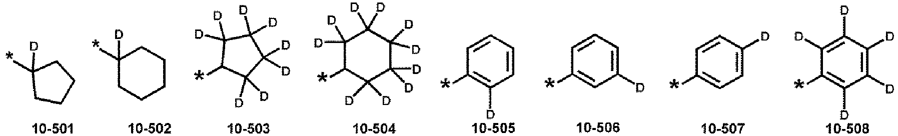

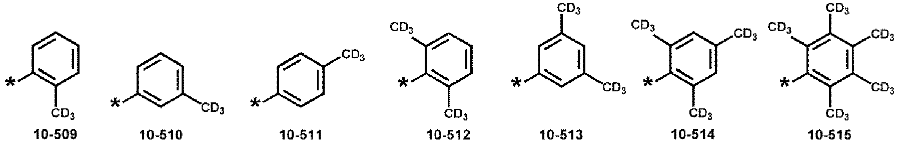

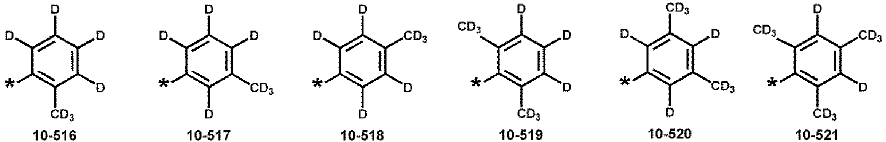

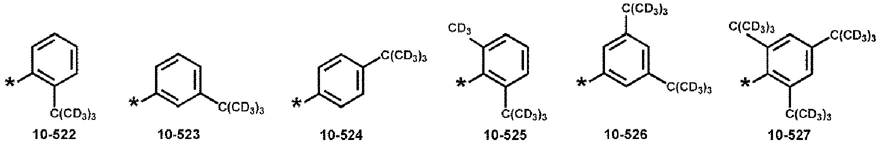

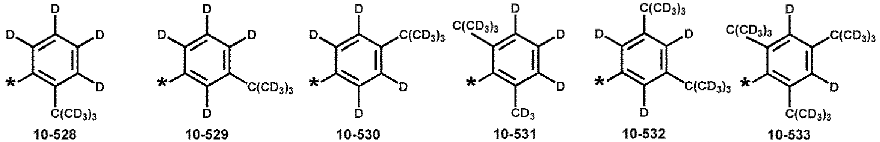

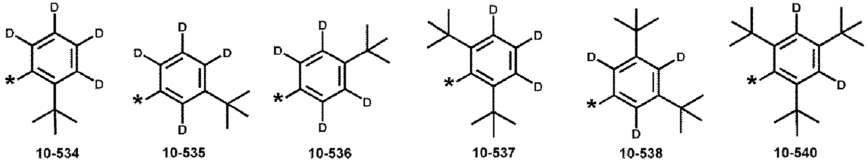

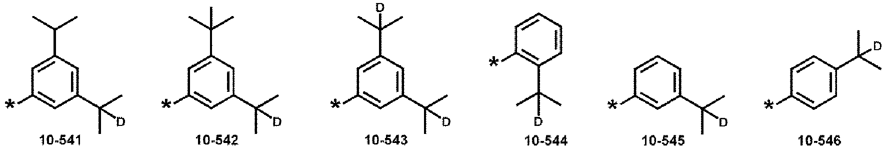

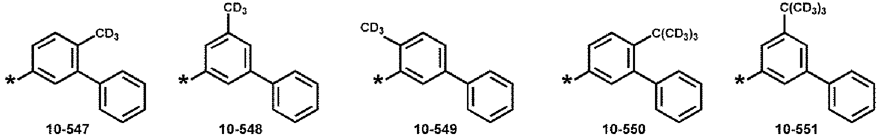

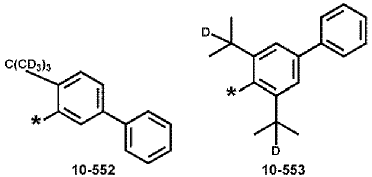

The "group in which at least one hydrogen of one of Formulae 10-1 to 10-145 is substituted with -F" and the "group in which at least one hydrogen of one of Formulae 10-201 to 10-354 is substituted with -F" may be, for example, a group represented by one of Formulae 10-601 to 10-636:

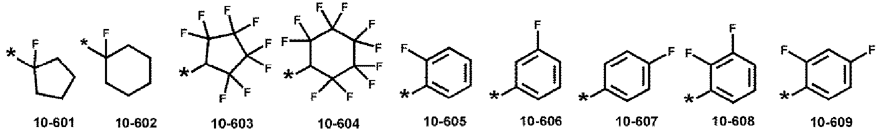

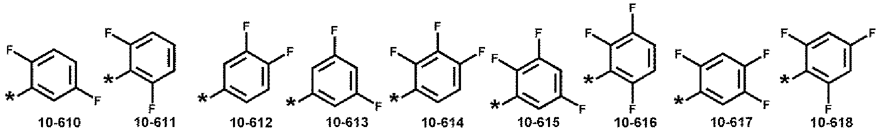

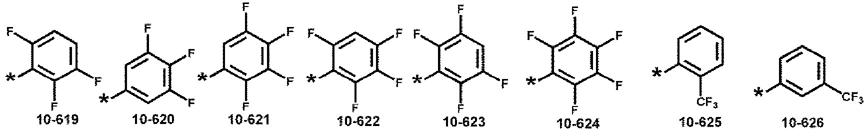

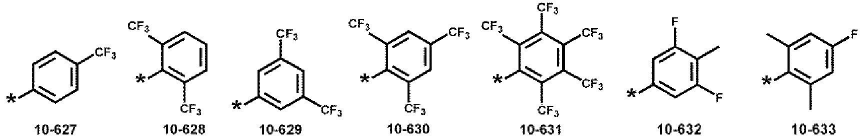

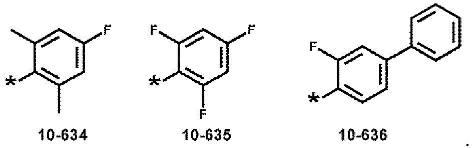

According to one or more embodiments, the organometallic compound represented by Formula 1 may include deuterium, a fluoro group (-F), or a combination thereof.

In one or more embodiments, the organometallic compound represented by Formula 1 may satisfy at least one of Condition 1 to Condition 12:
Condition 1
   at least one R₁ is not hydrogen, and
   R₁ includes at least one deuterium;
Condition 2
   at least one R₂ is not hydrogen, and
   R₂ includes at least one deuterium;
Condition 3
   at least one R₃ is not hydrogen, and
   R₃ includes at least one deuterium;
Condition 4
   a group represented by *-T₃₀-R₃₀ includes at least one deuterium;
Condition 5
   at least one R₄ is not hydrogen, and
   R₄ includes at least one deuterium;
Condition 6
   at least one W₄ includes deuterium;
Condition 7
   at least one R₁ is not hydrogen, and
   R₁ includes at least one fluoro group;
Condition 8
   at least one R₂ is not hydrogen, and
   R₂ includes at least one fluoro group;
Condition 9
   at least one R₃ is not hydrogen, and
   R₃ includes at least one fluoro group;
Condition 10
   a group represented by *-T₃₀-R₃₀ includes at least one fluoro group;
Condition 11
   at least one R₄ is not hydrogen, and
   R₄ includes at least one fluoro group;
Condition 12
   at least one W₄ includes a fluoro group.

In Formula 2-1 and Formula 2-2, i) two or more of a plurality of R₁ are optionally linked to each other to form a C₅-C₃₀ carbocyclic group unsubstituted or substituted with at least one R₁₀ₐ, or a C₁ -C₃₀ heterocyclic group unsubstituted or substituted with at least one R₁₀ₐ, ii) two or more of a plurality of R₂ are optionally linked to each other to form a C₅-C₃₀ carbocyclic group unsubstituted or substituted with at least one R₁₀ₐ, or a C₁ -C₃₀ heterocyclic group unsubstituted or substituted with at least one R₁₀ₐ, iii) two or more of a plurality of R₃ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ, iv) two or more of a plurality of R₄ are optionally linked to each other to form a C₅-C₃₀ carbocyclic group unsubstituted or substituted with at least one R₁₀ₐ, or a C₁ -C₃₀ heterocyclic group unsubstituted or substituted with at least one R₁₀ₐ, and v) two or more of R₁ to R₄ or R₃₀ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ.

R₁₀ₐ is as described in connection with R₂ herein. For example, R₁₀ₐ may be as described in connection with R₂ herein, and may not be hydrogen.

* and *' in Formula 2-1 and Formula 2-2 each indicates a binding site to M in Formula 1.

According to one or more embodiments, a group represented by: 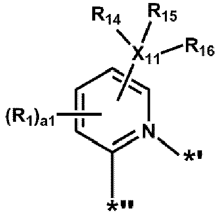 in Formula 2-1 may be a group represented by one of Formulae CY1-1 to CY1-3: 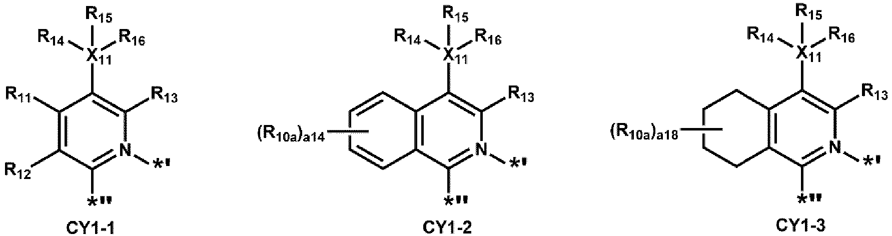 wherein, in Formulae CY1-1 to CY1-3,
each of X₁₁, R₁₄ to R₁₆ and R₁₀ₐ is as described herein,
R₁₁ to R₁₃ may each be the same as described in connection with R₁,
a14 may be an integer from 0 to 4,
a18 may be an integer from 0 to 8,
*' indicates a binding site to M in Formula 1, and
*" indicates a binding site to a neighboring atom in Formula 2-1.

For example, R₁₁ in in Formula CY1-1 may not be hydrogen.

According to one or more embodiments, R₁₁ in Formula CY1-1 may not be hydrogen or a methyl group.

According to one or more embodiments, R₁₁ in Formula CY1-1 may be hydrogen or a methyl group.

According to one or more embodiments, R₁₁ in Formula CY1-1 may not be hydrogen, a methyl group, or a cyano group.

According to one or more embodiments, R₁₁ in Formula CY1-1 may not be hydrogen, and R₁₂ and R₁₃ may each be hydrogen.

According to one or more embodiments, R₁₁ in Formula CY1-1 may have 2 or more carbon atoms, 3 or more carbon atoms, or 4 or more carbon atoms.

According to one or more embodiments, R₁₁ in Formula CY1-1 may be:
a methyl group, substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof; or
a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

According to one or more embodiments, a group represented by: 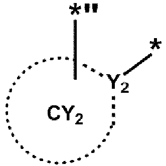 in Formula 2-1 may be a group represented by one of Formulae CY2-1 to CY2-33: 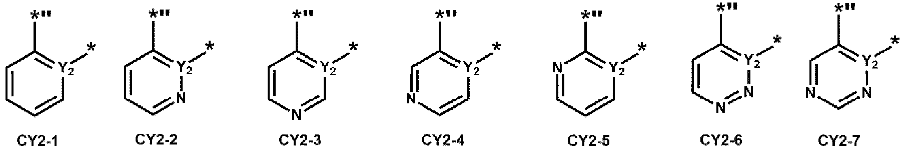 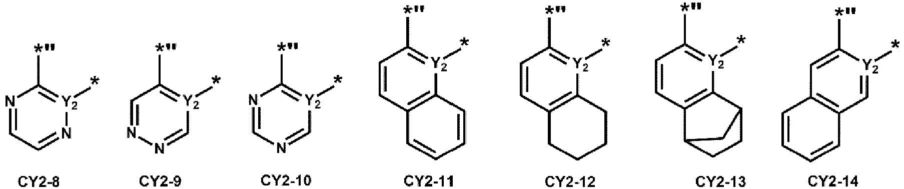 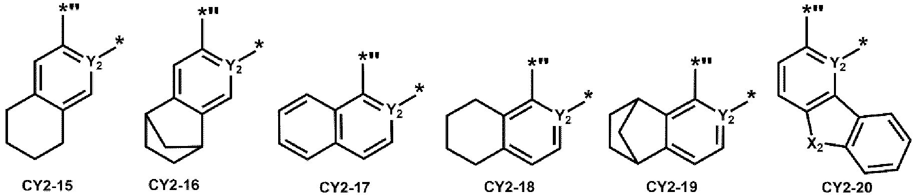 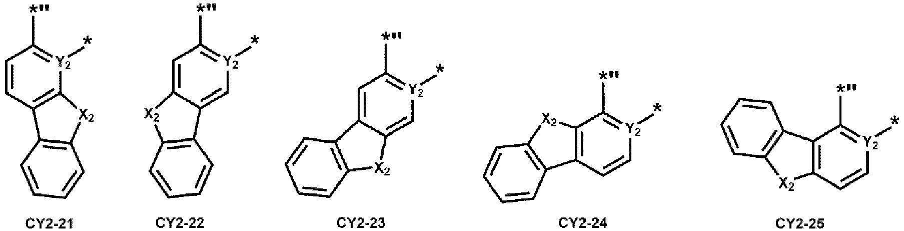 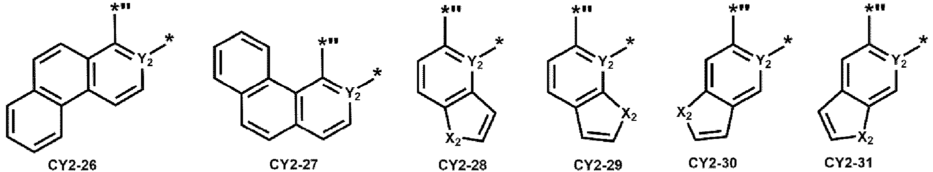 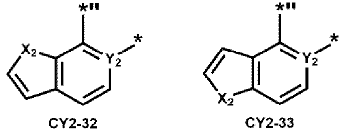 wherein, in Formulae CY2-1 to CY2-33,
Y₂ may be as described herein,
X₂ may be O, S, Se, N(R₂₈), C(R₂₈)(R₂₉), or Si(R₂₈)(R₂₉),
each of R₂₈ and R₂₉ is as described for R₂ herein,
*" indicates a binding site to a neighboring atom in Formula 2-1, and
* indicates a binding site to M in Formula 1.

In one or more embodiments, a group represented by: 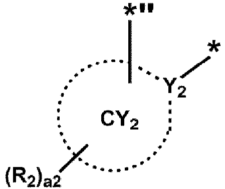 in Formula 2-1 may be a group represented by one of Formulae CY2(1) to CY2(56):

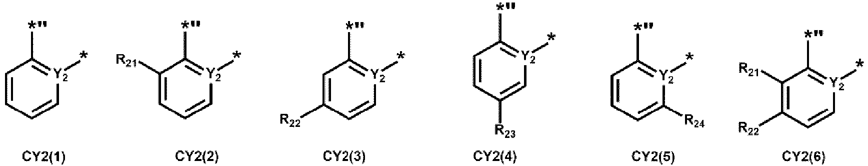

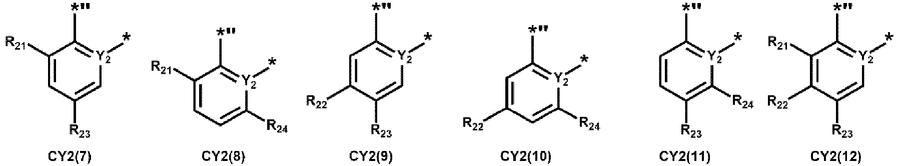

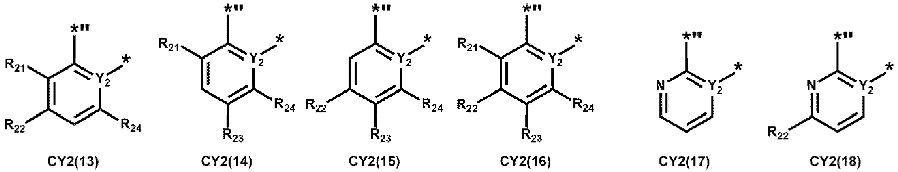

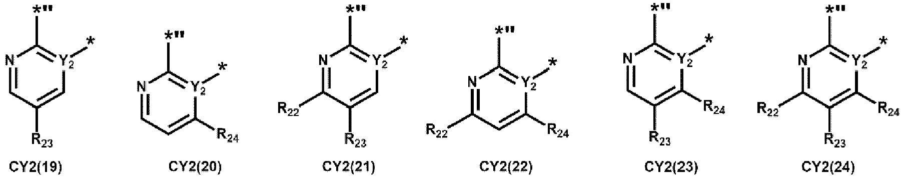

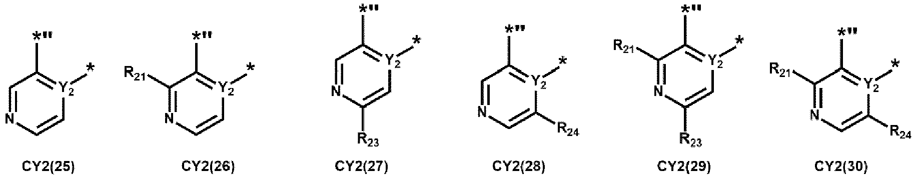

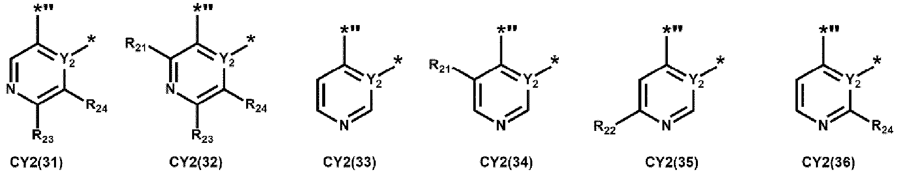

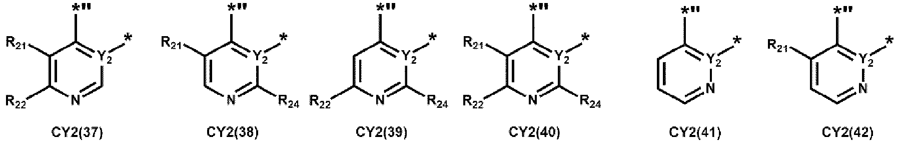

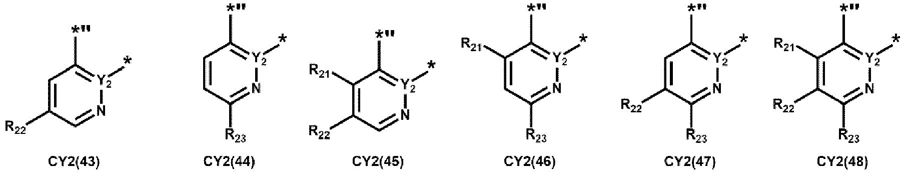

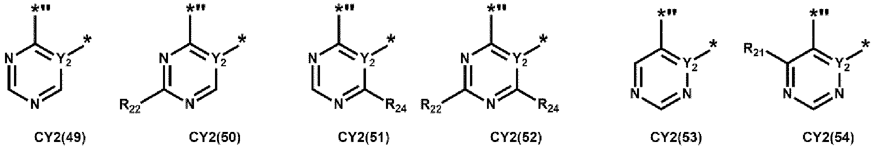

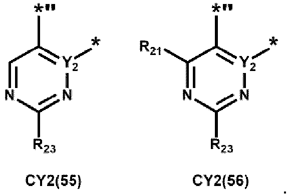

In Formulae CY2(1) to CY2(56),
Y₂ may be as described herein,
R₂₁ to R₂₄ may each be as described in connection with R₂, wherein each of R₂₁ to R₂₄ may not be hydrogen,
*" indicates a binding site to a neighboring atom in Formula 2-1, and
* indicates a binding site to M in Formula 1.

According to one or more embodiments, Formula 2-2 may satisfy at least one of Condition A and Condition B:
Condition A
   T₃₀ is a C₅-C₃₀ carbocyclic group unsubstituted or substituted with at least one R₁₀ₐ, or a C₁-C₃₀ heterocyclic group unsubstituted or substituted with at least one R₁₀ₐ, and
Condition B
   R₃₀ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, a group represented by: 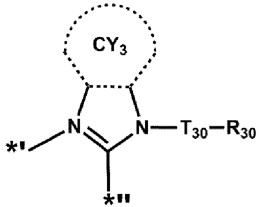 in Formula 2-2 may be a group represented by one of Formulae CY3-1 to CY3-21: 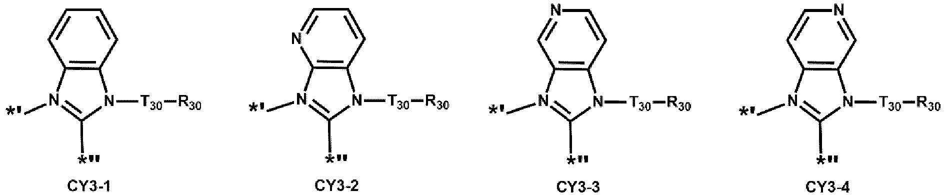 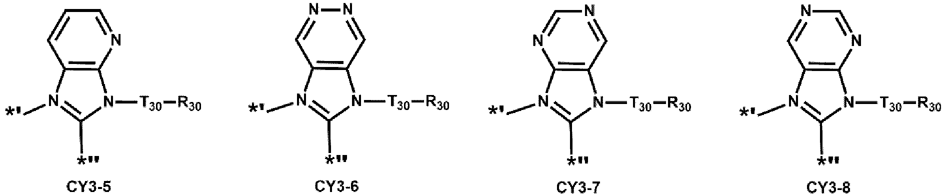 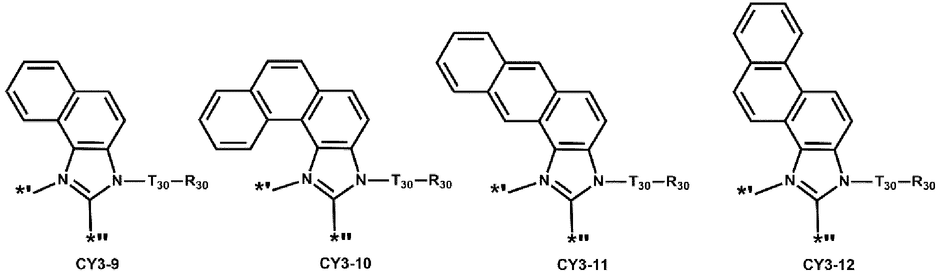 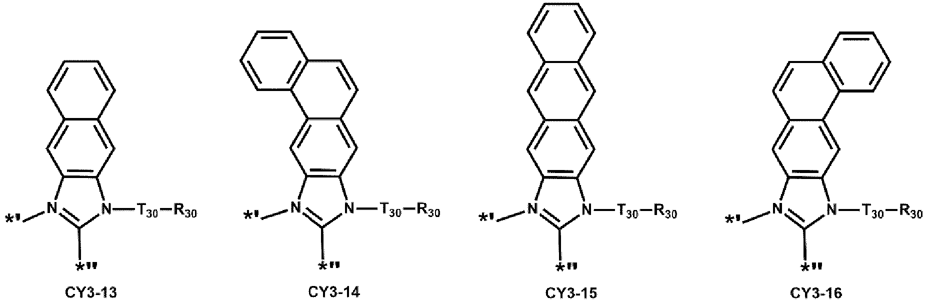 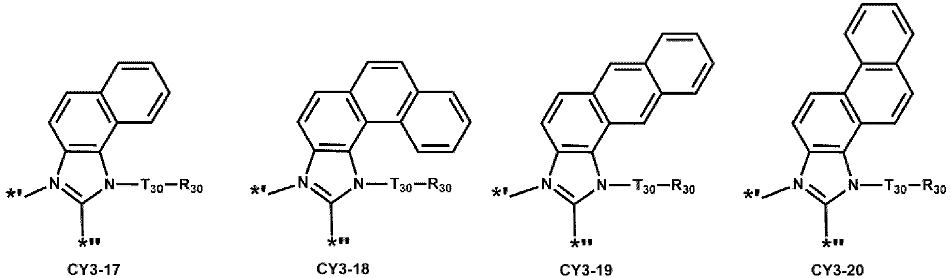 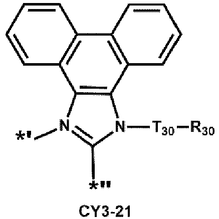 wherein, in Formulae CY3-1 to CY3-21,
each of T₃₀ and R₃₀ is as described herein,
*' indicates a binding site to M in Formula 1, and
*" indicates a binding site to a neighboring atom in Formula 2-2.

According to one or more embodiments, a group represented by: 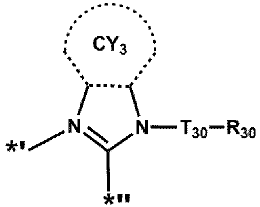 in Formula 2-2 may be a group represented by Formulae CY3-1 or CY3-17. According to one or more embodiments, a group represented by: 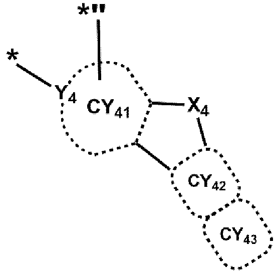 in Formula 2-2 may be a group represented by one of Formulae CY4-1 to CY4-6: 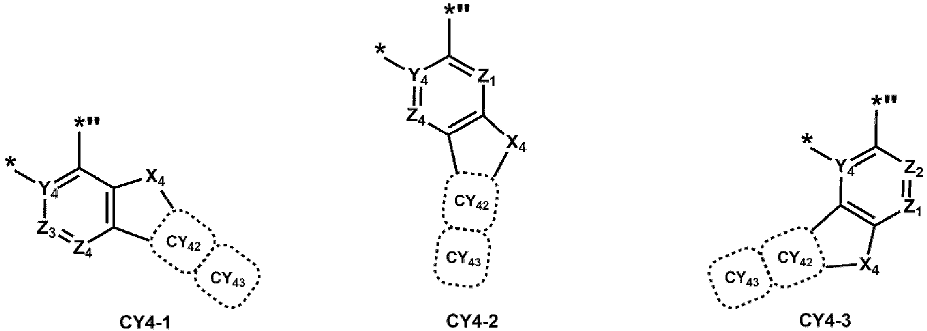 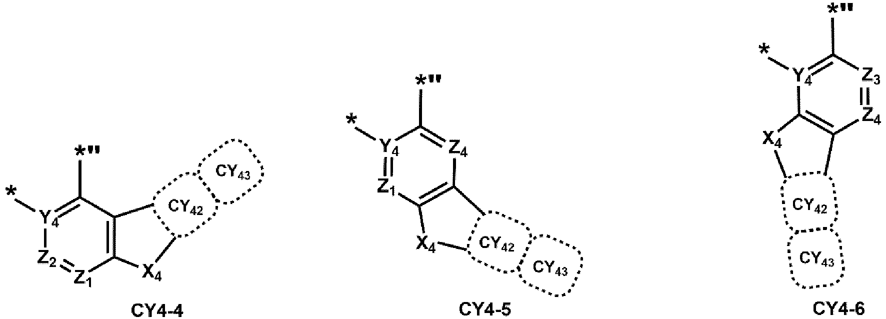 wherein, in Formulae C4-1 to C4-6,
each of Y₄, X₄, ring CY₄₂ and ring CY₄₃ is as described herein,
Z₁ to Z₄ may each independently be N or C,
* indicates a binding site to M in Formula 1, and
*" indicates a binding site to a neighboring atom in Formula 2-2.

According to one or more embodiments, a group represented by: 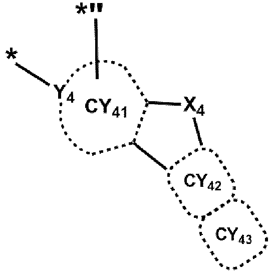 in Formula 2-2 may be a group represented by Formula CY4-1.

In one or more embodiments, a group represented by: 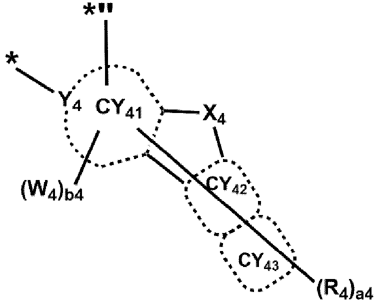 in Formula 2-2 may be a group represented by one of Formulae CY4(1) to CY4(18): 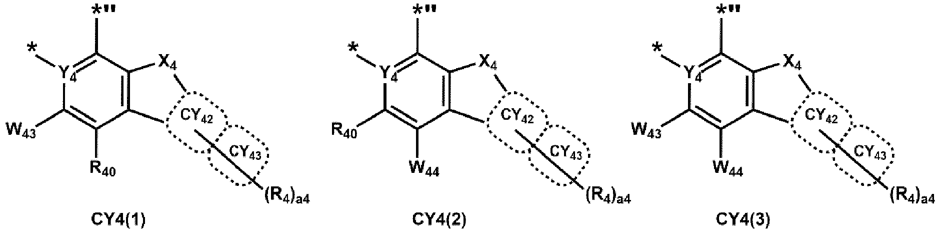 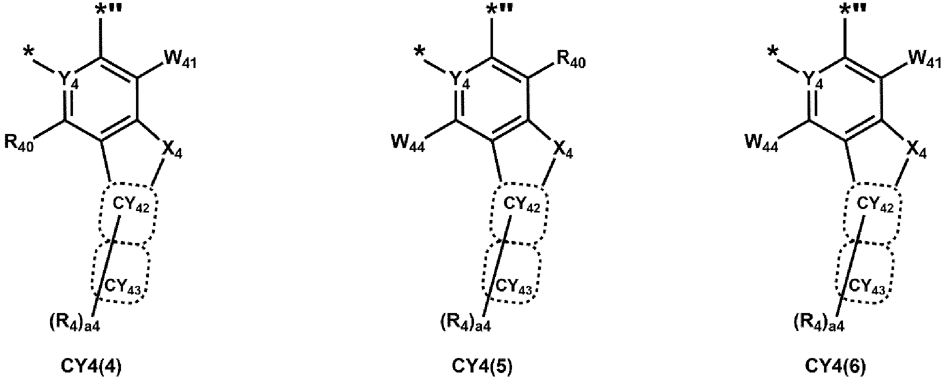 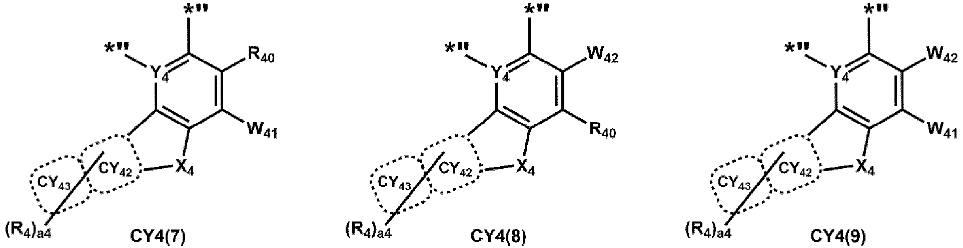 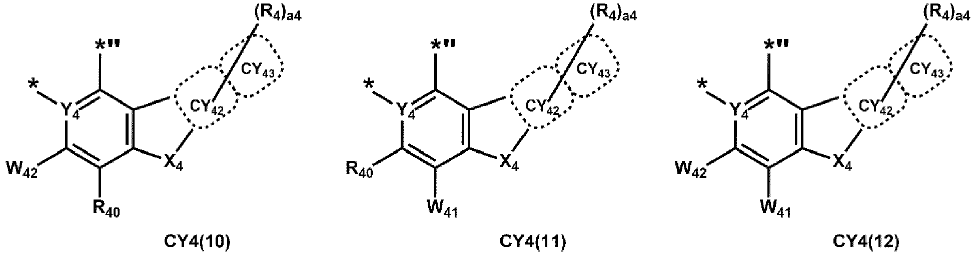 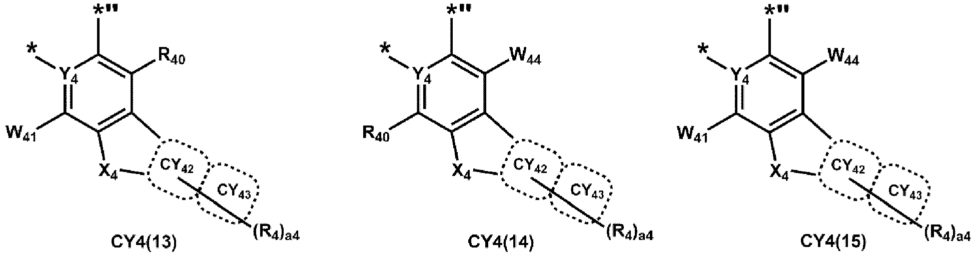 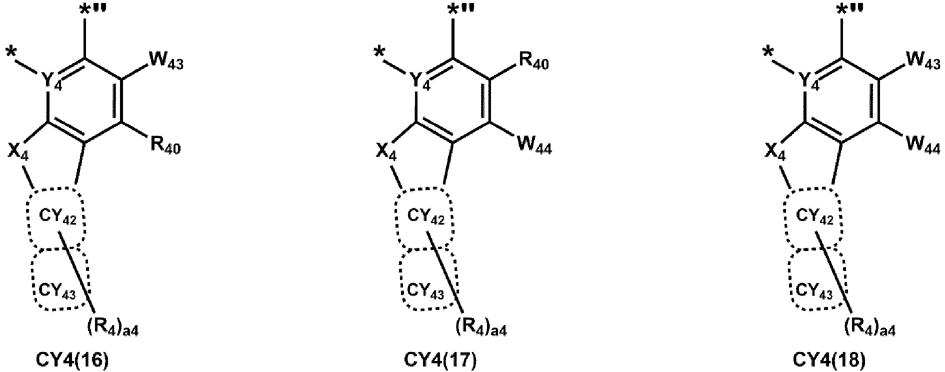 wherein, in Formulae CY4(1) to CY4(18),
each of Y₄, ring CY₄₂, ring CY₄₃ and R₄ is as described herein,
each W₄₁ to W₄₄ is as described in connection with W₄ herein,
R₄₀ is as described in connection with R₄,
a4 may be an integer from 0 to 10,
* indicates a binding site to M in Formula 1, and
*" indicates a binding site to a neighboring atom in Formula 2-2.

For example, a4 in Formulae CY4(1) to CY4(18) may be 0, 1, 2, or 3. According to one or more embodiments, a group represented by: 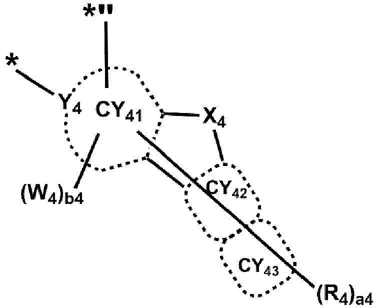 in Formula 2-2 may be a group represented by one of Formulae CY4(1) to CY4(3).

According to one or more embodiments, a group represented by 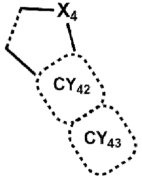 in a group represented by 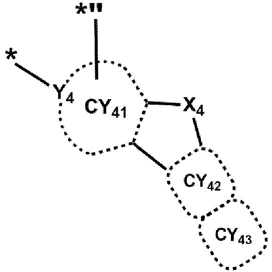 of Formula 2-2 and in Formulae CY4(1) to CY4(18) may be a group represented by one of Formulae CY401 to CY451 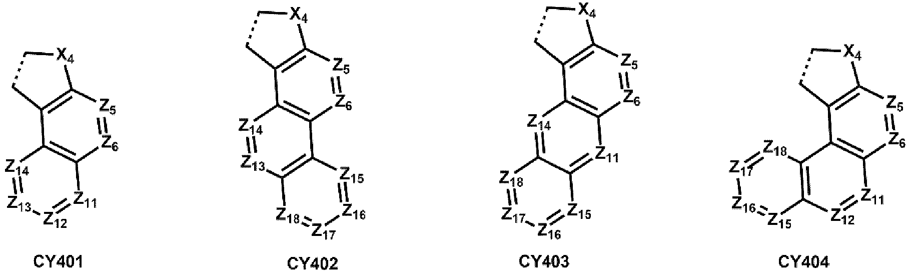 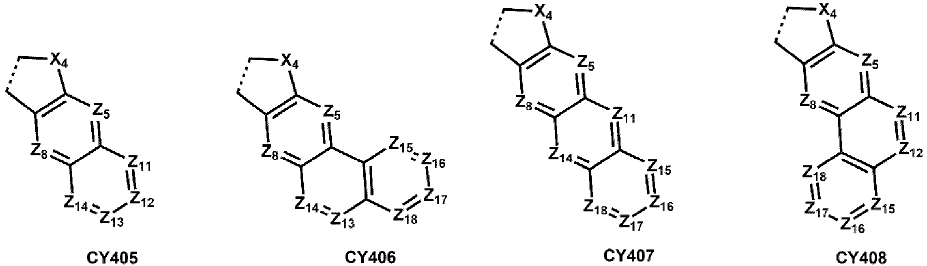 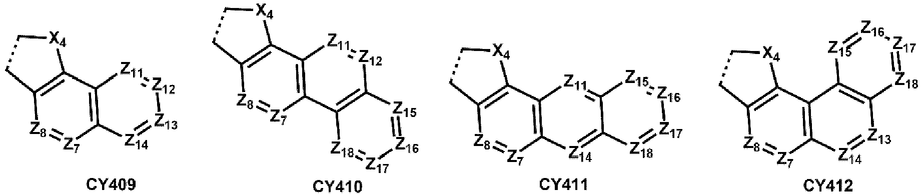 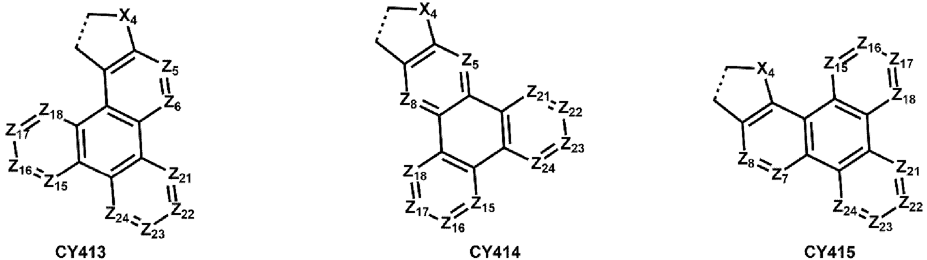 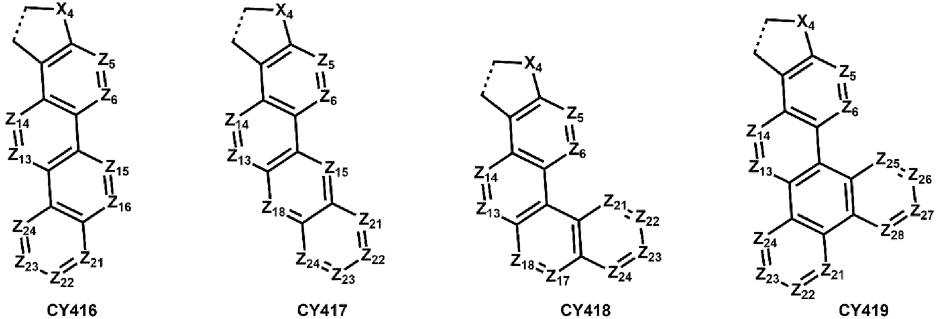 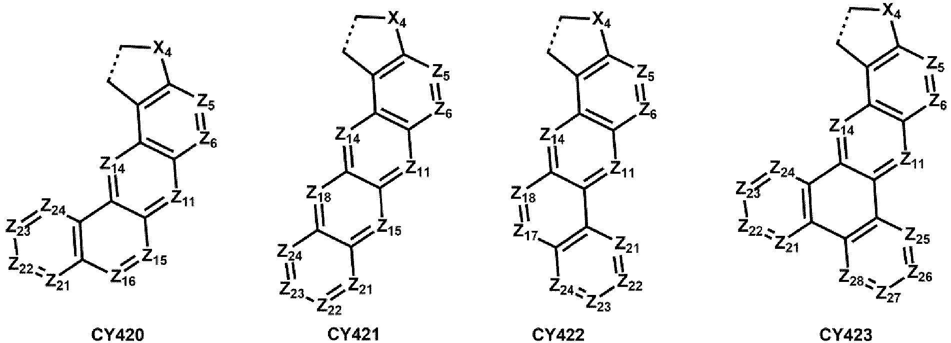 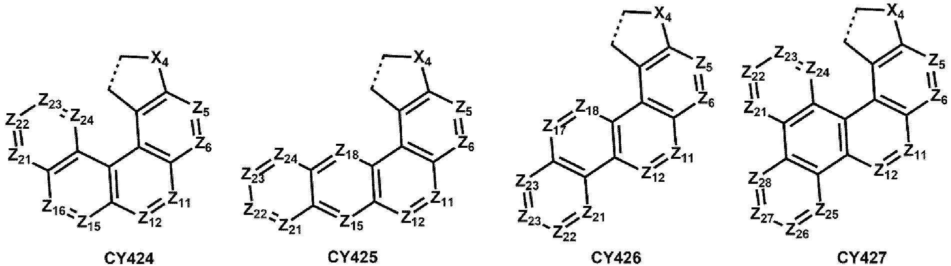 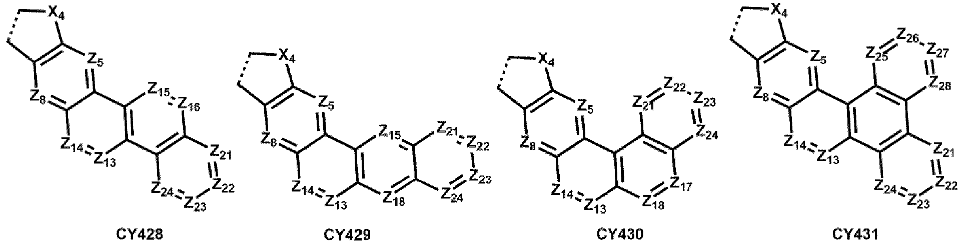 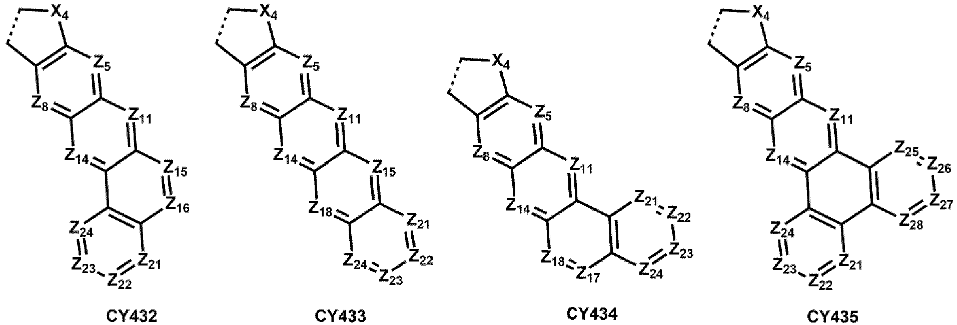 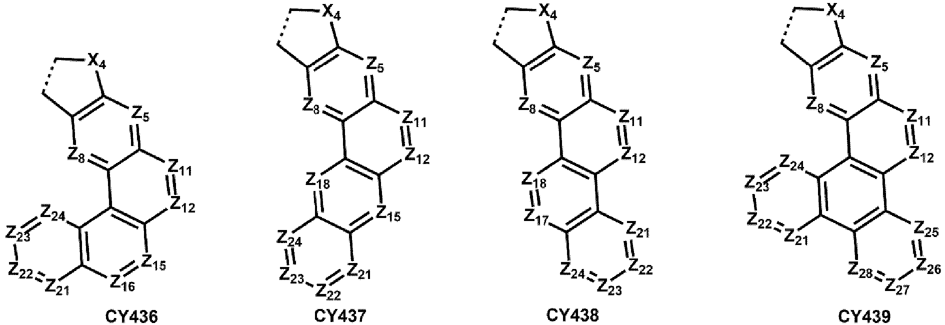 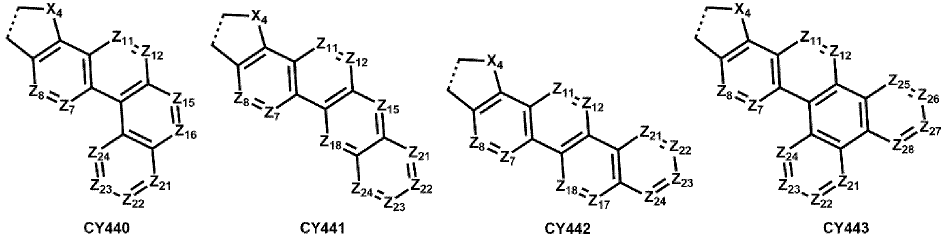 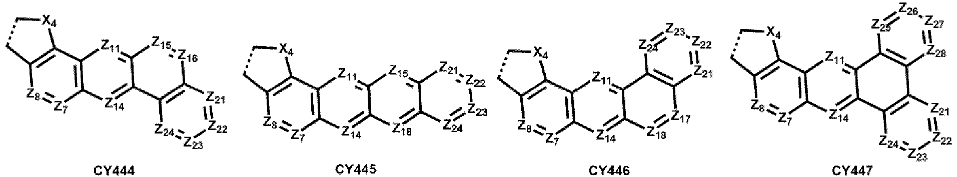 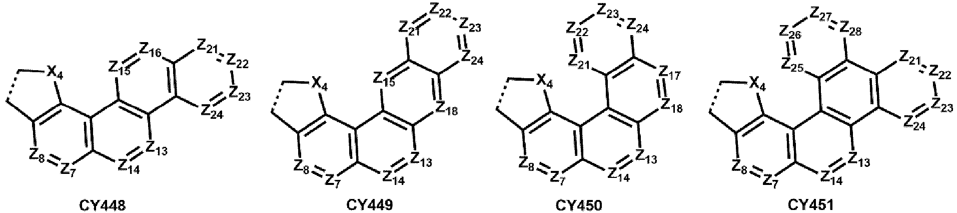 wherein, in Formulae CY401 to CY451,
X₄ is the same as described herein,
Z₅ to Z₈, Z₁₁ to Z₁₈, and Z₂₁ to Z₂₈ may each independently be N or C, and
an X₄-containing five-membered ring may be condensed with ring CY₄₁ which is adjacent thereto.

According to one or more embodiments, a group represented by: 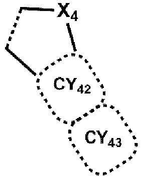 in a group represented by 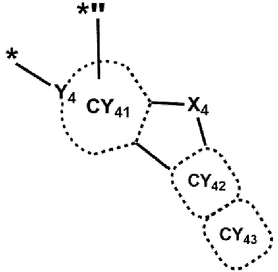 of Formula 2-2 and Formulae CY4(1) to CY4(18) may be a group represented by one of Formulae CY406, CY408, and CY410.

According to one or more embodiments, a group represented by: 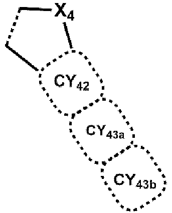 in 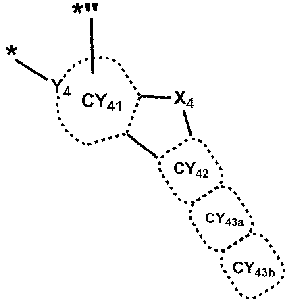 of Formula 2-2A may be a group represented by one of Formulae CY402 to CY404, CY406 to CY408, and CY410 to CY451.

According to one or more embodiments, the organometallic compound represented by Formula 1 may emit a red light or a green light, for example, a red light or a green light that has the maximum emission wavelength of about 500 nanometers (nm) or greater, or from about 500 nm to about 850 nm. For example, the organometallic compound represented by Formula 1 may emit a green light.

According to one or more embodiments, the organometallic compound represented by Formula 1 may emit light having the maximum emission wavelength of about 510 nm to about 550 nm, about 510 nm to about 540 nm, about 510 nm to about 529 nm, about 515 nm to about 550 nm, about 515 nm to about 540 nm, about 515 nm to about 529 nm, about 520 nm to about 550 nm, about 520 nm to about 540 nm, about or 520 nm to about 529 nm. For example, the organometallic compound represented by Formula 1 may emit light (for example, a green light) with a maximum emission wavelength of about 510 nm to about 529 nm, or about 520 nm to about 529 nm.

The organometallic compound represented by Formula 1 may be one of Compounds 1 to 111:

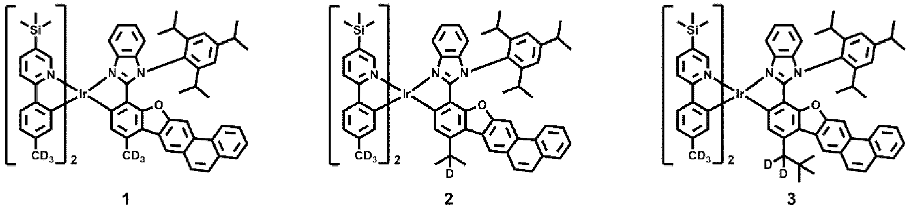

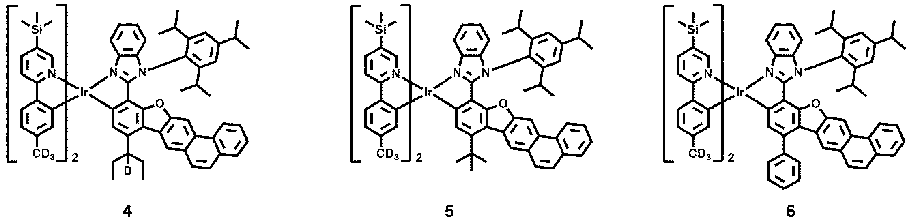

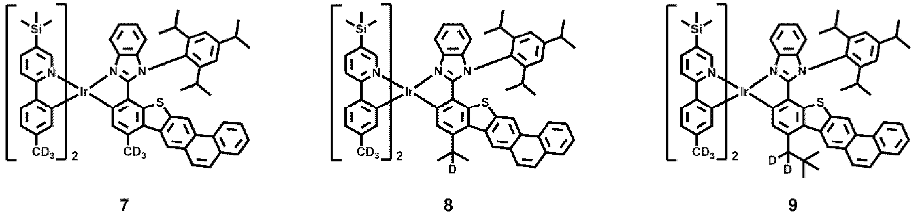

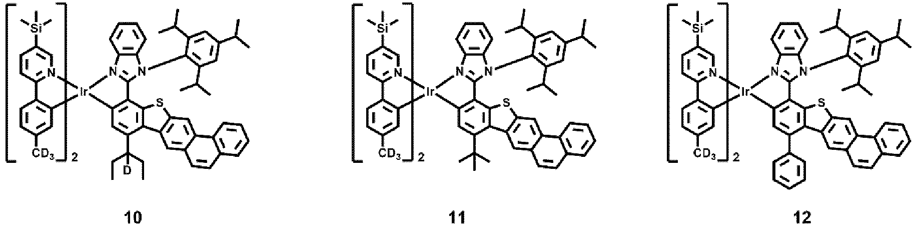

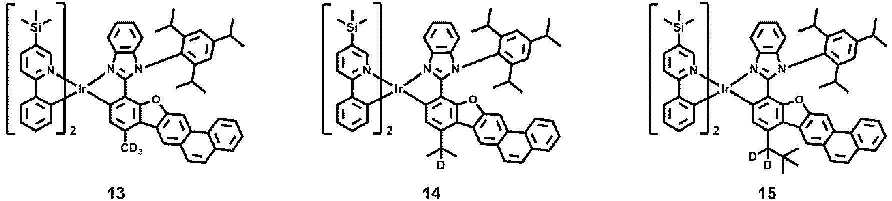

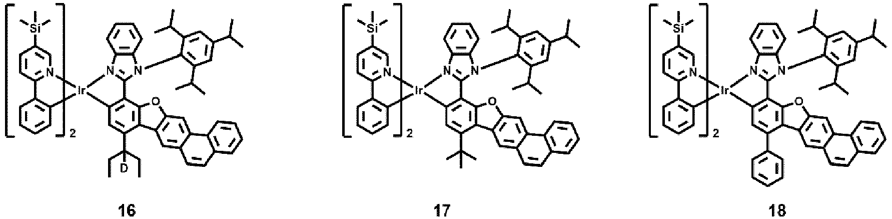

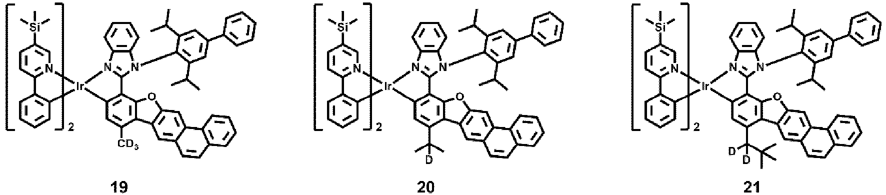

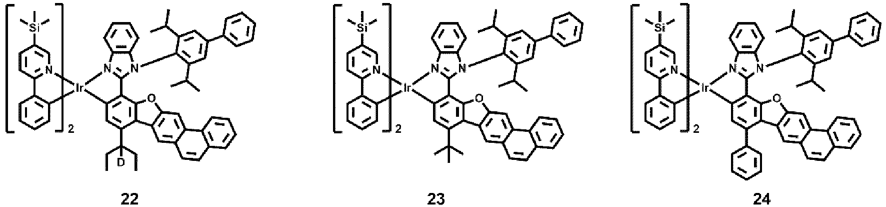

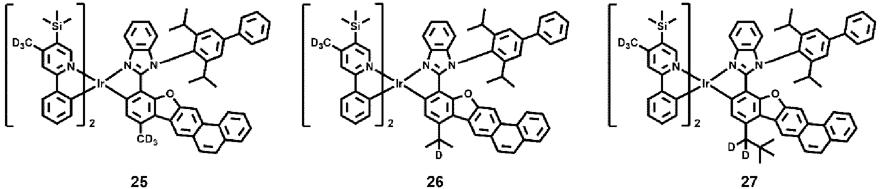

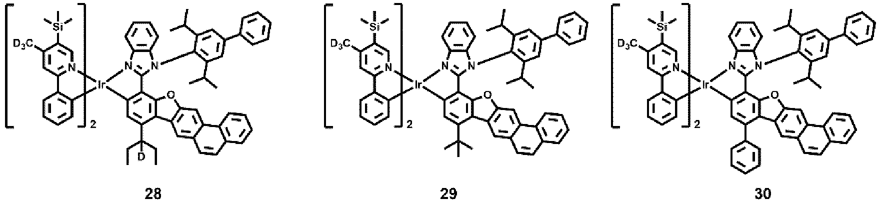

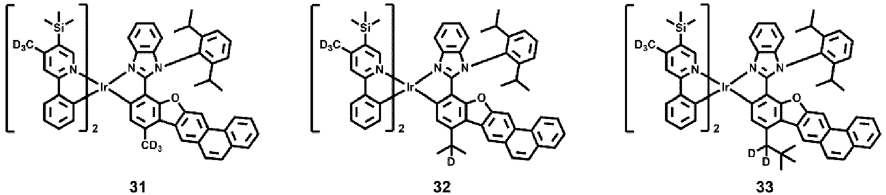

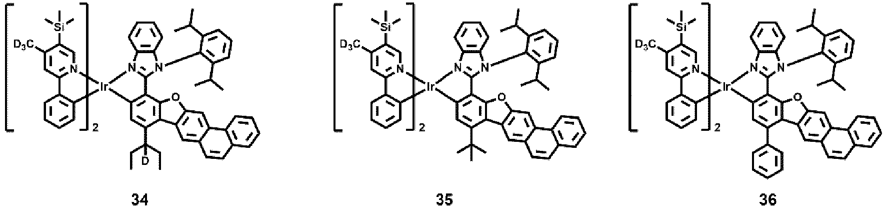

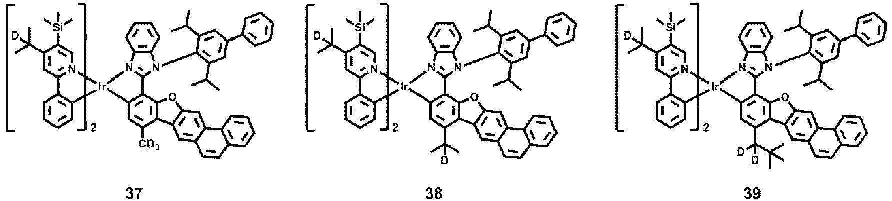

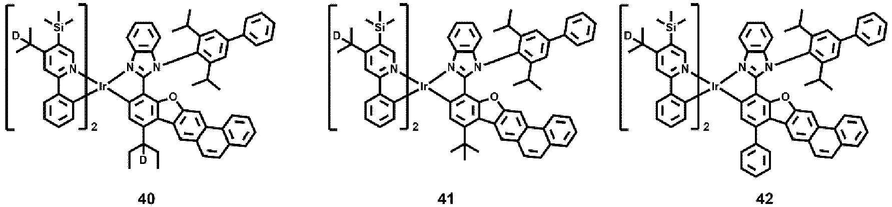

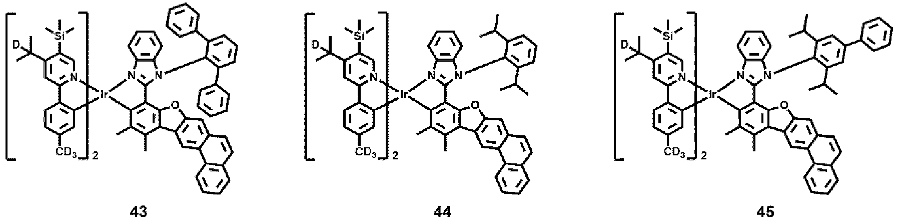

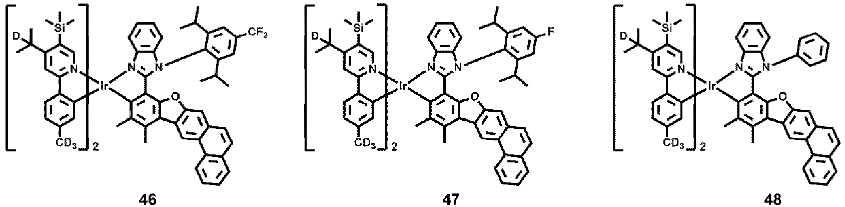

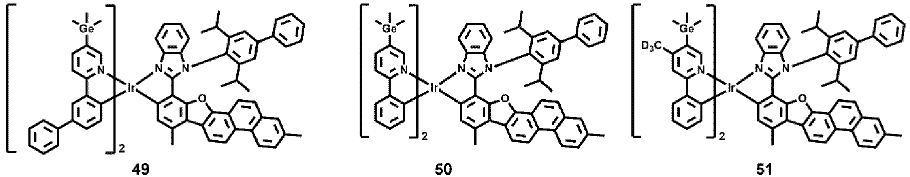

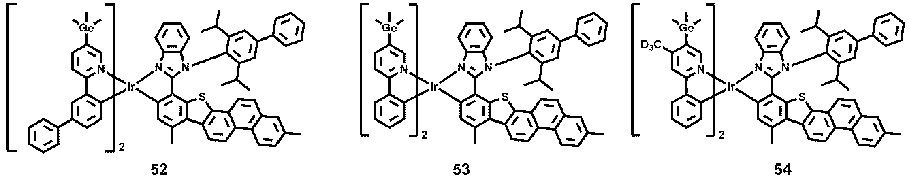

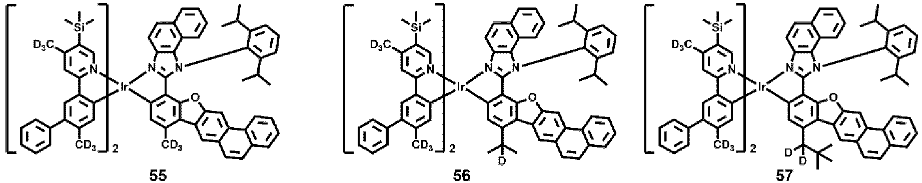

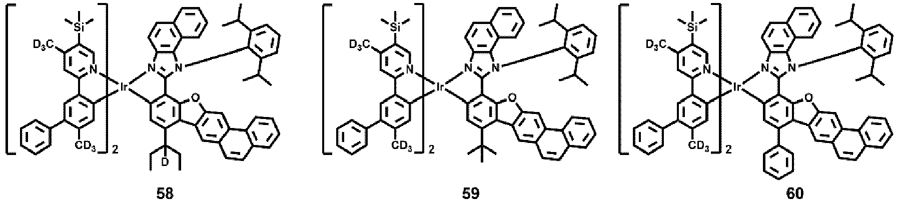

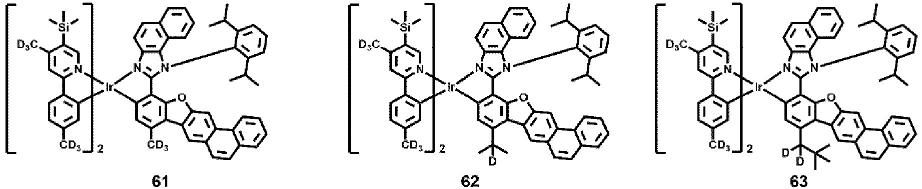

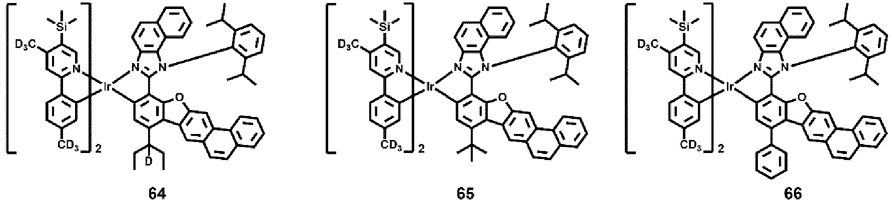

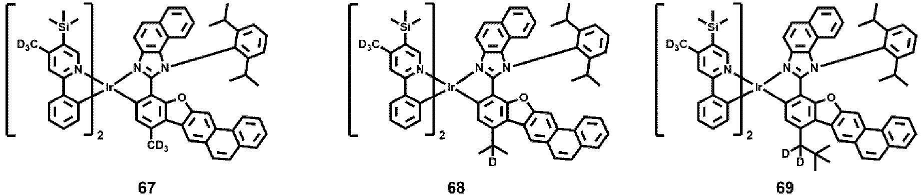

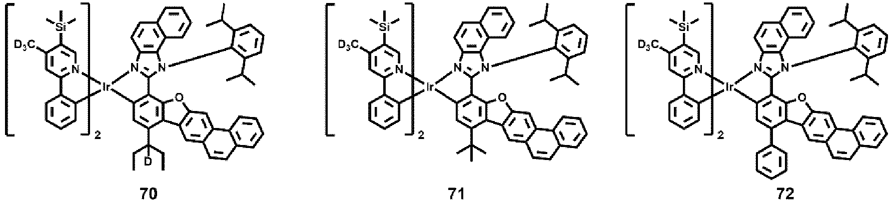

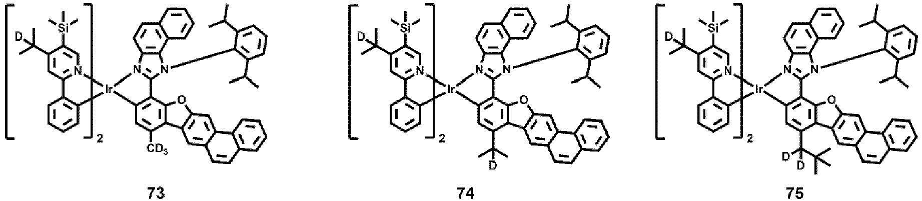

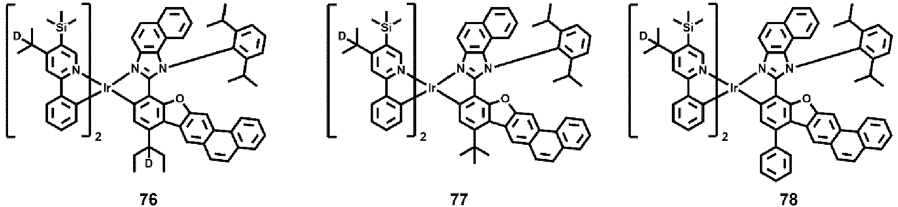

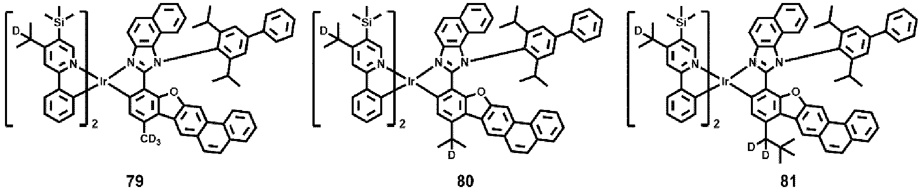

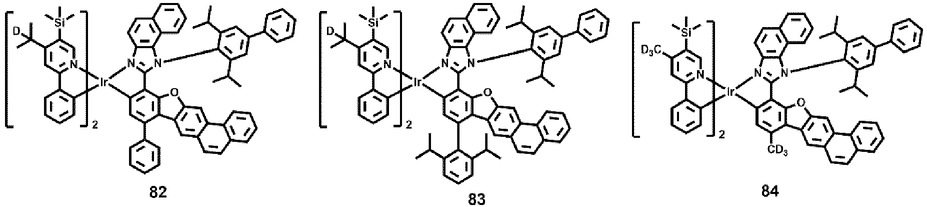

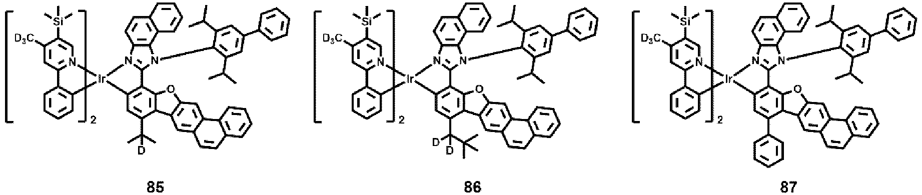

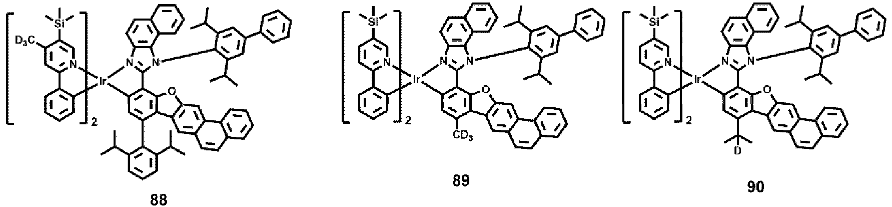

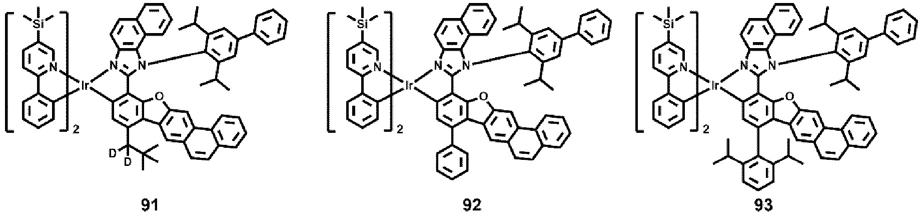

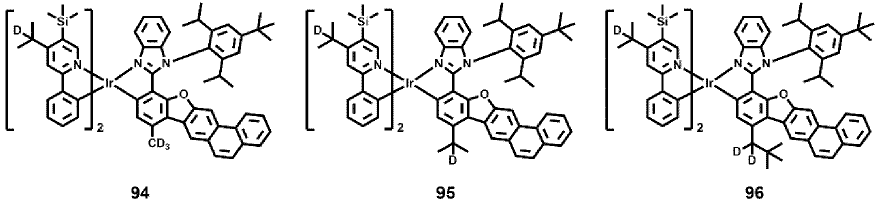

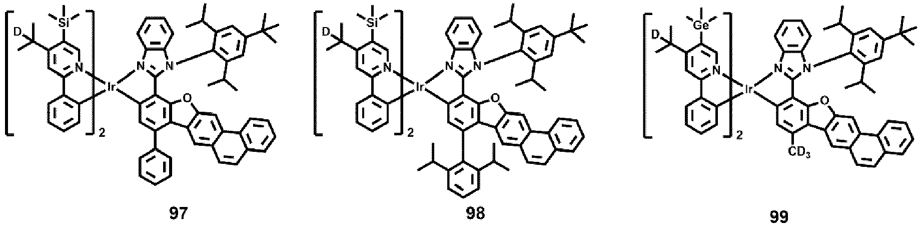

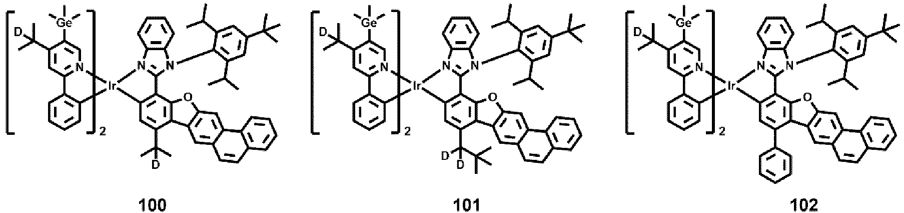

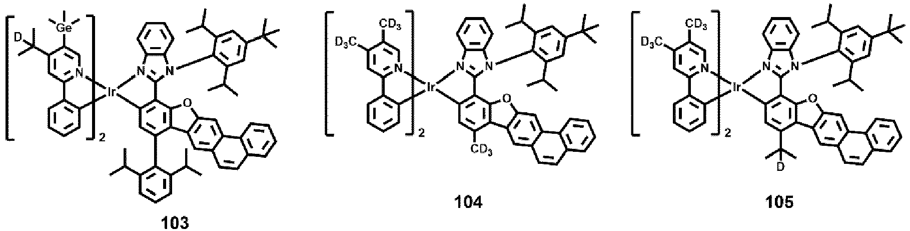

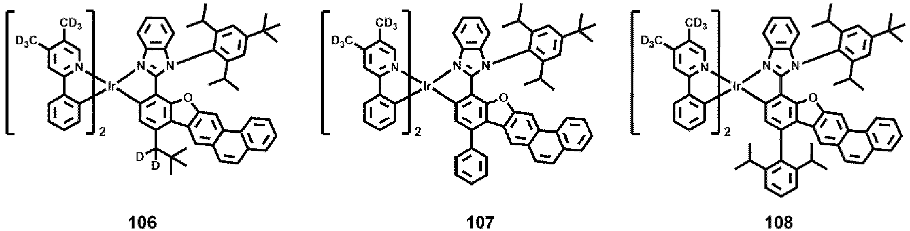

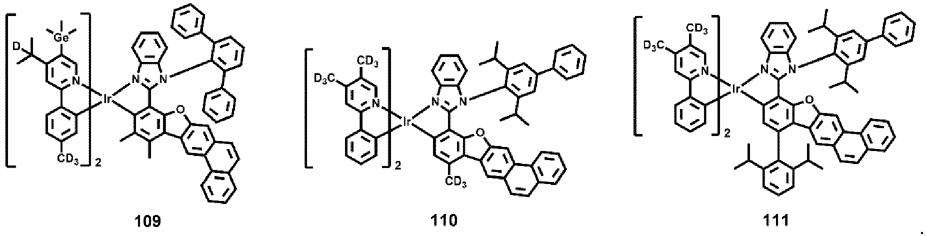

L₁ and L₂ in the organometallic compound represented by Formula 1 are a ligand represented by Formula 2-1 and a ligand represented by Formula 2-2, respectively, and n1 and n2, which are the number of L₁ and the number of L₂, respectively, may each independently be 1 or 2. In this regard, Formula 2-2 includes ring CY₄₃ condensed to ring CY₄₂ and includes at least one W₄ as defined herein. As a result, the organometallic compound represented by Formula 1 can emit light having a maximum emission wavelength shifted to a relatively shorter wavelength (for example, a green light having a maximum emission wavelength shifted to a relatively shorter wavelength), and at the same time, has excellent electrical stability and thermal stability. Accordingly, an electronic device, for example, a light-emitting device, including the same, can emit light having a maximum emission wavelength shifted to a relatively shorter wavelength (for example, a green light having a maximum emission wavelength shifted to a relatively shorter wavelength), and at the same time, external quantum efficiency and lifetime thereof can be improved.

For example, the highest occupied molecular orbital (HOMO) energy level of the organometallic compound represented by Formula 1 may be about -5.0 eV to about -4.0 eV, or about -4.8 eV to about -4.5 eV. In one or more embodiments, the lowest unoccupied molecular orbital (LUMO) energy level of the organometallic compound represented by Formula 1 may be about -1.7 eV to about -1.0 eV, or about -1.3 eV to about -1.05 eV. In one or more embodiments, the T₁ energy level of the organometallic compound represented by Formula 1 may be about 2.0 eV to about 3.0 eV, or about 2.4 eV to about 2.5 eV. The HOMO energy level, LUMO energy level, and T₁ energy level may be evaluated by using a simulation evaluation method based on density functional theory (DFT), for example, a simulation evaluation method using Gaussian 09 program involving molecular structure optimization by DFT based on B3LYP.

The HOMO energy level, LUMO energy level, and T₁ energy level of some of the organometallic compounds represented by Formula 1 were evaluated by using the Gaussian 09 program involving molecular structure optimization by DFT based on B3LYP. Results of the evaluation are shown in Table 1.

**Table 1**

| Compound No. | HOMO (eV) | LUMO (eV) | T₁ (eV) |
|---|---|---|---|
| 94 | -4.7013 | -1.1652 | 2.4739 |
| 98 | -4.7511 | -1.2093 | 2.4551 |
| 99 | -4.6891 | -1.1217 | 2.4732 |
| 103 | -4.7386 | -1.1796 | 2.4542 |
| 104 | -4.6689 | -1.1072 | 2.4665 |
| 108 | -4.7291 | -1.1666 | 2.4535 |

From Table 1, it was confirmed that the organometallic compound represented by Formula 1 has electric characteristics suitable for use as a dopant for an electronic device, for example, a light-emitting device.

Synthesis methods of the organometallic compound represented by Formula 1 may be recognizable by one of ordinary skill in the art by referring to Synthesis Examples provided below.

Accordingly, the organometallic compound represented by Formula 1 may be suitable for use as a dopant for an interlayer of a light-emitting device, for example, an emission layer of the interlayer. Thus, according to another aspect, provided is a light-emitting device including a first electrode, a second electrode, and an interlayer that is disposed between the first electrode and the second electrode, wherein the interlayer includes an emission layer, and wherein the interlayer further includes at least one of the organometallic compounds represented by Formula 1.

Due to the inclusion of the interlayer containing at least one of the organometallic compounds represented by Formula 1 as described herein, the light-emitting device can have improved external quantum efficiency and improved lifetime characteristics.

The organometallic compound represented by Formula 1 may be used between a pair of electrodes of a light-emitting device. For example, the organometallic compound represented by Formula 1 may be included in the emission layer. In this regard, the organometallic compound may act as a dopant, and the emission layer may further include a host (that is, an amount of the at least one organometallic compound represented by Formula 1 in the emission layer is less than an amount of the host in the emission layer, based on weight).

According to one or more embodiments, the emission layer (or a light-emitting device including the emission layer) may emit light having the maximum emission wavelength of about 510 nm to about 550 nm, about 510 nm to about 540 nm, about 510 nm to about 529 nm, about 515 nm to about 550 nm, about 515 nm to about 540 nm, about 515 nm to about 529 nm, about 520 nm to about 550 nm, about 520 nm to about 540 nm, about or 520 nm to about 529 nm. For example, the emission layer, or a light-emitting device including the emission layer, may emit light (for example, a green light) having a maximum emission wavelength of about 510 nm to about 529 nm, or about 520 nm to about 529 nm.

The expression "(an interlayer) includes at least one of organometallic compounds represented by Formula 1" as used herein may include a case in which "(an interlayer) includes identical organometallic compounds represented by Formula 1" and a case in which "(an interlayer) includes two or more different organometallic compounds represented by Formula 1."

In one or more embodiments, the interlayer may include, as the at least one organometallic compound represented by Formula 1, only Compound 1. In this regard, Compound 1 may be present in the emission layer of the light-emitting device. In one or more embodiments, the interlayer may include, as the at least one organometallic compound represented by Formula 1, Compound 1 and Compound 2. In this regard, Compound 1 and Compound 2 may exist in the same layer (for example, both Compound 1 and Compound 2 may exist in the emission layer).

The first electrode may be an anode, which is a hole injection electrode, and the second electrode may be a cathode, which is an electron injection electrode, or the first electrode may be a cathode, which is an electron injection electrode, and the second electrode may be an anode, which is a hole injection electrode.

For example, in the light-emitting device, the first electrode may be an anode, the second electrode may be a cathode, and the interlayer may further include: a hole transport region between the first electrode and the emission layer; and an electron transport region between the emission layer and the second electrode, wherein the hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "interlayer" as used herein refers to a single layer and/or a plurality of layers located between a first electrode and a second electrode of a light-emitting device. The "interlayer" may include, in addition to an organic compound, an organometallic complex including a metal.

The FIGURE is a schematic cross-sectional view of an organic light-emitting device 10 of a light-emitting device according to one or more embodiments. Hereinafter, the structure and manufacturing method of the organic light-emitting device 10 according to one or more embodiments will be described with reference to the FIGURE. The organic light-emitting device 10 may have a structure in which a first electrode 11, an interlayer 15, and a second electrode 19 are sequentially stacked in the stated order.

A substrate may be further disposed under the first electrode 11 or on the second electrode 19. The substrate may be a substrate commonly used in organic light-emitting devices, for example, a glass substrate or a transparent plastic substrate, which have excellent mechanical strength, thermal stability, transparency, surface smoothness, ease of handling, and/or water repellency.

The first electrode 11 may be formed by, for example, depositing or sputtering, onto the substrate, a material for forming the first electrode 11. The first electrode 11 may be an anode. The material for forming the first electrode 11 may include materials with a high work function to facilitate hole injection. The first electrode 11 may be a reflective electrode, a transflective electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The interlayer 15 may be arranged on the first electrode 11.

The interlayer 15 may include a hole transport region, an emission layer, and an electron transport region.

The hole transport region may be disposed between the first electrode 11 and the emission layer.

The hole transport region may include a hole injection layer (HIL), a hole transport layer, an electron-blocking layer, a buffer layer, or a combination thereof.

The hole transport region may include only either a HIL or a hole transport layer. In one or more embodiments, the hole transport region may have a HIL/hole transport layer structure or a HIL/hole transport layer/electron-blocking layer structure, in which respective layers of each structure are sequentially stacked in the stated order from the first electrode 11.

When the hole transport region includes a HIL, the HIL may be formed on the first electrode 11 by using various methods, for example, vacuum deposition, spin coating, casting, and/or Langmuir-Blodgett (LB) deposition, but embodiments are not limited thereto.

When a HIL is formed by vacuum deposition, the deposition conditions may vary depending on a material that is used to form the HIL, and the structure and thermal characteristics of the HIL. For example, the deposition conditions may include a deposition temperature of about 100°C to about 500°C, a vacuum pressure of about 10⁻⁸ torr to about 10⁻³ torr, and a deposition rate of about 0.01 angstrom per second (Å/sec) to about 100 Å/sec.

When the HIL is formed by spin coating, the coating conditions may vary depending on a material for forming the HIL, and the structure and thermal characteristics of the HIL. For example, the coating conditions may include a coating speed of about 2,000 revolutions per minute (rpm) to about 5,000 rpm and a heat treatment temperature of about 80°C to about 200°C for removing a solvent after coating, but embodiments are not limited thereto.

The conditions for forming the hole transport layer and the electron-blocking layer may be referred to the description provided for the conditions for forming the HIL.

The hole transport region may be 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto:

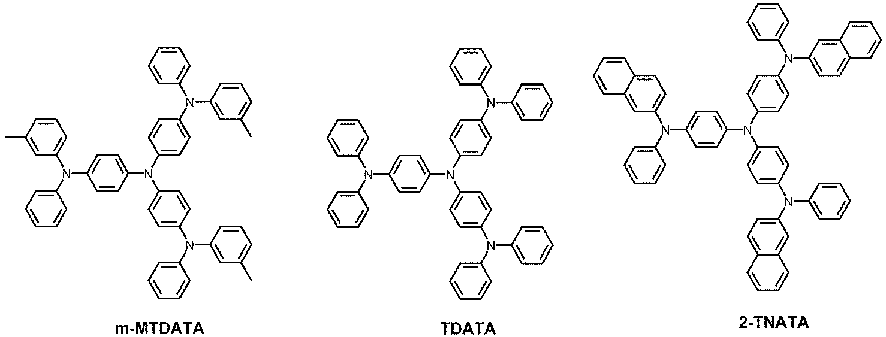

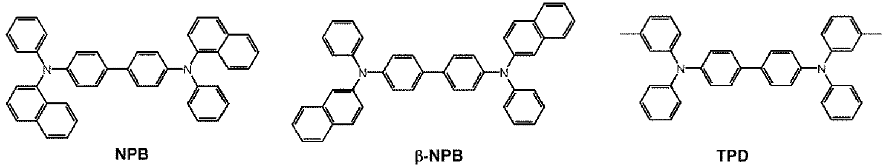

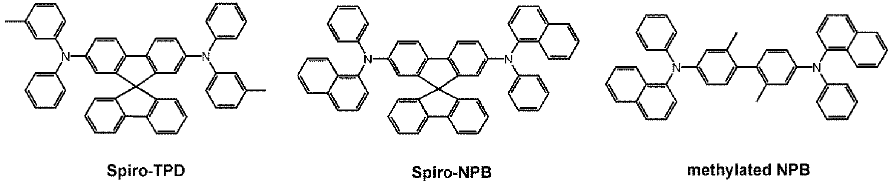

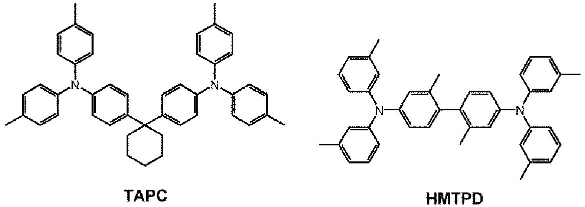

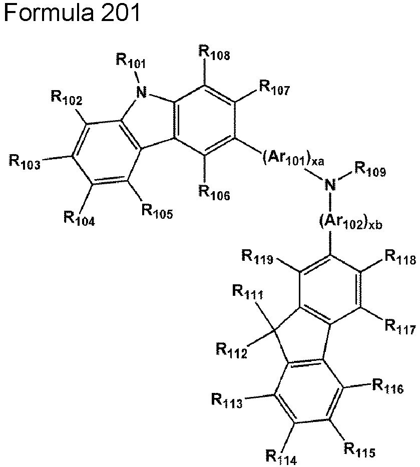

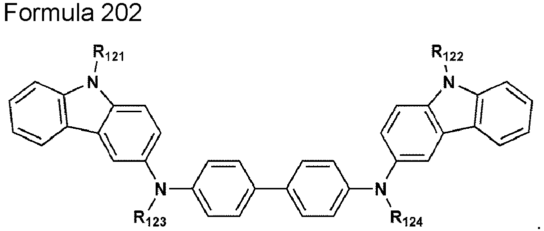

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂ -C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆ -C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amnio group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted deuterium, -F, -Cl, -Br,-I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A:

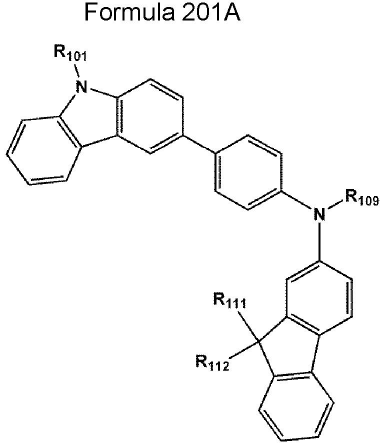

R₁₀₁, R₁₁₁, R₁₁₂, and R₁₀₉ in Formula 201A may each be as described herein. For example, the compound represented by Formula 201 and the compound represented by Formula 202 may include one or more of Compounds HT1 to HT20:

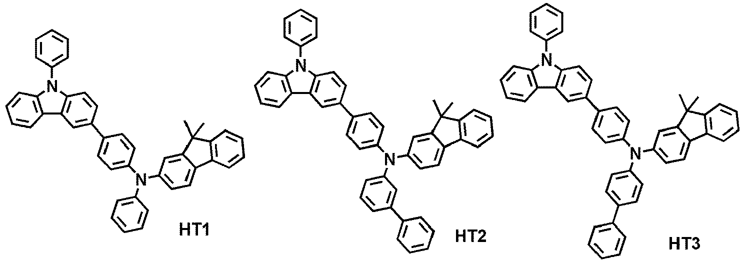

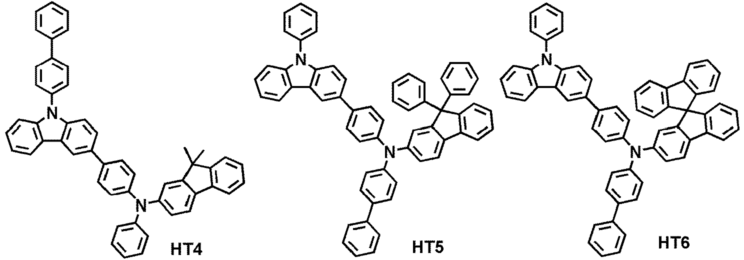

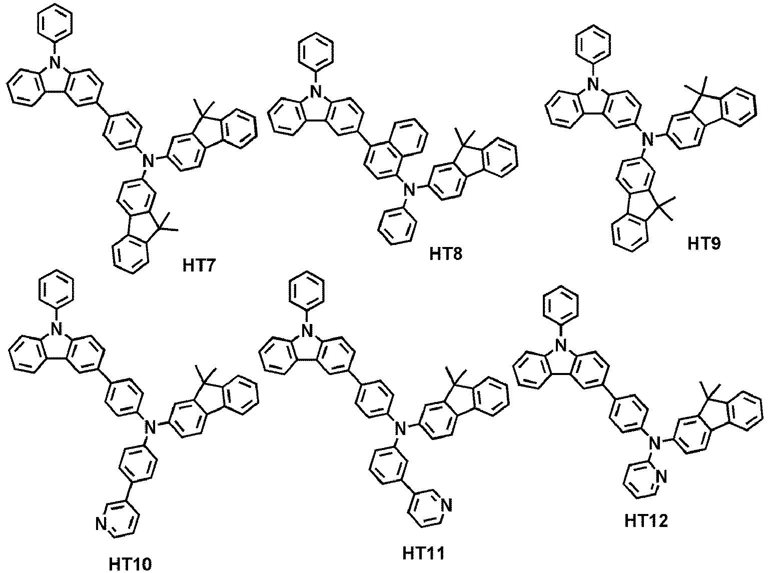

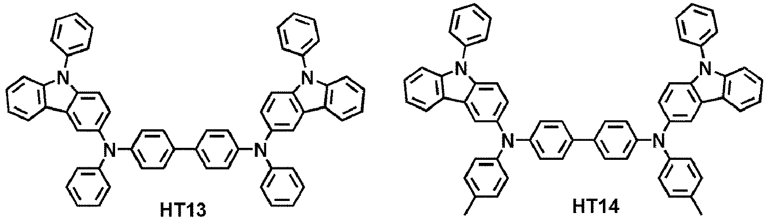

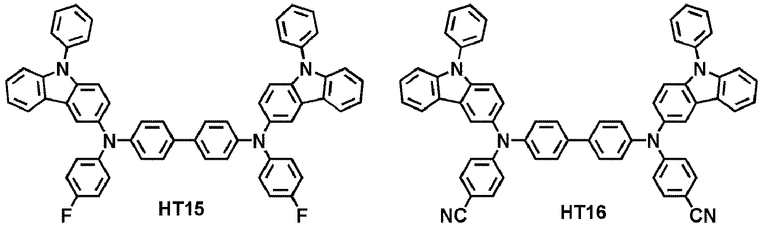

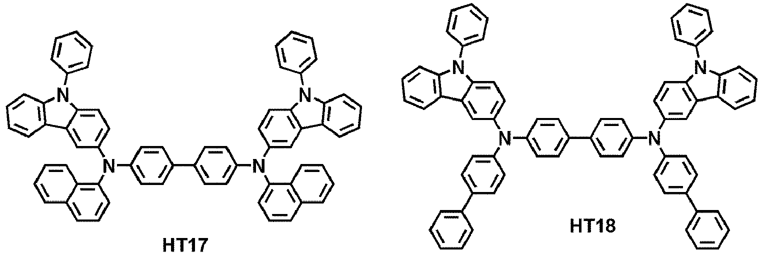

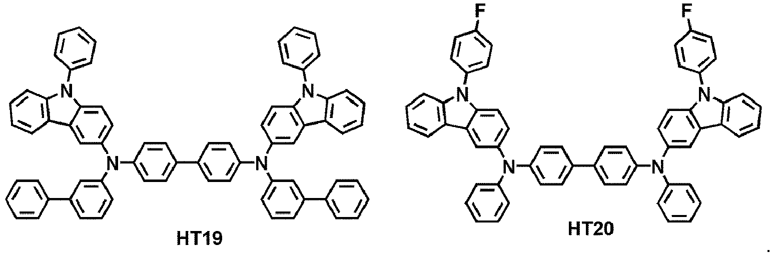

A thickness of the hole transport region may be about 100 Å to about 10,000 Å, for example, about 100 Å to about 1,000 Å. When the hole transport region includes at least one of a HIL and a hole transport layer, the thickness of the HIL may be about 50 Å to about 5000 Å, for example, about 50 Å to about 1000 Å, and the thickness of the hole transport layer may be about 50 Å to about 3000 Å, for example, about 100 Å to about 2000 Å. When the thicknesses of the hole transport region, the HIL, and the hole transport layer are within these ranges, satisfactory hole transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), HT-D2, or the like; a metal oxide, such as a tungsten oxide, a molybdenum oxide, or the like; or a cyano group-containing compound, such as Compound HT-D1, but embodiments are not limited thereto:

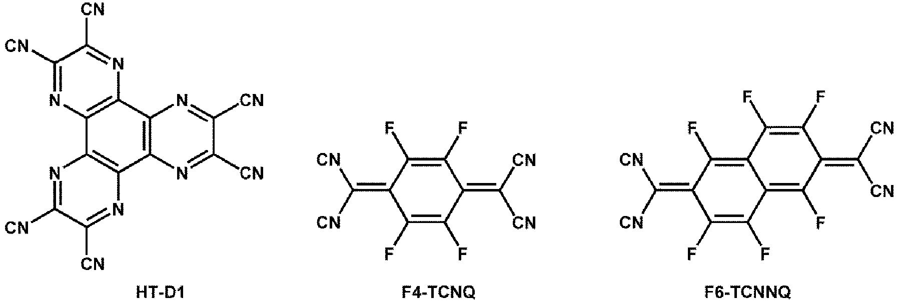

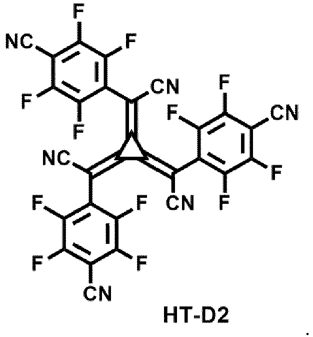

The hole transport region may include a buffer layer.

The buffer layer may compensate for an optical resonance distance according to a wavelength of light emitted from the emission layer, and thus, efficiency of a formed organic light-emitting device may be improved.

Meanwhile, when the hole transport region includes an electron-blocking layer, a material for forming the electron-blocking layer may include a material that is used in the hole transport region as described herein, a host material described herein, or a combination thereof. For example, when the hole transport region includes an electron-blocking layer, a material for forming the electron-blocking layer may be mCP, H-H1, or the like which are described herein.

The emission layer (EML) may be formed on the hole transport region by vacuum deposition, spin coating, casting, LB deposition, or the like. When the emission layer is formed by vacuum deposition or spin coating, the deposition or coating conditions may generally be similar to those applied in forming the HIL although the deposition or coating conditions may vary according to a material that is used to form the emission layer.

The emission layer may include a host and a dopant, and the dopant may include at least one of the organometallic compounds represented by Formula 1.

The hosts may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl)benzene (TCP), 1,3-bis(N-carbazolyl)benzene (mCP), Compound H50, Compound H51, Compound H52, Compound H-H1, Compound HE43, Compound GH3, or a combination thereof, but embodiments are not limited thereto:

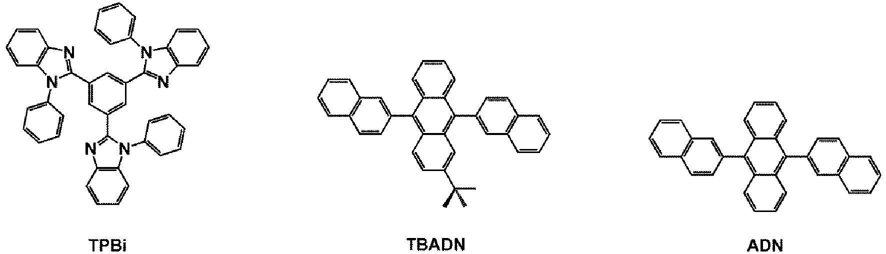

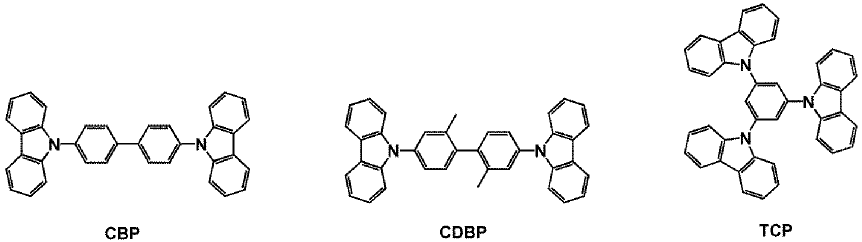

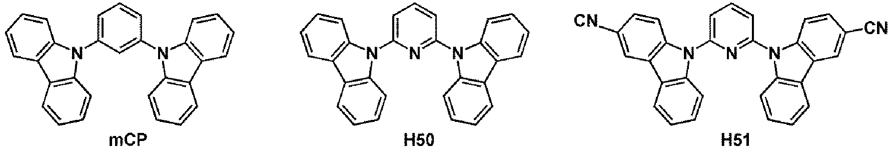

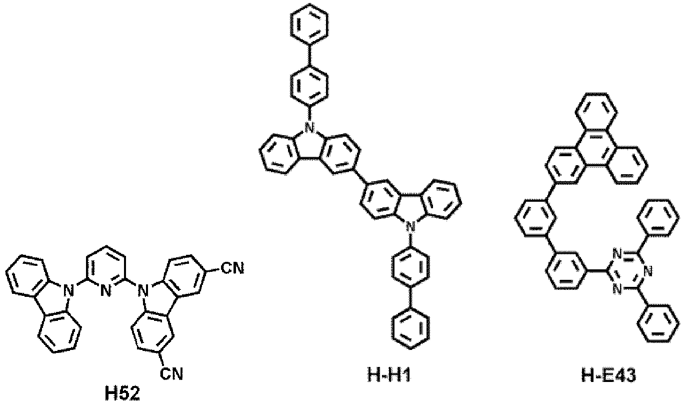

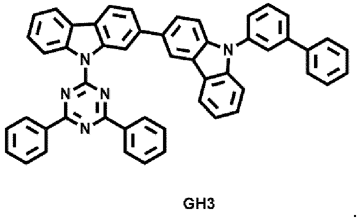

When the organic light-emitting device is a full-color organic light-emitting device, the emission layer may be patterned into a red emission layer, a green emission layer, and/or a blue emission layer. In one or more embodiments, the emission layer may have a structure in which a red emission layer, a green emission layer, and/or a blue emission layer are stacked, and thus, various modifications such as emission of white light are possible.

When the emission layer includes a host and a dopant, the amount (for example, by weight) of the dopant may typically be about 0.01 parts by weight to about 20 parts by weight based on about 100 parts by weight of the emission layer.

The thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

Next, an electron transport region may be placed on the emission layer.

The electron transport region may include a hole-blocking layer, an electron transport layer, an EIL, or a combination thereof.

For example, the electron transport region may have a hole-blocking layer/electron transport layer/electron injection layer structure or an electron transport layer/electron injection layer structure. The electron transport layer may have a single-layered structure or a multi-layered structure including two or more different materials.

Conditions for forming the hole-blocking layer, the electron transport layer, and the electron injection layer which constitute the electron transport region may be referred to the description provided for the conditions for forming the HIL.

When the electron transport region includes a hole-blocking layer, the hole-blocking layer may include, for example, at least one of 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof, but embodiments are not limited thereto:

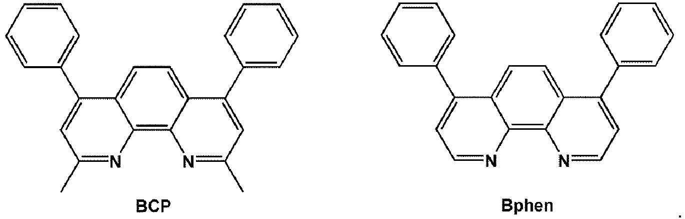

A thickness of the hole-blocking layer may be about 20 Å to about 1,000 Å, for example, about 30 Å to about 300 Å. When the thickness of the hole-blocking layer is within these ranges, excellent hole-blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto:

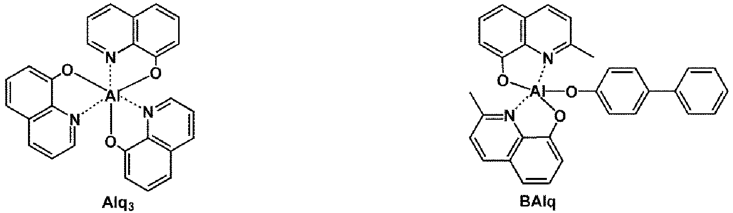

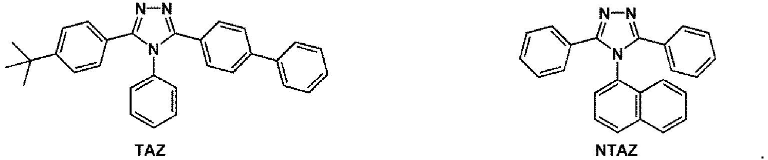

In one or more embodiments, the electron transport layer may include one of Compounds ET1 to ET25, or a combination thereof, but embodiments are not limited thereto:

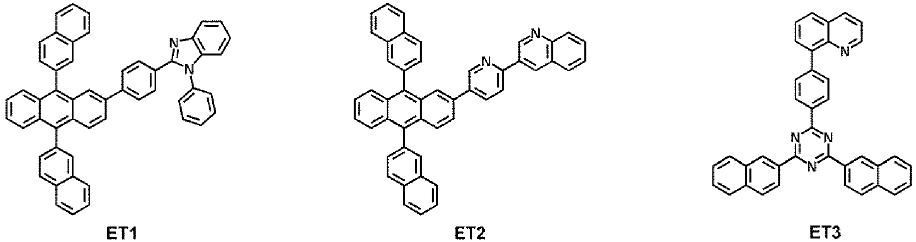

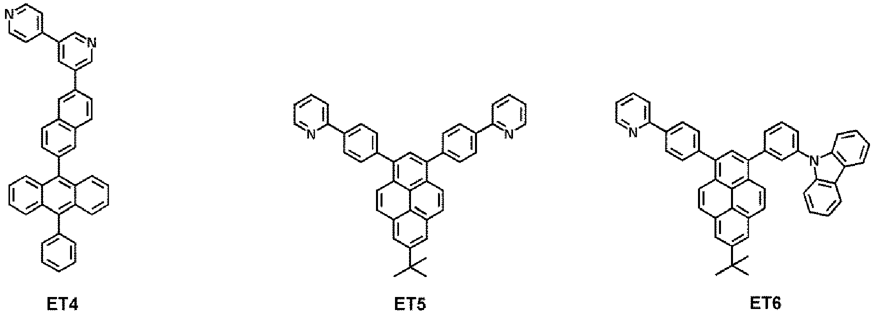

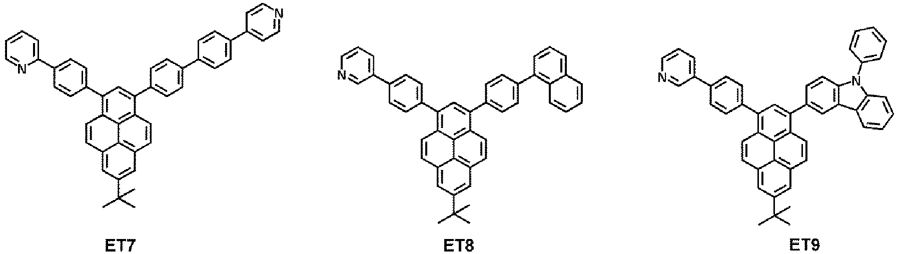

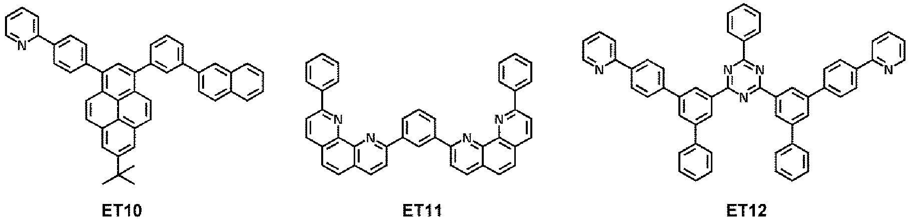

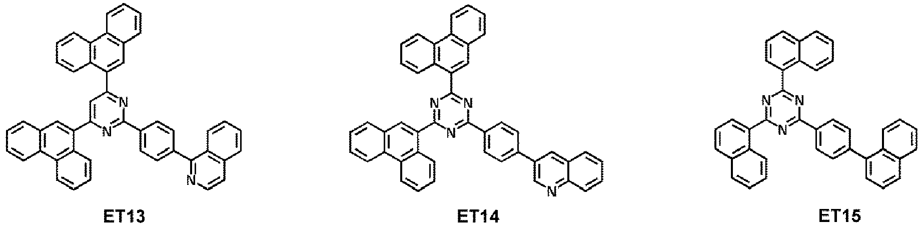

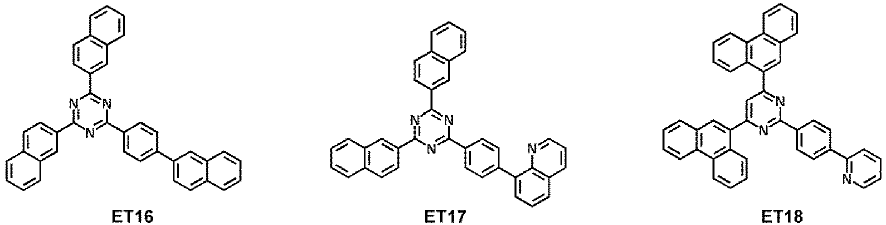

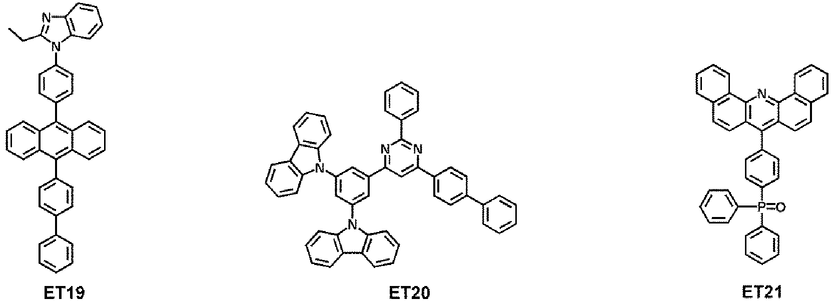

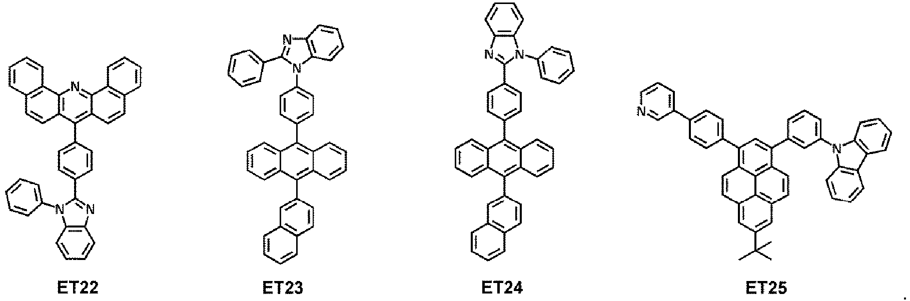

The thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described herein.

The metal-containing material may include a Li complex. The Li complex may include, for example, Compound ET-D1 (LiQ) or ET-D2, but embodiments are not limited thereto:

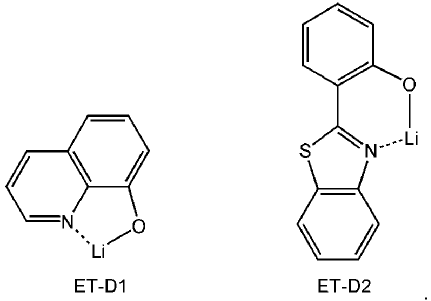

The electron transport region may include an EIL that facilitates the injection of electrons from the second electrode 19.

The electron injection layer may include ET-D1, LiF, NaCl, CsF, Li₂O, BaO, or a combination thereof.

A thickness of the electron injection layer may be about 1 Å to about 100 Å, for example, about 3 Å to about 90 Å. When the thickness of the electron injection layer is within the range as described above, satisfactory electron injection characteristics may be obtained without a substantial increase in driving voltage.

A second electrode 19 may be provided on the interlayer 15. The second electrode 19 may be a cathode. A material for the second electrode 19 may be a metal, an alloy, an electrically conductive compound, or a combination thereof, each having a relatively low work function. For example, lithium (Li), silver (Ag), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, various modifications, such as formation of a transmissive second electrode using ITO or IZO, is possible.

Hereinbefore, the light-emitting device 10 according to one or more embodiments has been described in connection with the FIGURE, but embodiments are not limited thereto.

According to another aspect, the light-emitting device may be included in an electronic apparatus. Thus, an electronic apparatus including the light-emitting device is provided. The electronic apparatus may include, for example, a display, an illumination, a sensor, or the like.

According to one or more embodiments, a diagnostic composition includes at least one organometallic compound represented by Formula 1.

The organometallic compound represented by Formula 1 may provide a high luminous efficiency, and thus, a diagnostic composition including at least one of the organometallic compounds represented by Formula 1 may have high diagnostic efficiency.

The diagnostic composition may be used in various applications including a diagnosis kit, a diagnosis reagent, a biosensor, or a biomarker, but embodiments are not limited thereto.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

As used herein, the C₁-C₆₀ alkyl group may be a C₁-C₂₀ alkyl group. As used herein, the C₁-C₂₀ alkyl group may be a C₁-C₁₀ alkyl group, a C₁-C₆ alkyl group, or a C₁-C₃ alkyl group. The C₁-C₆₀ alkyl group, the C₁-C₂₀ alkyl group, and the C₁-C₁₀ alkyl group may each independently linear or branched, and in the case of the branched alkyl group, the lower limit of the carbon number in each of the alkyl groups becomes 3. Non-limiting examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, a propoxy group, a butoxy group, a pentoxy group, or the like.

The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein refers to a structure containing at least one carbon-carbon double bond in the middle or at the end of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof are an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon ring group having 3 to 10 carbon atoms, and the C₃-C₁₀ cycloalkylene group is a divalent group having the same structure as the C₃-C₁₀ cycloalkyl group.

Non-limiting examples of the C₃-C₁₀ cycloalkyl group include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

The term "C₁-C₁₀ heterocycloalkyl group" as used herein refers to a monovalent saturated ring group that includes at least one heteroatom selected from N, O, P, Si, S, Se, Ge, and B as a ring-forming atom and 1 to 10 carbon atoms as ring-forming atom(s), and the term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent ring group that has 3 to 10 carbon atoms as ring-forming atoms and has at least one carbon-carbon double bond in the ring thereof and has no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent ring group that includes at least one heteroatom selected from N, O, P, Si, S, Se, Ge, and B as a ring-forming atom, 1 to 10 carbon atoms as ring-forming atom(s), and at least one double bond in the ring thereof, and has no aromaticity. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms as ring-forming atoms, and the term "C₆-C₆₀ arylene group" as used herein refers to a divalent group having a carbocyclic aromatic ring system having 6 to 60 carbon atoms as ring-forming atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused with each other.

The term "C₇-C₆₀ alkyl aryl group" as used herein refers to a C₆-C₆₀ aryl group substituted with at least one C₁-C₆₀ alkyl group. The term "C₇-C₆₀ aryl group alkyl" as used herein refers to a C₁-C₆₀ alkyl group substituted with at least one C₆-C₆₀ aryl group.

The term "C₁-C₆₀ heteroaryl group" as used herein refers to a monovalent group that includes at least one heteroatom selected from N, O, P, Si, S, Se, Ge, and B as a ring-forming atom and a heteroaromatic ring system having 1 to 60 carbon atoms, and the term "C₁-C₆₀ heteroarylene group" as used herein refers to a divalent group that includes at least one heteroatom selected from N, O, P, Si, S, Se, Ge, and B as a ring-forming atom and a heteroaromatic system having 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused with each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ indicates the C₆-C₆₀ aryl group), the C₆-C₆₀ arylthio group indicates -SA₁₀₃ (wherein A₁₀₃ indicates the C₆-C₆₀ aryl group).

The term "C₁-C₆₀ heteroaryloxy group" as used herein indicates -OA₁₀₅ (wherein A₁₀₅ is a C₁-C₆₀ heteroaryl group), and the term "C₁-C₆₀ heteroarylthio group" as used herein indicates -SA₁₀₆ (wherein A₁₀₆ is the C₁-C₆₀ heteroaryl group).

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as ring-forming atoms, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" used herein include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group, or the like (each unsubstituted or substituted with at least one R₁₀ₐ).

The term "C₁-C₃₀ heterocyclic group" as used herein refers to a saturated or unsaturated ring group having, as a ring-forming atom, at least one heteroatom selected from N, O, P, Si, S, Se, Ge, and B other than 1 to 30 carbon atoms as ring-forming atoms(s). The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

Non-limiting examples of the "C₅-C₃₀ carbocyclic group" and "C₁-C₃₀ heterocyclic group" as used herein include i) a first ring, ii) a second ring, iii) a condensed ring group in which two or more first rings are condensed with each other, iv) a condensed ring group in which two or more second rings are condensed with each other, or v) a condensed ring group in which at least one first ring is condensed with at least one second ring,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, -CFH₂, or the like. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen atoms included therein are substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen atoms included therein are not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include - CD₃, -CD₂H, -CDH₂, or the like, and examples of the "deuterated C₃-C₁₀ cycloalkyl group" include, for example, Formula 10-501 or the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen atoms included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen atoms included therein are not substituted with deuterium.

The term "(C₁-C₂₀ alkyl)'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a tolyl group.

As used herein, the terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

A substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅),-B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂ -C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃),-Ge(Q₂₁)(Q₂₂)(Q₂₃), -N(Q₂₄) (Q₂₅), -B(Q₂₆)(Q₂₇), -P(=O)(Q₂₈)(Q₂₉), P(Q₂₈)(Q₂₉), or a combination thereof;
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇),-P(=O)(Q₃₈)(Q₃₉), or -P(Q₃₈)(Q₃₉); or
a combination thereof.

Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉, and Q₃₁ to Q₃₉ as described herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, organometallic compounds represented by Formula 1 and organic light-emitting devices including the same, according to one or more embodiments, will be described in further detail with reference to Synthesis Example and Examples. However, the following examples are not intended to limit the scope of the disclosure. The wording "B was used instead of A" used in describing Synthesis Examples means that an amount of A used was identical to an amount of B used, in terms of a molar equivalent.

### EXAMPLES

### Synthesis Example 1 (Compound 1)

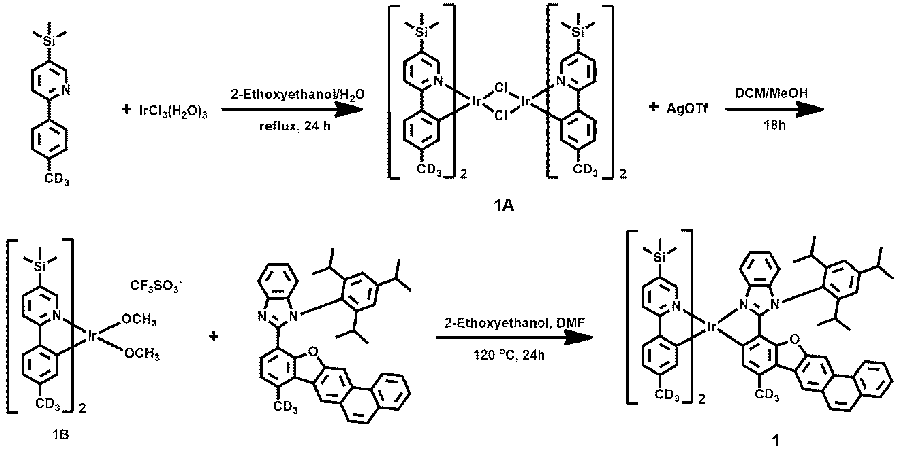

### Synthesis of Compound 1A

2-(4-(methyl-d3)phenyl)-5-(trimethylsilyl)pyridine [3.0 grams (g), 12.27 millimoles (mmol)] and iridium chloride trihydrate (2.06 g, 5.84 mmol) were combined with 90 milliliters (mL) of 2-ethoxyethanol and 30 mL of distilled water. The reaction mixture was stirred under reflux for 24 hours, and then cooled to room temperature. Precipitated solids were separated by filtration, and thoroughly washed with water/methanol/hexane in that order. The obtained solids were dried in a vacuum oven to provide 3.4 g (yield of 81%) of Compound 1A.

### Synthesis of Compound 1B

Compound 1A (3.4 g, 2.38 mmol) was combined with 120 mL of dichloromethane (DCM), and then a solution of silver trifluoromethanesulfonate (AgOTf) (1.28 g, 5 mmol) in 40 mL of methanol (MeOH) was added thereto. Afterwards, the reaction mixture was stirred at room temperature for 18 hours in the dark, then filtered through Celite to remove the precipitated solids, and the filtrate was concentrated to provide a solid residue (Compound 1B), which was then used in the next reaction without further purification.

### Synthesis of Compound 1

Compound 1B (3 g, 3.37 mmol) and 2-(8-(methyl-d3)phenanthro[3,2-b]benzofuran-11-yl)-1-(2,4,6-triisopropylphenyl)-1H-benzo[d]imidazole (2.04 g, 3.37 mmol) were combined with 25 mL of 2-ethoxyethanol and 25 mL of dimethylformamide (DMF). The reaction mixture was stirred at 120 °C for 24 hours, and then cooled. The resulting mixture was concentrated under reduced pressure to provide a solid residue, which was then purified by column chromatography (eluent: hexane and ethyl acetate) to provide 1.03 g (yield of 24%) of Compound 1. The obtained Compound 1 was identified by high resolution mass spectrometry using matrix assisted laser desorption ionization (HRMS (MALDI)) and high-performance liquid chromatography (HPLC) analysis.

HRMS (MALDI) calculated for C₇₃H₆₆D₉IrN₄OSi₂: mass to charge ratio (m/z) 1281.5674, Found: 1281.5678.

### Synthesis Example 2 (Compound 109)

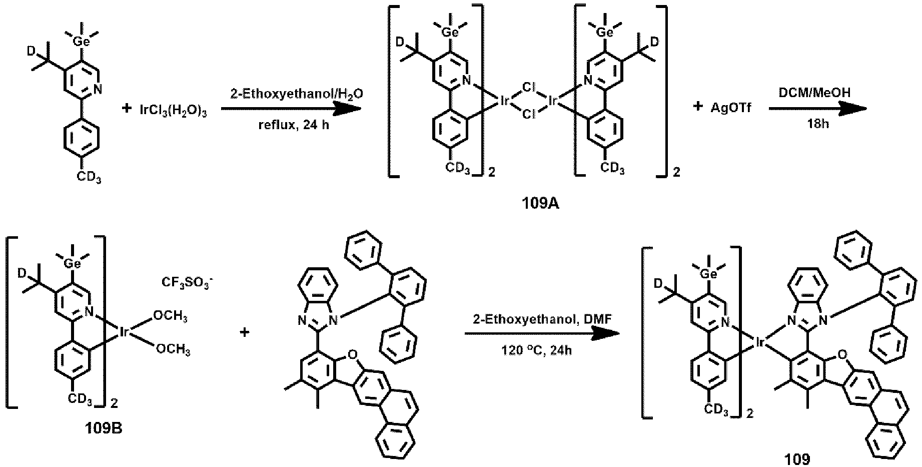

### Synthesis of Compound 109A

2-(4-(methyl-d3)phenyl)-4-(propan-2-yl-2-d)-5-(trimethylgermyl)pyridine (3.0 g, 9.03 mmol) and iridium chloride trihydrate (1.52 g, 4.30 mmol) were combined with 90 mL of 2-ethoxyethanol and 30 mL of distilled water. The reaction mixture was then stirred under reflux for 24 hours, and the resultant reaction mixture was cooled to room temperature. Precipitated solids were separated by filtration, and thoroughly washed with water/methanol/hexane in that order. The obtained solids were dried in a vacuum oven to provide 3.1 g (yield of 81%) of Compound 109A.

### Synthesis of Compound 109B

Compound 109A (3.1 g, 1.74 mmol) was combined with 120 mL of dichloromethane, and then a solution of AgOTf (0.94 g, 3.66 mmol) in 40 mL of methanol was added thereto. Afterwards, the reaction mixture was stirred at room temperature for 18 hours in the dark, then filtered through Celite to remove the precipitated solids, and the filtrate was concentrated to provide a solid residue (Compound 109B), which was used in the next reaction without further purification.

### Synthesis of Compound 109

Compound 109B (2.8 g, 2.63 mmol) and 1-([1,1':3',1"-terphenyl]-2'-yl)-2-(11,12-dimethylphenanthro[2,3-b]benzofuran-9-yl)-1H-benzo[d]imidazole (1.68 g, 2.63 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 1.01 g (yield of 26%) of Compound 109. The obtained Compound 109 was identified by mass spectrometry and HPLC analysis.

HRMS(MALDI) calculated for C₈₃H₇₁D₈Ge₂IrN₄O: m/z 1496.4809, Found: 1496.4813.

### Synthesis Example 3 (Compound 49)

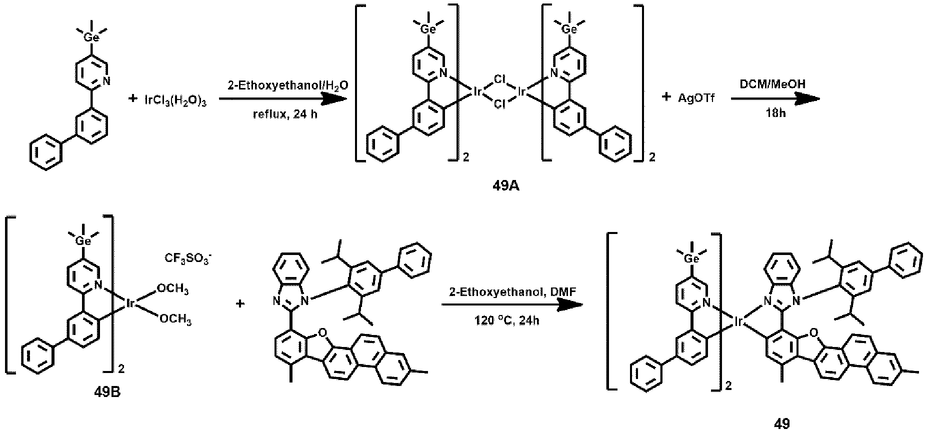

### Synthesis of Compound 49A

2-([1,1'-biphenyl]-3-yl)-5-(trimethylgermyl)pyridine) (3.0 g, 8.62 mmol) and iridium chloride trihydrate (1.45 g, 4.10 mmol) were combined with 90 mL of 2-ethoxyethanol and 30 mL of distilled water. The reaction mixture was then stirred under reflux for 24 hours. Then, the temperature was lowered to room temperature. Precipitated solids were separated by filtration, and thoroughly washed with water/methanol/hexane in that order. The obtained solids were dried in a vacuum oven to provide 3.1 g (yield of 82%) of Compound 49A.

### Synthesis of Compound 49B

Compound 49A (3.1 g, 1.68 mmol) was combined with 120 mL of dichloromethane, and then a solution of AgOTf (0.91 g, 3.53 mmol) in 40 mL of methanol was added thereto. Afterwards, the reaction mixture was stirred at room temperature for 18 hours in the dark, then filtered through Celite to remove the precipitated solids, and the filtrate was concentrated to provide a solid residue (Compound 49B), which was used in the next reaction without further purification.

### Synthesis of Compound 49

Compound 49B (2.8 g, 2.55 mmol) and 1-(3,5-diisopropyl-[1,1'-biphenyl]-4-yl)-2-(4,9-dimethylphenanthro[1,2-b]benzofuran-12-yl)-1H-benzo[d]imidazole (1.66 g, 2.55 mmol) were combined with 25 mL of 2-ethoxyethanol and 25 mL of dimethylformamide. The reaction mixture was then stirred at 120 °C for 24 hours, and then the temperature was lowered. The resulting mixture was concentrated under reduced pressure to provide a solid residue, which was then purified by column chromatography (eluent: hexane and ethyl acetate) to provide 0.89 g (yield of 23%) of Compound 49. The obtained compound was identified by mass spectrometry and HPLC analysis.

HRMS(MALDI) calculated for C₈₇H₇₉Ge₂IrN₄O: m/z 1536.4307, Found: 1536.4311.

### Synthesis Example 4 (Compound 57)

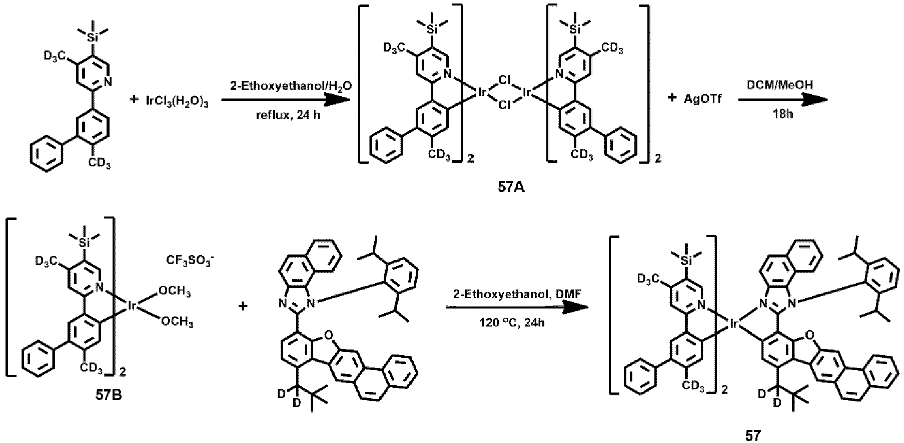

### Synthesis of Compound 57A

4-(methyl-d3)-2-(6-(methyl-d3)-[1,1'-biphenyl]-3-yl)-5-(trimethylsilyl)pyridine (3.0 g, 8.89 mmol) and iridium chloride trihydrate (1.49 g, 4.23 mmol) were combined with 90 mL of 2-ethoxyethanol and 30 mL of distilled water. The reaction mixture was stirred under reflux for 24 hours, and then cooled to room temperature. Precipitated solids were separated by filtration, and thoroughly washed with water/methanol/hexane in that order. The obtained solids were dried in a vacuum oven to provide 3.1 g (yield of 81%) of Compound 57A.

### Synthesis of compound 57B

Compound 57A (3.1 g, 1.68 mmol) was combined with 120 mL of dichloromethane, and then a solution of AgOTf (0.93 g, 3.61 mmol) in 40 mL of methanol was added thereto. Afterwards, the reaction mixture was stirred at room temperature for 18 hours in the dark, then filtered through Celite to remove the precipitated solids, and the filtrate was concentrated to provide a solid residue (Compound 57B), which was used in the next reaction without further purification.

### Synthesis of Compound 57

Compound 57B (2.7 g, 2.51 mmol) and 1-(2,6-diisopropylphenyl)-2-(8-(2,2-dimethylpropyl-1,1-d2)phenanthro[3,2-b]benzofuran-11-yl)-1H-naphtho[1,2-d]imidazole (1.67 g, 2.51 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 0.92 g (yield of 24%) of Compound 57. The obtained compound was identified by mass spectrometry and HPLC analysis.

HRMS(MALDI) calculated for C₉₂H₇₇D₁₄IrN₄OSi₂: m/z 1530.7239, Found: 1530.7241.

### Synthesis Example 5 (Compound 94)

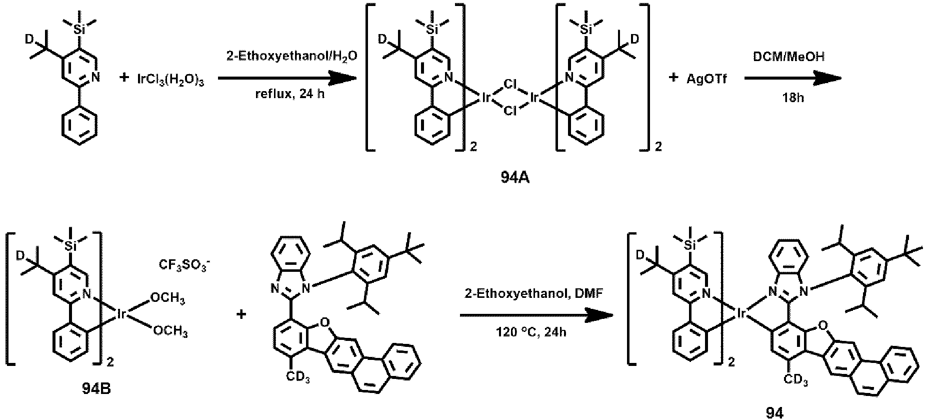

### Synthesis of Compound 94A

2-phenyl-4-(propan-2-yl-2-d)-5-(trimethylsilyl)pyridine (3.0 g, 11.09 mmol) and iridium chloride trihydrate (1.88 g, 5.32 mmol) were combined with 90 mL of 2-ethoxyethanol and 30 mL of distilled water. The reaction mixture was stirred under reflux for 24 hours, and then allowed to cool to room temperature. Precipitated solids were separated by filtration, and thoroughly washed with water/methanol/hexane in that order. The obtained solids were dried in a vacuum oven to provide 3.3 g (yield of 81%) of Compound 94A.

### Synthesis of Compound 94B

Compound 94A (3.3 g, 1.68 mmol) was combined with 120 mL of dichloromethane, and then a solution of AgOTf (1.16 g, 4.52 mmol) in 40 mL of methanol was added thereto. Afterwards, the reaction mixture was stirred at room temperature for 18 hours in the dark, then filtered through Celite to remove the precipitated solids, and the filtrate was concentrated to provide a solid residue (Compound 94B), which was used in the next reaction without further purification.

### Synthesis of Compound 94

Compound 94B (3.0 g, 3.18 mmol) and 1-(4-(tert-butyl)-2,6-diisopropylphenyl)-2-(8-(methyl-d3)phenanthro[3,2-b]benzofuran-11-yl)-1H-benzo[d]imidazole(1.77 g, 2.86 mmol) were mixed with 25 mL of 2-ethoxyethanol and 25 mL of dimethylformamide, stirred at 120 °C for 24 hours, and then the temperature was lowered. The resulting mixture was concentrated under reduced pressure to obtain a solid residue, which was then purified by column chromatography (eluent: hexane and ethyl acetate) to provide 0.99 g (yield of 23%) of Compound 94. The obtained compound was identified by mass spectrometry and HPLC analysis.

HRMS(MALDI) calculated for C₇₈H₈₀D₆IrN₄OSi₂: m/z 1347.6205, Found: 1347.6212.

### Synthesis Example 6 (Compound 98)

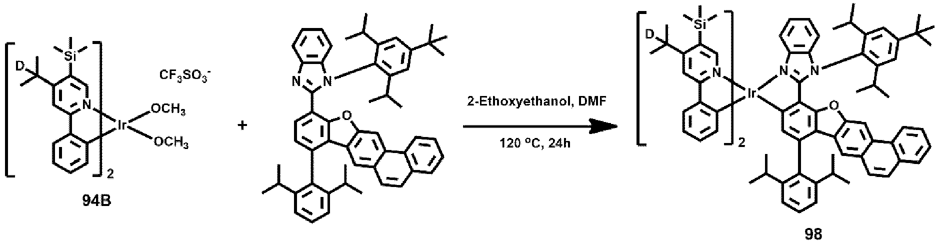

Compound 94B (3.0 g, 3.18 mmol) and 1-(4-(tert-butyl)-2,6-diisopropylphenyl)-2-(8-(2,6-diisopropylphenyl)phenanthro[3,2-b]benzofuran-11-yl)-1H-benzo[d]imidazole(2.18 g, 2.86 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 0.91 g (yield of 19%) of Compound 98. The obtained compound was identified by mass spectrometry and HPLC analysis.

HRMS(MALDI) calculated for C₈₉H₉₇D₂IrN₄OSi₂: m/z 1490.7112, Found: 1490.7116.

### Synthesis Example 7 (Compound 99)

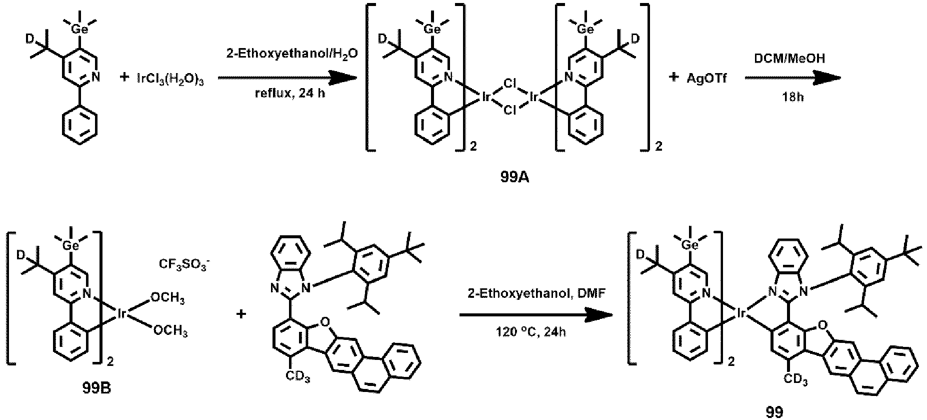

### Synthesis of Compound 99A

2-phenyl-4-(propan-2-yl-2-d)-5-(trimethylgermyl)pyridine (3.0 g, 9.52 mmol) and iridium chloride trihydrate (1.61 g, 4.57 mmol) were combined with 90 mL of 2-ethoxyethanol and 30 mL of distilled water. The reaction mixture was stirred under reflux for 24 hours, and then allowed to cool to room temperature. Precipitated solids were separated by filtration, and thoroughly washed with water/methanol/hexane in that order. The obtained solids were dried in a vacuum oven to provide 3.2 g (yield of 82%) of Compound 99A.

### Synthesis of Compound 99B

Compound 99A (3.2 g, 1.87 mmol) was combined with 120 mL of dichloromethane, and then a solution of AgOTf (1.00 g, 3.93 mmol) in 40 mL of methanol was added thereto. Afterwards, the reaction mixture was stirred at room temperature for 18 hours in the dark, then filtered through Celite to remove the resulting precipitated solids, and the filtrate was concentrated to provide a solid residue (Compound 99B), which was used in the next reaction without further purification.

### Synthesis of Compound 99

Compound 99B (3.0 g, 2.90 mmol) and 1-(4-(tert-butyl)-2,6-diisopropylphenyl)-2-(8-(methyl-d3)phenanthro[3,2-b]benzofuran-11-yl)-1H-benzo[d]imidazole(1.61 g, 2.61 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 0.99 g (yield of 24%) of Compound 99. The obtained compound was identified by mass spectrometry and HPLC analysis.

HRMS(MALDI) calculated for C₇₈H₈₀D₆Ge₂IrN₄O: m/z 1437.5099, Found: 1437.5103.

### Synthesis Example 8 (Compound 103)

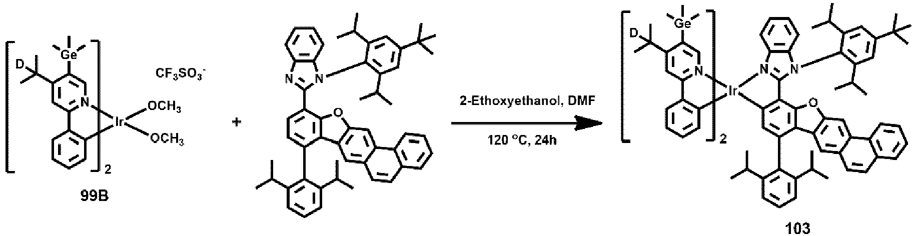

Compound 99B (3.0 g, 2.90 mmol) and 1-(4-(tert-butyl)-2,6-diisopropylphenyl)-2-(8-(2,6-diisopropylphenyl)phenanthro[3,2-b]benzofuran-11-yl)-1H-benzo[d]imidazole (1.99 g, 2.61 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 0.99 g (yield of 22%) of Compound 103. The obtained compound was identified by mass spectrometry and HPLC analysis.

HRMS(MALDI) calculated for C₇₈H₈₀D₆Ge₂IrN₄O: m/z 1580.6006, Found: 1580.6012.

### Synthesis Example 9 (Compound 104)

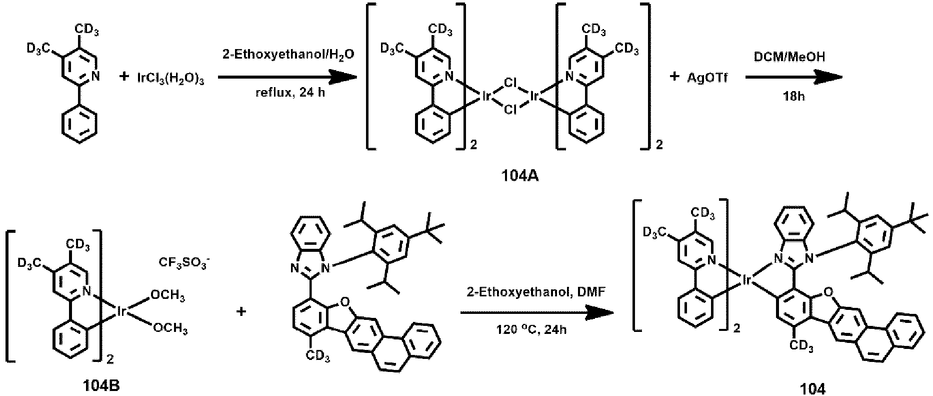

### Synthesis of Compound 104A

4,5-bis(methyl-d3)-2-phenylpyridine (2.0 g, 10.6 mmol) and iridium chloride trihydrate (1.79 g, 5.07 mmol) were combined with 90 mL of 2-ethoxyethanol and 30 mL of distilled water. The reaction mixture was stirred under reflux for 24 hours, and allowed to cool to room temperature. Precipitated solids were separated by filtration, and thoroughly washed with water/methanol/hexane in that order. The obtained solids were dried in a vacuum oven to provide 2.6 g (yield of 85%) of Compound 104A.

### Synthesis of Compound 104B

Compound 104A (2.6 g, 2.15 mmol) was combined with 120 mL of dichloromethane, and then a solution of AgOTf (1.16 g, 4.52 mmol) in 40 mL of methanol was added thereto. Afterwards, the reaction mixture was stirred at room temperature for 18 hours in the dark, then filtered through Celite to remove the resulting precipitated solids, and the filtrate was concentrated to provide a solid residue (Compound 104B), which was used in the next reaction without further purification.

### Synthesis of Compound 104

Compound 104B (2.6 g, 3.33 mmol) and 1-(4-(tert-butyl)-2,6-diisopropylphenyl)-2-(8-(methyl-d3)phenanthro[3,2-b]benzofuran-11-yl)-1H-benzo[d]imidazole (1.85 g, 2.99 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 0.92 g of Compound 104 (yield of 23%). The obtained compound was identified by mass spectrometry and HPLC analysis.

HRMS(MALDI) calculated for C₇₀H₅₀D₁₅IrN₄O: m/z 1185.5729, Found: 1185.5733.

### Synthesis Example 10 (Compound 108)

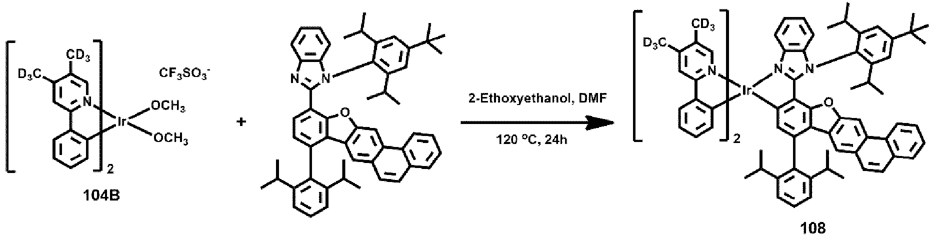

Compound 104B (2.6 g, 3.33 mmol) and 1-(4-(tert-butyl)-2,6-diisopropylphenyl)-2-(8-(2,6-diisopropylphenyl)phenanthro[3,2-b]benzofuran-11-yl)-1H-benzo[d]imidazole(2.28 g, 2.99 mmol) were combined with 25 mL of 2-ethoxyethanol and 25 mL of dimethylformamide. The reaction mixture was stirred at 120 °C for 24 hours, and then the temperature was lowered. The resulting mixture was concentrated under reduced pressure to provide a solid residue, which was then purified by column chromatography (eluent: hexane and ethyl acetate) to provide 1.0 g (yield of 23%) of Compound 108. The obtained compound was identified by mass spectrometry and HPLC analysis.

HRMS(MALDI) calculated for C₈₁H₆₇D₁₂IrN₄O: m/z 1328.6636, Found: 1328.6640.

### Synthesis Example 11 (Compound 110)

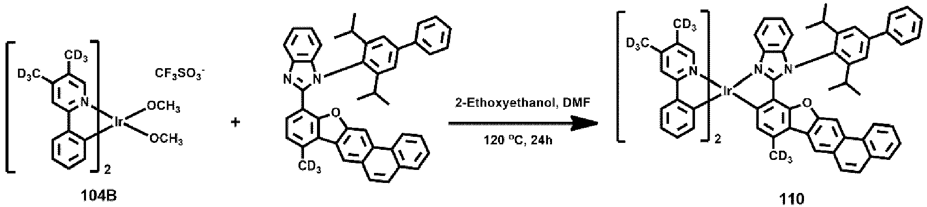

0.93 g (yield of 23%) of Compound 110 was obtained in the same manner as in Synthesis Example 9, except that 1-(4-(phenyl)-2,6-diisopropylphenyl)-2-(8-(methyl-d3)phenanthro[3,2-b]benzofuran-11-yl)-1H-benzo[d]imidazole was used instead of 1-(4-(tert-butyl)-2,6-diisopropylphenyl)-2-(8-(methyl-d3)phenanthro[3,2-b]benzofuran-11-yl)-1H-benzo[d]imidazole. The obtained compound was identified by mass spectrometry and HPLC analysis.

HRMS(MALDI) calculated for C₇₂H₄₆D₁₅IrN₄O: m/z 1205.5416, Found: 1205.5420

### Synthesis Example 12 (Compound 111)

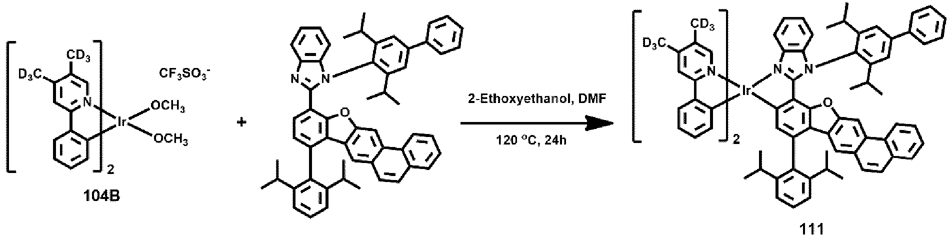

1.0 g of Compound 111 was obtained in the same manner as in Synthesis Example 9, except that 1-(4-(phenyl)-2,6-diisopropylphenyl)-2-(8-(2,6-diisopropylphenyl)phenanthro[3,2-b]benzofuran-11-yl)-1H-benzo[d]imidazole was used instead of 1-(4-(tert-butyl)-2,6-diisopropylphenyl)-2-(8-(2,6-diisopropylphenyl)phenanthro[3,2-b]benzofuran-11-yl)-1H-benzo[d]imidazole. The obtained compound was identified by mass spectrometry and HPLC analysis.

HRMS(MALDI) calculated for C₈₃H₆₃D₁₂IrN₄O: m/z 1348.6323, Found: 1348.6325.

### Example 1

An ITO(as an anode)-patterned glass substrate was cut to a size of 50 millimeters (mm) x 50 mm x 0.5 mm, sonicated with isopropyl alcohol and pure water, each for 5 minutes, and then cleaned by radiation with ultraviolet light (UV) and exposure to ozone for 30 minutes. The resulting glass substrate was loaded onto a vacuum deposition apparatus.

Compounds HT3 and HT-D2 were vacuum-codeposited in a weight ratio of 98:2 on the anode to form a HIL having a thickness of 100 angstroms (Å), and Compound HT3 was vacuum-deposited on the HIL to form a hole transport layer having a thickness of 1650 Å.

Next, a host (Compound GH3) and a dopant (Compound 94 listed in Table 2) were vacuum-co-deposited on the hole transport layer at a weight ratio of 92:8 to form an emission layer having a thickness of 400 Å.

Then, Compound ET3 and ET-D1 were vacuum-co-deposited on the emission layer in a volume ratio of 50:50 to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device. 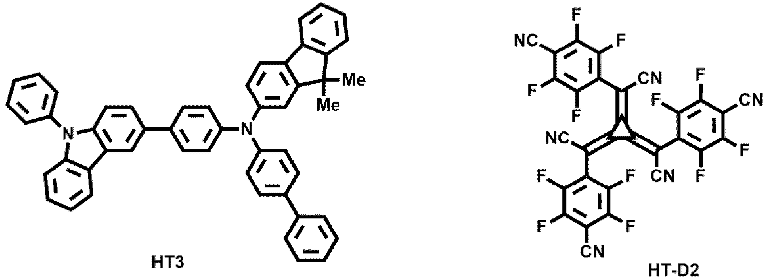 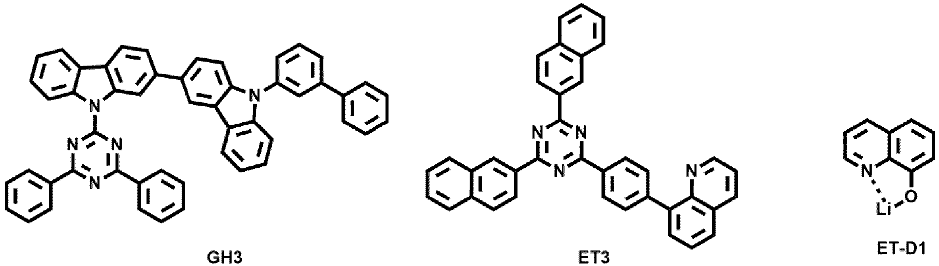 Comparative Example 1R, Example 2 and Comparative Example 2R

Organic light-emitting devices were manufactured in the same manner as in Example 1, except that the compounds listed in Table 2 were used as dopants when forming the emission layer.

### Evaluation Example 1

For each of the organic light-emitting devices manufactured in Example 1, Comparative Example 1R, Example 2, and Comparative Example 2R, driving voltage (volts, V), maximum external quantum efficiency (Max EQE), maximum emission wavelength (nm) and lifetime (LT₉₇) were evaluated. Results thereof are shown in Table 2. As evaluation devices, a current-voltage meter (Keithley 2400) and a luminance meter (Minolta Cs-1000A) were used, and for the lifetime (LT₉₇) (at 6,000 nit), the time (hr) required for the luminance to reach 97% of the initial luminance of 100% was evaluated. The maximum external quantum efficiency and lifetime were expressed as relative values (%). The maximum emission wavelength was set as the wavelength corresponding to the top of the emission peak of an emission spectrum measured with a luminance meter.

**Table 2**

| | Dopant in emission layer | Driving voltage (V) | Max EQE (relative value, %) | Maximum emission wavelength (nm) | LT₉₇ (relative value, %) (at 6,000 nit) |
|---|---|---|---|---|---|
| Example 1 | 94 | 4.5 | 108 | 522 | 140 |
| Comparative Example 1R | 94R | 4.6 | 100 | 521 | 100 |
| Example 2 | 98 | 4.4 | 105 | 526 | 120 |
| Comparative Example 2R | 98R | 4.5 | 98 | 524 | 85 |

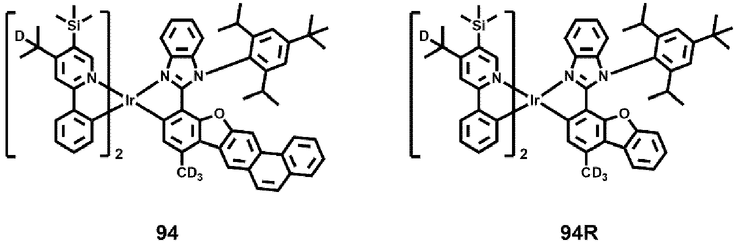

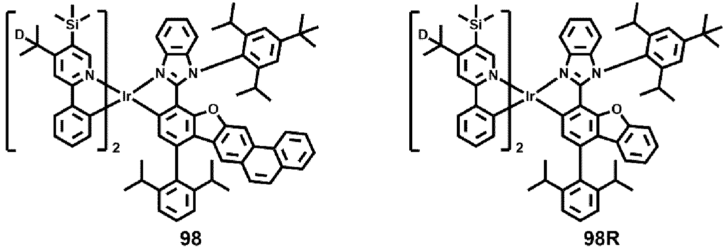

As shown in Table 2, the organic light-emitting device of Example 1 has an improved driving voltage, improved external quantum efficiency, and improved lifetime compared to the organic light-emitting device of Comparative Example 1R. Similarly, the organic light-emitting device of Example 2 has an improved driving voltage, improved external quantum efficiency, and improved lifetime compared to the organic light-emitting device of Comparative Example 2R.

### Comparative Example 3R

An organic light-emitting device was manufactured in the same manner as in Example 1, except that the compound listed in Table 3 was used as a dopant when forming the emission layer.

### Evaluation Example 2

The maximum emission wavelength (nm) of the organic light-emitting device manufactured in Comparative Example 3 was evaluated by using the same method as described in Evaluation Example 1, and the result is shown in Table 3 together with the maximum emission wavelengths of the organic light-emitting devices of Examples 1 and 2.

**Table 3**

| | Dopant in emission layer | Maximum emission wavelength (nm) |
|---|---|---|
| Example 1 | 94 | 522 |
| Example 2 | 98 | 526 |
| Comparative Example 3R | Ref1 | 530 |

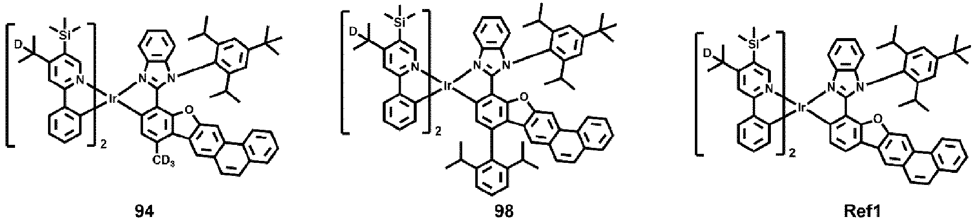

As shown in Table 3, the organic light-emitting devices of Examples 1 and 2 have a smaller maximum emission wavelength, for example, in the range of 510 nm to 529 nm, than the organic light-emitting device of Comparative Example 3R. Example 11, Comparative Example 11R, Example 12, and Comparative Example 12R

Organic light-emitting devices were manufactured in the same manner as in Example 1, except that the compounds listed in Table 4 were used as dopants when forming the emission layer.

### Evaluation Example 3

For each of the organic light-emitting devices manufactured in Example 11, Comparative Example 11R, Example 12, and Comparative Example 12R, driving voltage (V), maximum external quantum efficiency (Max EQE), maximum emission wavelength (nm) and lifetime (LT₉₇) were evaluated in the same manner as used in Evaluation Example 1. Results thereof are shown in Table 4. The maximum external quantum efficiency and lifetime were expressed as relative values (%).

**Table 4**

| | Dopant in emission layer | Driving voltage (V) | Max EQE (relative value, %) | Maximum emission wavelength (nm) | LT₉₇ (relative value, %) (at 6,000 nit) |
|---|---|---|---|---|---|
| Example 11 | 99 | 4.3 | 109 | 522 | 135 |
| Comparative Example 11R | 99R | 4.5 | 100 | 521 | 100 |
| Example 12 | 103 | 4.3 | 106 | 525 | 120 |
| Comparative Example 12R | 103R | 4.3 | 96 | 524 | 90 |

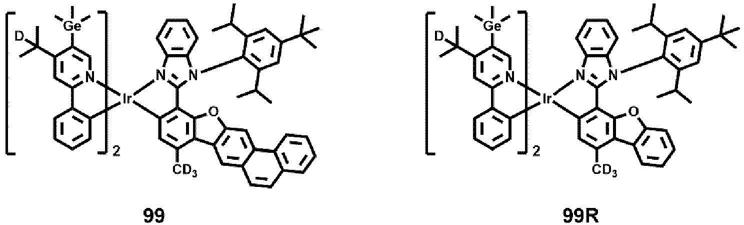

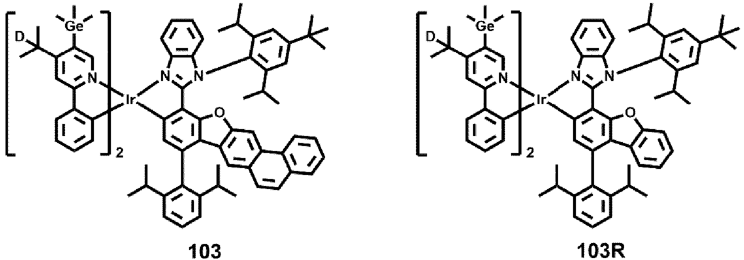

As shown in Table 4, the organic light-emitting device of Example 11 has an improved driving voltage, improved external quantum efficiency, and improved lifetime compared to the organic light-emitting device of Comparative Example 11R. Similarly, the organic light-emitting device of Example 12 has an improved driving voltage, equivalent external quantum efficiency, and improved lifetime compared to the organic light-emitting device of Comparative Example 12R.

### Comparative Example 13R

An organic light-emitting device was manufactured in the same manner as in Example 1, except that the compound listed in Table 5 was used as a dopant when forming the emission layer.

### Evaluation Example 4

The maximum emission wavelength (nm) of the organic light-emitting device manufactured in Comparative Example 13R was evaluated by using the same method as described in Evaluation Example 1, and the result is shown in Table 5 together with the maximum emission wavelengths of the organic light-emitting devices of Examples 11 and 12.

**Table 5**

| | Dopant in emission layer | Maximum emission wavelength (nm) |
|---|---|---|
| Example 11 | 99 | 522 |
| Example 12 | 103 | 525 |
| Comparative Example 13R | Ref2 | 531 |

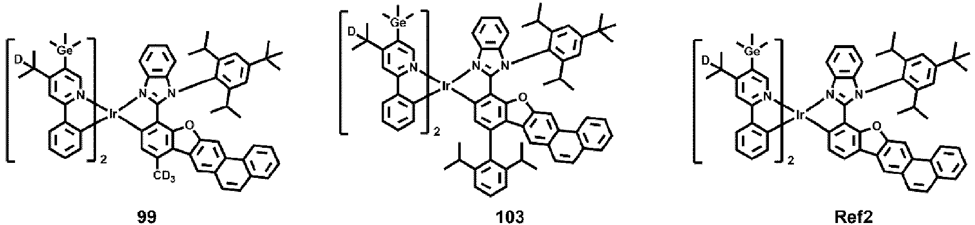

As shown in Table 5, the organic light-emitting devices of Examples 11 and 12 have a smaller maximum emission wavelength, for example, in the range of 510 nm to 529 nm, than the organic light-emitting device of Comparative Example 13R. Example 21, Comparative Example 21R, Example 22, and Comparative Example 22R

Organic light-emitting devices were manufactured in the same manner as in Example 1, except that the compounds listed in Table 6 were used as dopants when forming the emission layer.

### Evaluation Example 5

For each of the organic light-emitting devices manufactured in Example 21, Comparative Example 21R, Example 22, and Comparative Example 22R, driving voltage (V), maximum external quantum efficiency (Max EQE), maximum emission wavelength (nm) and lifetime (LT₉₇) were evaluated in the same manner as used in Evaluation Example 1. Results thereof are shown in Table 6. The maximum external quantum efficiency and lifetime were expressed as relative values (%).

**Table 6**

| | Dopant in emission layer | Driving voltage (V) | Max EQE (relative value, %) | Maximum emission wavelength (nm) | LT₉₇ (relative value, %) (at 6,000 nit) |
|---|---|---|---|---|---|
| Example 21 | 110 | 4.1 | 107 | 522 | 135 |
| Comparative Example 21R | 110R | 4.2 | 100 | 522 | 100 |
| Example 22 | 111 | 4.1 | 104 | 526 | 125 |
| Comparative Example 22R | 111R | 4.2 | 94 | 525 | 90 |

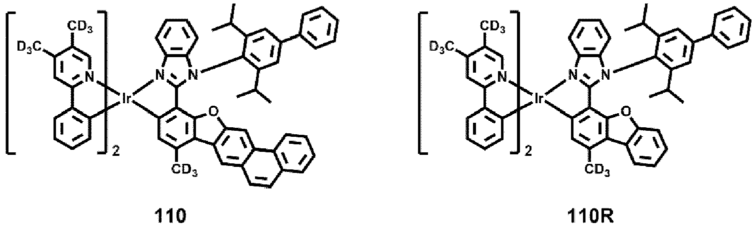

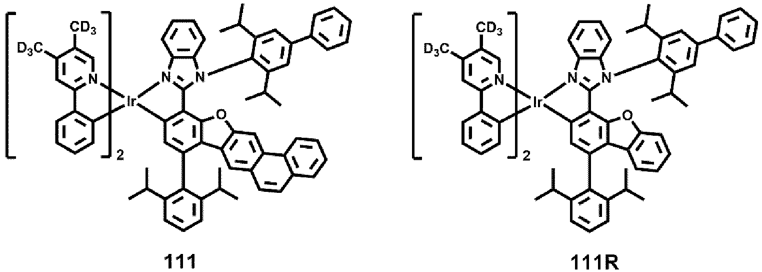

As shown in Table 6, the organic light-emitting device of Example 21 has an improved driving voltage, improved external quantum efficiency, and improved lifetime compared to the organic light-emitting device of Comparative Example 21R. Similarly, the organic light-emitting device of Example 22 has an improved driving voltage, improved external quantum efficiency, and improved lifetime compared to the organic light-emitting device of Comparative Example 22R.

### Comparative Example 23R

An organic light-emitting device was manufactured in the same manner as in Example 1, except that the compound listed in Table 7 was used as a dopant when forming the emission layer.

### Evaluation Example 6

The maximum emission wavelength (nm) of the organic light-emitting device manufactured in Comparative Example 23R was evaluated by using the same method as described in Evaluation Example 1, and the result is shown in Table 7 together with the maximum emission wavelengths of the organic light-emitting devices of Examples 21 and 22.

**Table 7**

| | Dopant in emission layer | Maximum emission wavelength (nm) |
|---|---|---|
| Example 21 | 110 | 522 |
| Example 22 | 111 | 526 |
| Comparative Example 23R | Ref3 | 532 |

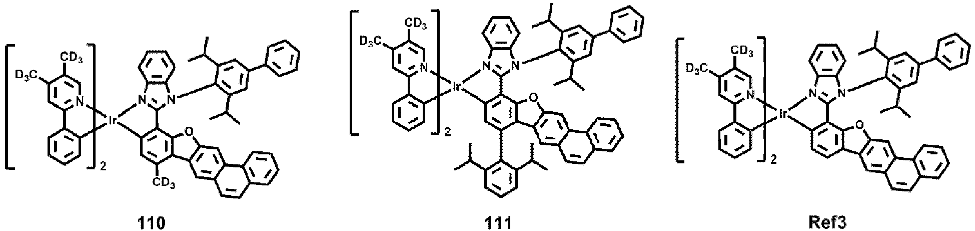

As shown in Table 7, the organic light-emitting devices of Examples 21 and 22 have a smaller maximum emission wavelength, for example, in the range of 510 nm to 529 nm, than the organic light-emitting device of Comparative Example 23R.

### Examples 31 to 34 and Comparative Example 31R

Organic light-emitting devices were manufactured in the same manner as in Example 1, except that the compounds listed in Table 8 were used as dopants when forming the emission layer.

### Evaluation Example 7

For each of the organic light-emitting devices manufactured in Examples 31 to 34 and Comparative Example 31R, driving voltage (V), maximum external quantum efficiency (Max EQE), maximum emission wavelength (nm), and lifetime (LT₉₇) were evaluated in the same manner as used in Evaluation Example 1. Results thereof are shown in Table 8. The maximum external quantum efficiency and lifetime were expressed as relative values (%).

**Table 8**

| | Dopant in emission layer | Driving voltage (V) | Max EQE (relative value, %) | Maximum emission wavelength (nm) | LT₉₇ (relative value, %) (at 6,000 nit) |
|---|---|---|---|---|---|
| Example 31 | 1 | 4.5 | 26 | 523 | 130 |
| Example 32 | 109 | 4.5 | 26 | 527 | 130 |
| Example 33 | 49 | 4.6 | 27 | 525 | 140 |
| Example 34 | 57 | 4.6 | 27 | 524 | 130 |
| Comparative Example 31R | Ref4 | 4.5 | 26 | 523 | 100 |

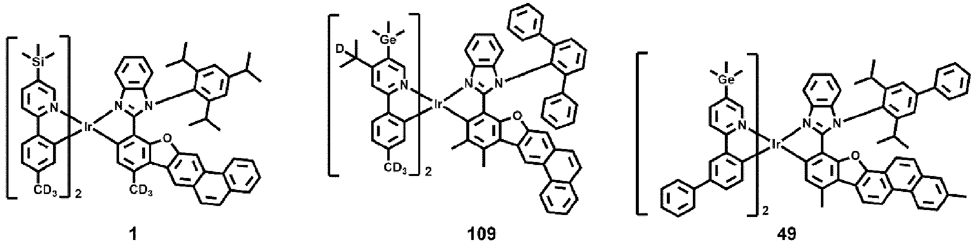

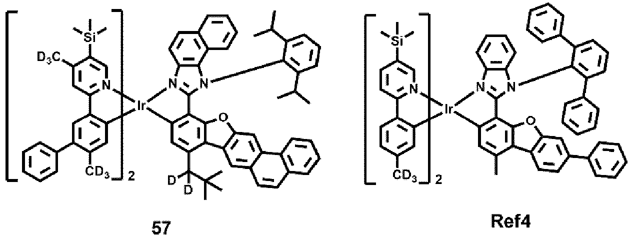

As shown in Table 8, it can be seen that the organic light-emitting devices of Examples 31 to 34 emit green light while having equivalent or improved external quantum luminescence efficiency and improved lifetime characteristics compared to the organic light-emitting device of Comparative Example 31R.

The organometallic compound according to the disclosure has excellent electrical properties, and accordingly, an electronic device, for example, a light-emitting device, using the organometallic compound, may have improved driving voltage, improved external quantum efficiency, and improved lifetime characteristics. The light-emitting device enables manufacture of high-quality electronic apparatuses. It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2-1,
L₂ is a ligand represented by Formula 2-2,
n1 and n2 are each independently 1 or 2, wherein, when n1 is 2, two of L₁ are identical to or different from each other, and when n2 is 2, two of L₂ are identical to or different from each other, and
L₁ and L₂ are different from each other, 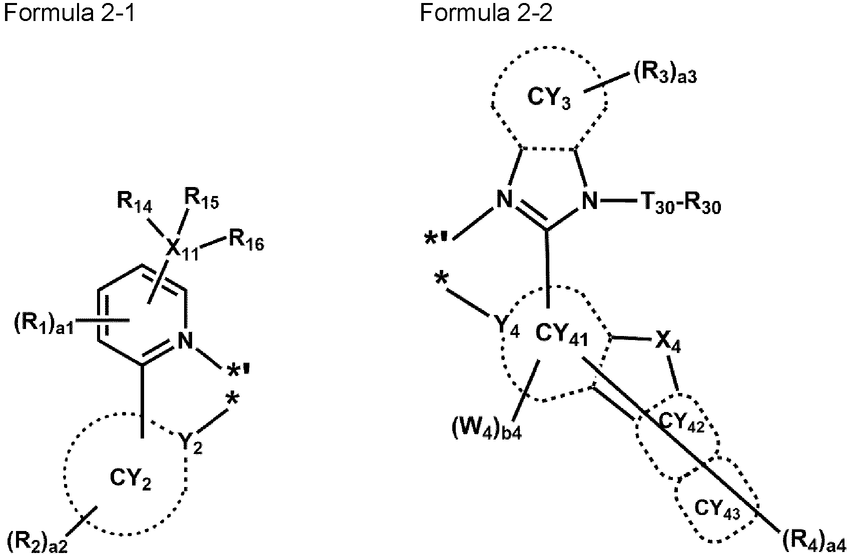 wherein, in Formulae 2-1 and 2-2,
Y₂ and Y₄ are each independently C or N,
ring CY₂, ring CY₃, and ring CY₄₁ to ring CY₄₃ are each independently a C₅-C₃₀ carbocyclic group or a C₁-C₃₀ heterocyclic group,
X₁₁ is C, Si, or Ge,
T₃₀ is a single bond, a C₁-C₂₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ,
X4 is O, S, Se, N(R₄₈), C(R₄₈)(R₄₉), or Si(R₄₈)(R₄₉),
R₁ to R₄, R₁₄ to R₁₆, R₃₀, R₄₈, and R₄₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), -B(Q₆)(Q₇), -P(=O)(Q₈)(Q₉), or-P(Q₈)(Q₉),
a1 is an integer from 0 to 3,
a2 to a4 are each independently an integer from 0 to 20,
W₄ is a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group,
b4 is an integer from 1 to 10,
two or more of a plurality of R₁ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of a plurality of R₂ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₃ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of a plurality of R₄ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of R₁ to R₄ or R₃₀ are optionally linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
R₁₀ₐ is as described in connection with R₂,
* and *' each indicate a binding site to M in Formula 1,
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group,-Si(Q₁₁)(Q₁₂)(Q₁₃), -Ge(Q₁₁)(Q₁₂)(Q₁₃), -N(Q₁₄)(Q₁₅), - B(Q₁₆)(Q₁₇), -P(=O)(Q₁₈)(Q₁₉),-P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂,-CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, **-**Si(Q₂₁)(Q₂₂)(Q₂₃),-Ge(Q₂₁)(Q₂₂)(Q₂₃), -N(Q₂₄) (Q₂₅), -B(Q₂₆)(Q₂₇), -P(=O)(Q₂₈)(Q₂₉), P(Q₂₈)(Q₂₉), or a combination thereof;
**-**Si(Q₃₁)(Q₃₂)(Q₃₃), -Ge(Q₃₁)(Q₃₂)(Q₃₃), -N(Q₃₄)(Q₃₆), -B(Q₃₆)(Q₃₇),-P(=O)(Q₃₈)(Q₃₉), or -P(Q₃₈)(Q₃₉); or
a combination thereof, and
Q₁ to Q₉, Q₁₁ to Q₁₉, Q₂₁ to Q₂₉ and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein
ring CY₂ is a benzene group, a naphthalene group, an anthracene group, a phenanthrene group, a 1,2,3,4-tetrahydronaphthalene group, a carbazole group, a fluorene group, a dibenzosilole group, a dibenzothiophene group, a dibenzofuran group, a dibenzoselenophene group, a pyridine group, a benzoxazole group, a benzothiazole group, or a benzene group that is condensed with a norbornane group.

3. The organometallic compound of claims 1 or 2, wherein ring CY₃ and ring CY₄₁ to ring CY₄₃ are each independently:
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group; or
a benzene group, a pyridine group, a pyrimidine group, a pyridazine group, a pyrazine group, a triazine group, a naphthalene group, a quinoline group, an isoquinoline group, a quinazoline group, a quinoxaline group, a phenanthrene group, a benzoquinoline group, a benzoisoquinoline group, an anthracene group, or a chrysene group, each condensed with a cyclohexane group, a norbornane group, an adamantane group, or a combination thereof.

4. The organometallic compound of any of claims 1-3, wherein L₂ is a ligand represented by Formula 2-2A: 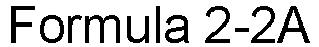 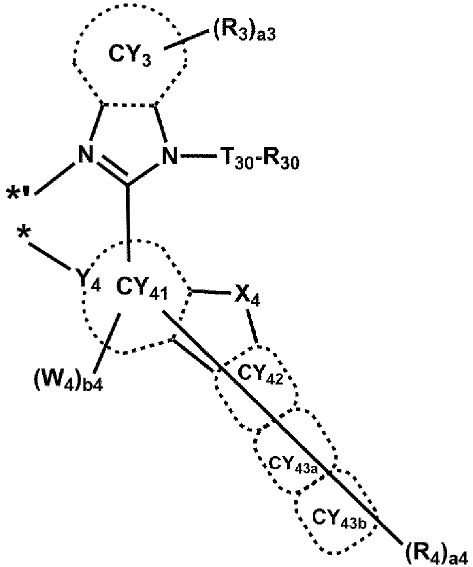 wherein, in Formula 2-2A,
Y₄, ring CY₃, ring CY₄₁, ring CY₄₂, T₃₀, X₄, R₃, R₄, R₃₀, a3, a4, W₄, and b4 are as described in claim 1, and
ring CY₄₃ₐ and ring CY_{43b} are each independently a C₅-C₁₅ carbocyclic group or a C₁-C₁₅ heterocyclic group.

5. The organometallic compound of any of claims 1-4, wherein T₃₀ is:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

6. The organometallic compound of any of claims 1-5, wherein R₁ to R₄, R₃₀, R₄₈ and R₄₉ are each independently:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, - Si(Q₃₁)(Q₃₂)(Q₃₃),
-Ge(Q₃₁)(Q₃₂)(Q₃₃), or a combination thereof,
R₁₄ to R₁₆ are each independently a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

7. The organometallic compound of any of claims 1-6, wherein W₄ is
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group,
each unsubstituted or substituted with at least one of:
deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₁)(Q₃₂)(Q₃₃), - Ge(Q₃₁)(Q₃₂)(Q₃₃), or a combination thereof.

8. The organometallic compound of any of claims 1-7, wherein a group represented by: 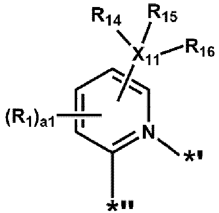 in Formula 2-1 is a group represented by one of Formulae CY1-1 to CY1-3: 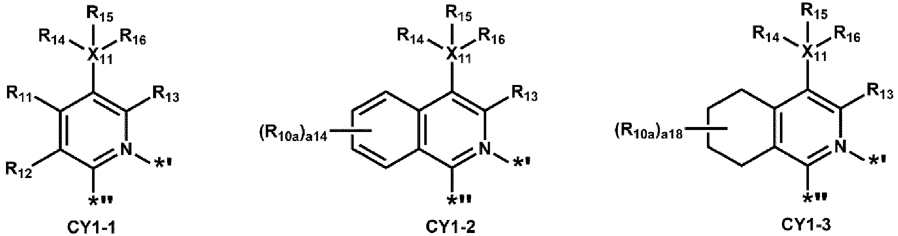 wherein, in Formulae CY1-1 to CY1-3,
X₁₁, R₁₄ to R₁₆, and R₁₀ₐ are as described in claim 1,
each of R₁₁ to R₁₃ is as described in connection with R₁ in claim 1, a14 is an integer from 0 to 4,
a18 is an integer from 0 to 8,
*' indicates a binding site to M in Formula 1, and
*" indicates a binding site to a neighboring atom in Formula 2-1; and/or
wherein a group represented by: 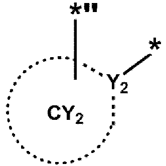 in Formula 2-1 is a group represented by one of Formulae CY2-1 to CY2-33: 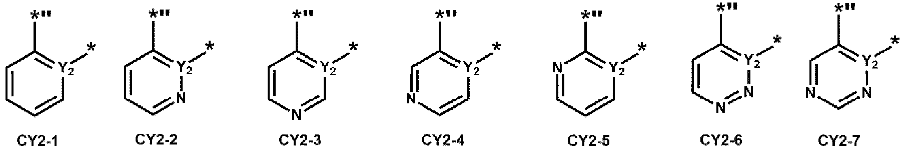 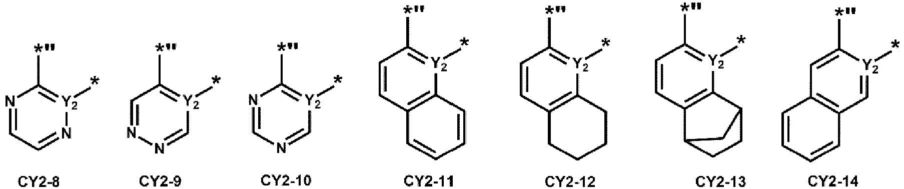 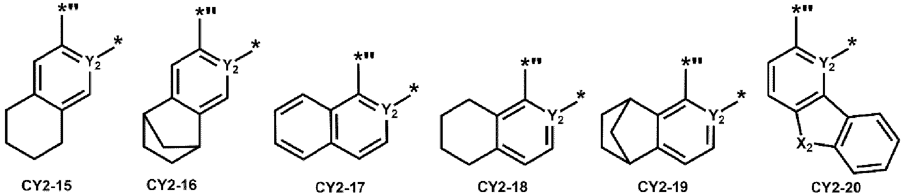 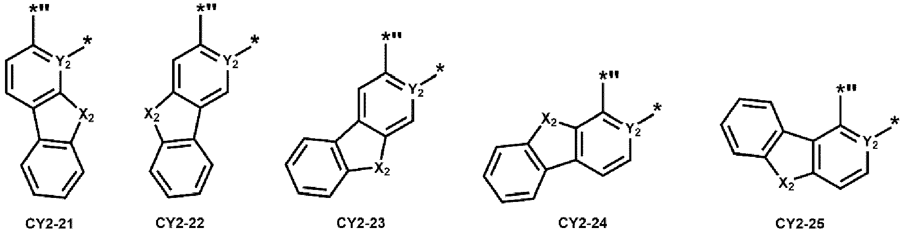 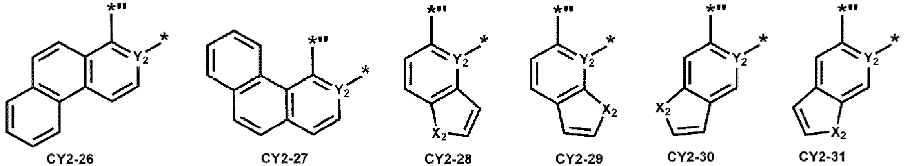 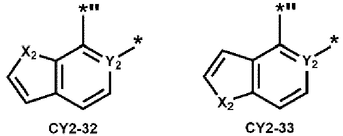 wherein, in Formulae CY2-1 to CY2-33,
Y₂ is as described in claim 1,
X₂ is O, S, Se, N(R₂₈), C(R₂₈)(R₂₉), or Si(R₂₈)(R₂₉),
each of R₂₈ and R₂₉ is as described in connection with R₂ in claim 1,
*" indicates a binding site to a neighboring atom in Formula 2-1, and
* indicates a binding site to M in Formula 1.

9. The organometallic compound of any of claims 1-8, wherein a group represented by: 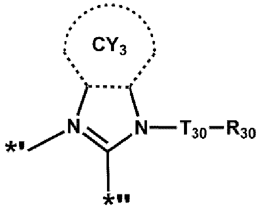 in Formula 2-2 is a group represented by one of Formulae CY3-1 to CY3-21: 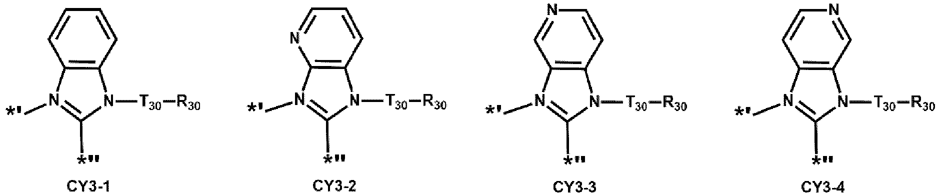 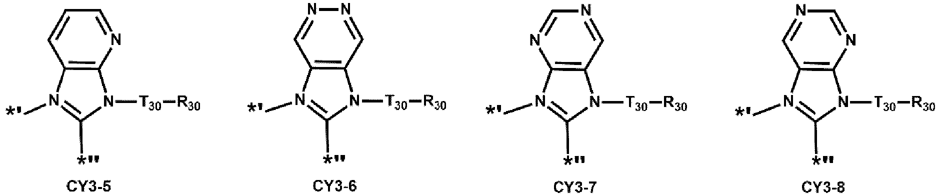 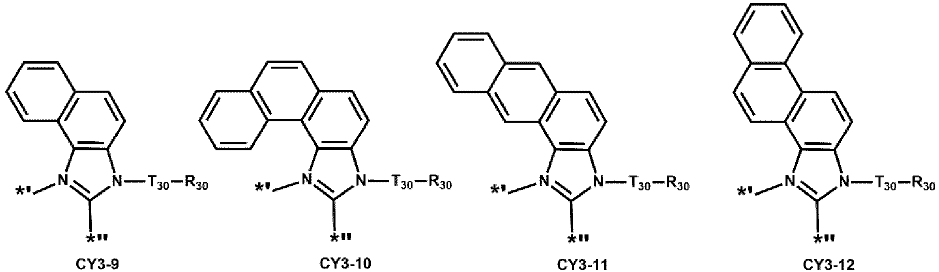 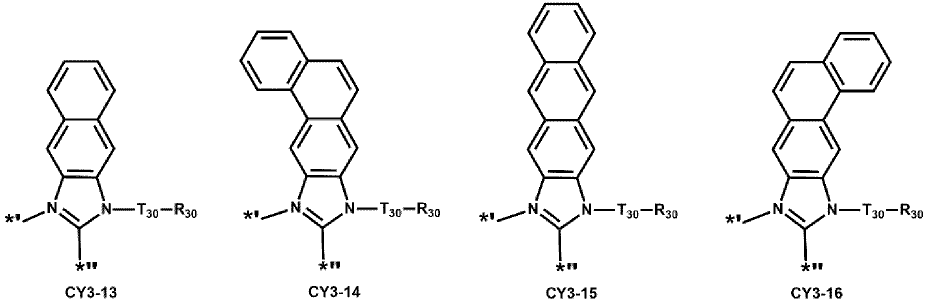 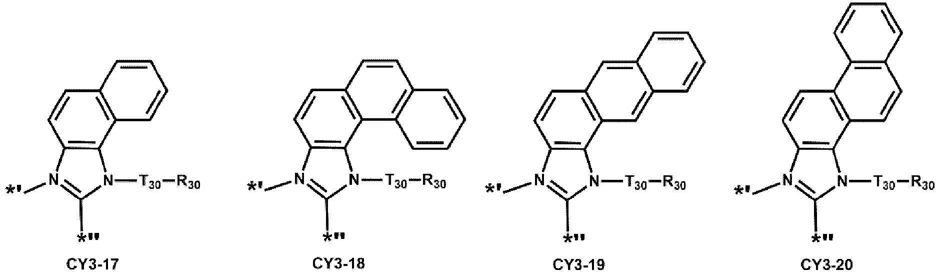 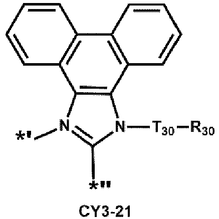 wherein, in Formulae CY3-1 to CY3-21,
T₃₀ and R₃₀ are as described in claim 1,
*' indicates a binding site to M in Formula 1, and
*" indicates a binding site to a neighboring atom in Formula 2-2; and/or
wherein a group represented by: 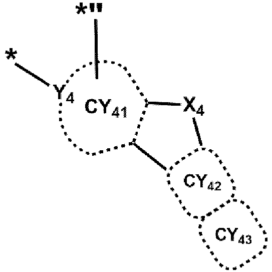 in Formula 2-2 is represented by one of Formulae CY4-1 to CY4-6: 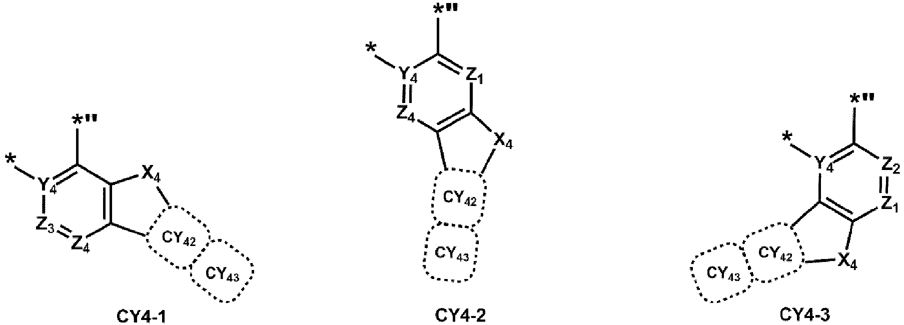 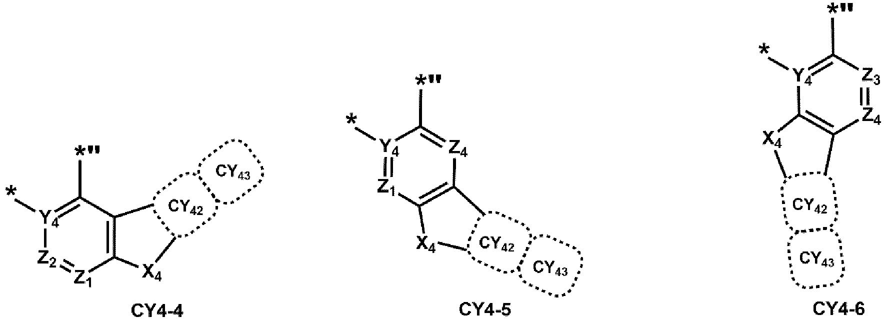 wherein, in Formulae C4-1 to C4-6,
Y₄, X₄, ring CY₄₂ and ring CY₄₃ are each as described in claim 1,
Z₁ to Z₄ are each independently N or C,
* indicates a binding site to M in Formula 1, and
*" indicates a binding site to a neighboring atom in Formula 2-2.

10. The organometallic compound of any of claims 1-9, wherein a group represented by: 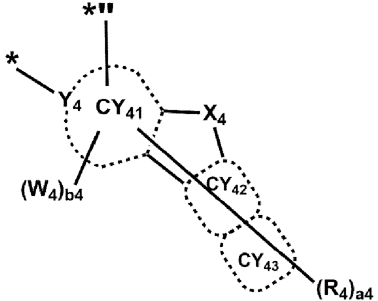 in Formula 2-2 is represented by one of Formulae CY4(1) to CY4(18): 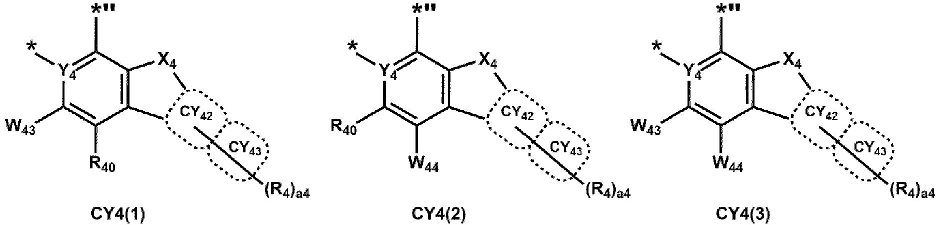 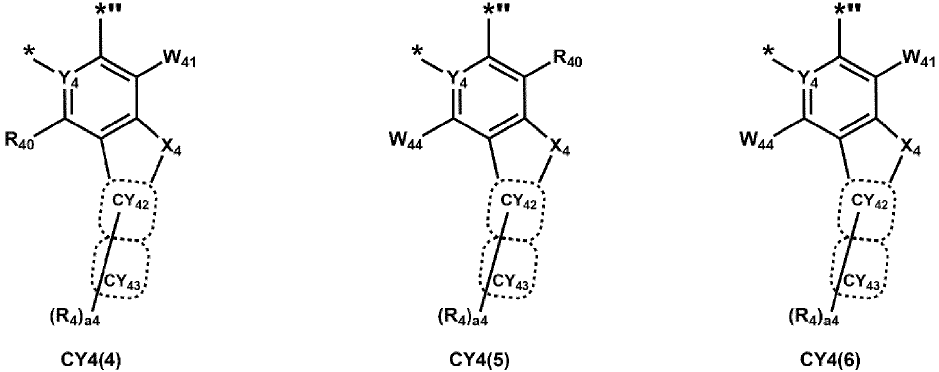 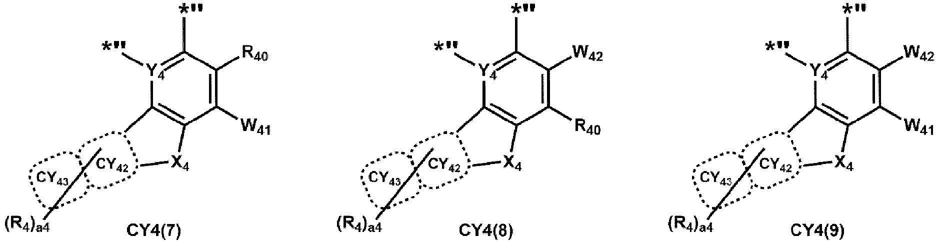 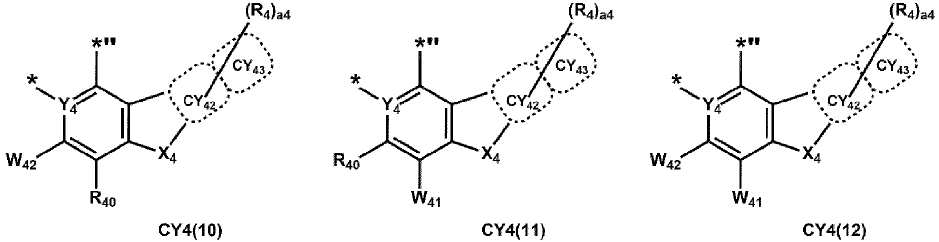 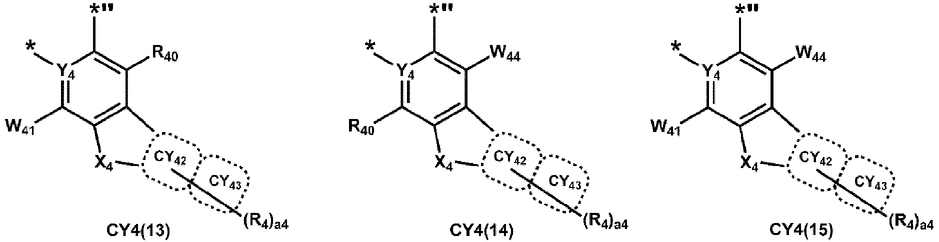 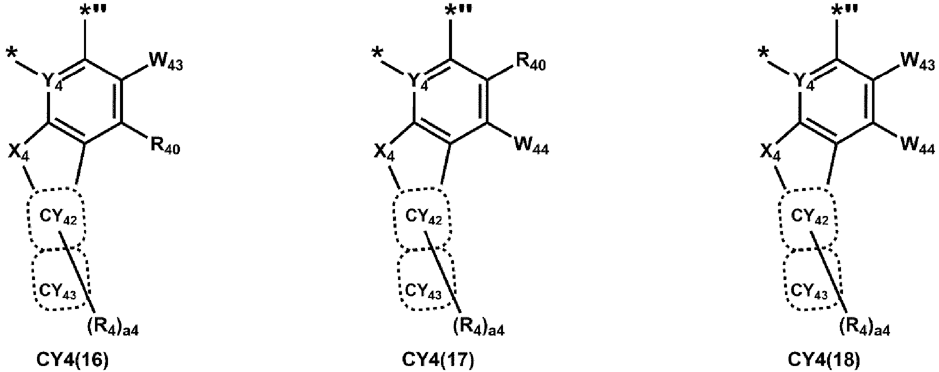 wherein, in Formulae CY4(1) to CY4(18),
Y₄, ring CY₄₂, ring CY₄₃, and R₄ are as described in claim 1,
each of W₄₁ to W₄₄ is as described in connection with W₄ in claim 1,
R₄₀ is as described in connection with R₄ in claim 1,
a4 is an integer from 0 to 10,
* indicates a binding site to M in Formula 1, and
*" indicates a binding site to a neighboring atom in Formula 2-2; and/or
wherein a group represented by: 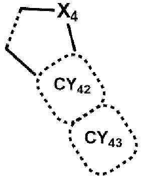 in 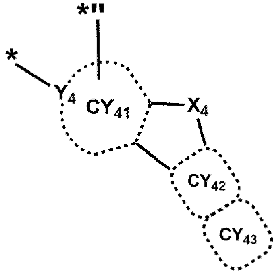 of Formula 2-2 is represented by one of Formulae CY401 to CY451: 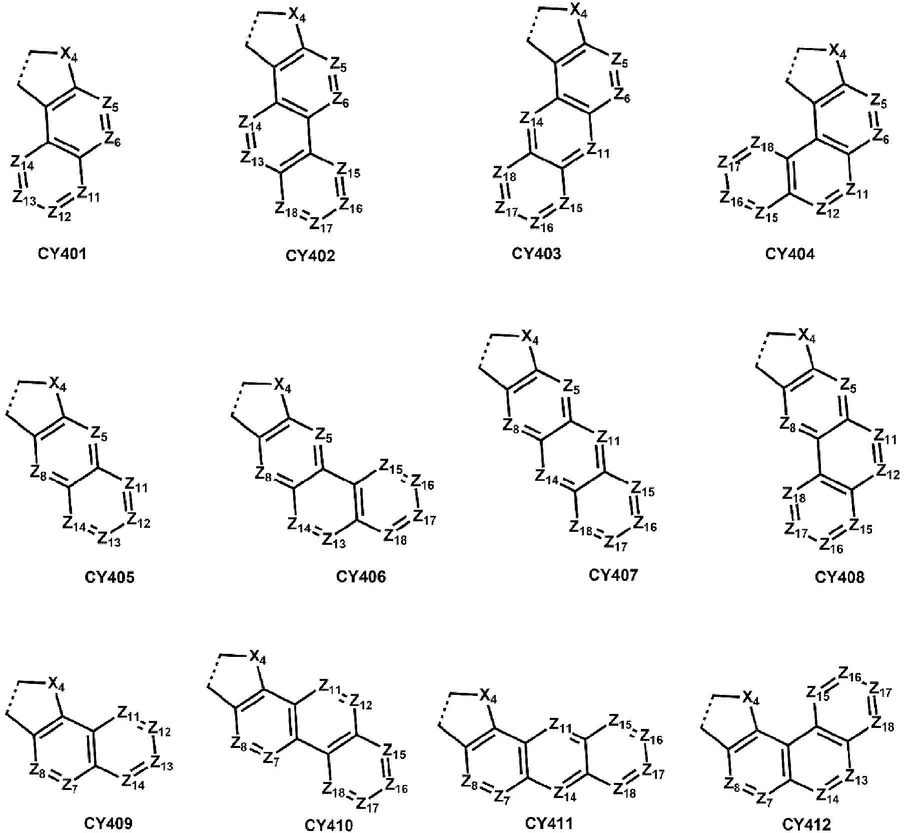 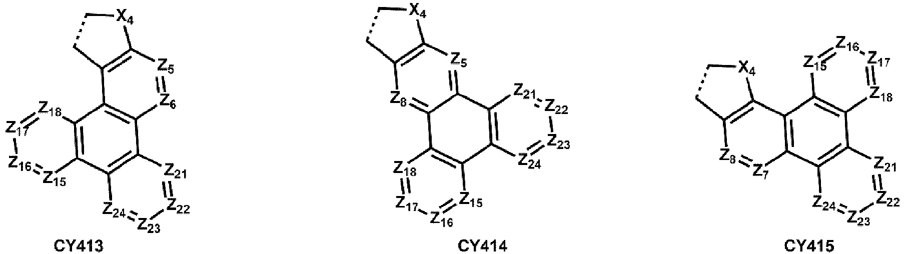 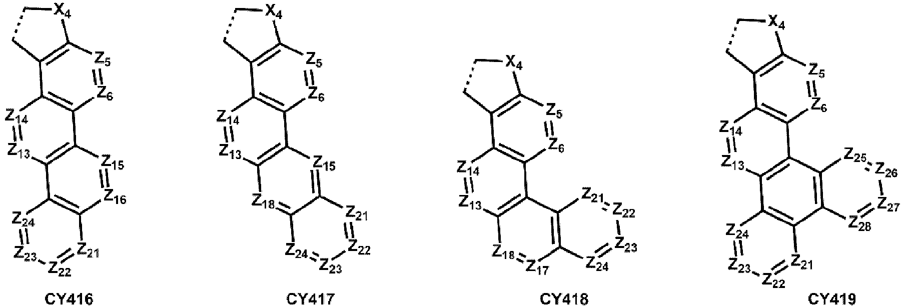 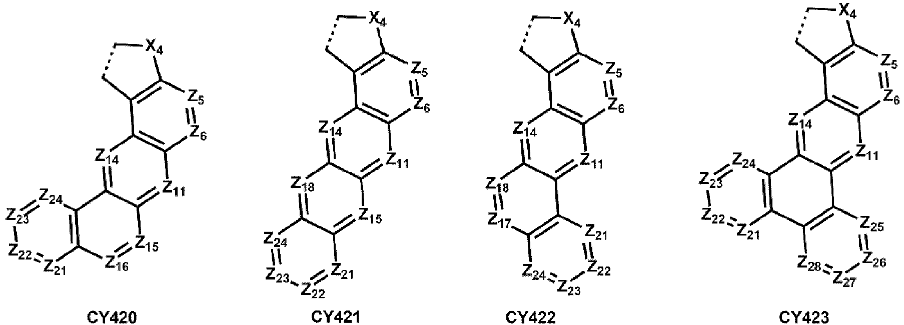 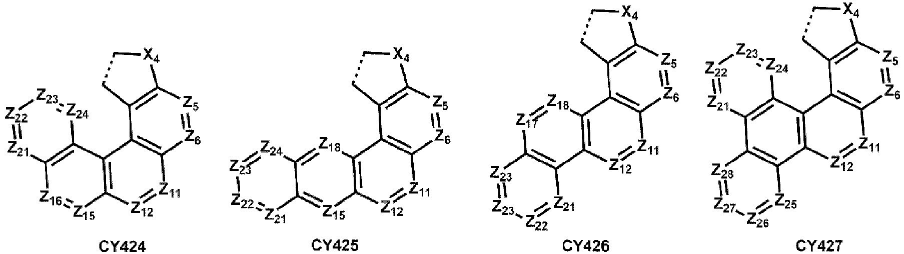 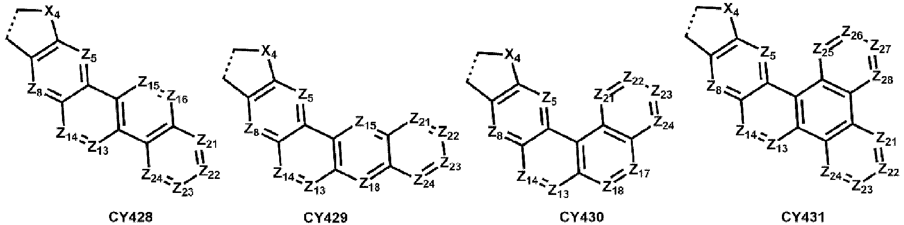 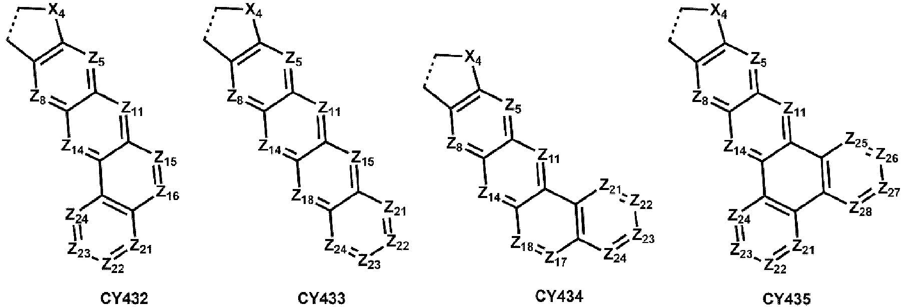 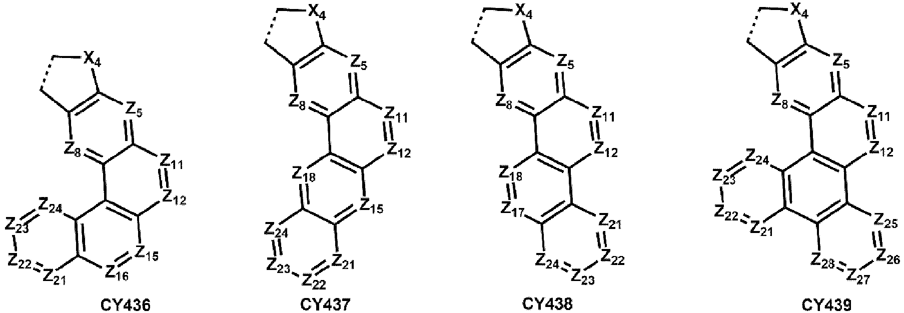 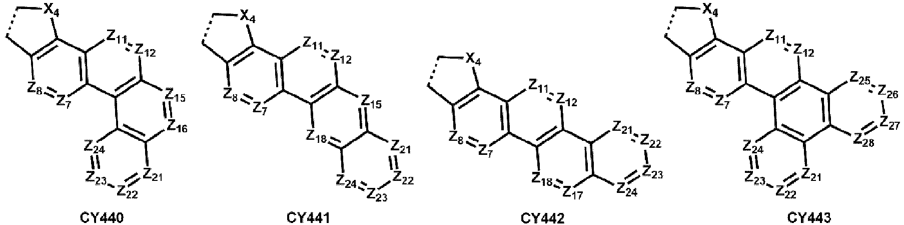 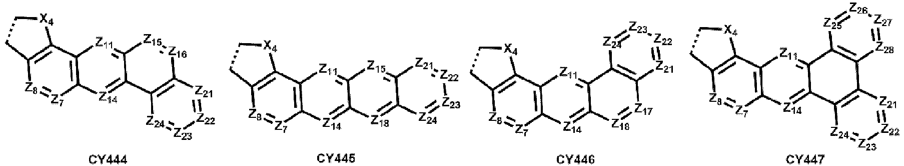 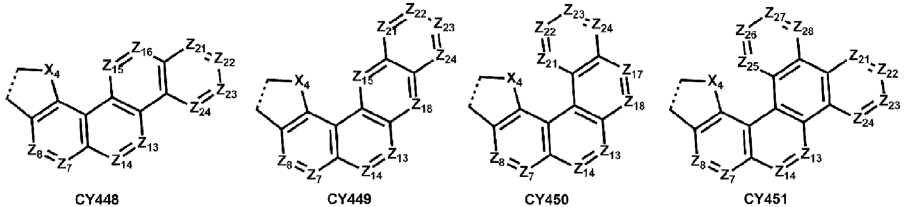 wherein, in Formulae CY401 to CY451,
X₄ is as described in claim 1,
Z₅ to Z₈, Z₁₁ to Z₁₈, and Z₂₁ to Z₂₈ are each independently N or C, and
an X₄-containing five-membered ring is condensed with ring CY₄₁ which is adjacent thereto.

11. The organometallic compound of any of claims 1-10, wherein the organometallic compound emits light having a maximum emission wavelength of 510 nanometers to 550 nanometers.

12. A light-emitting device, comprising:
a first electrode;
a second electrode; and
an interlayer arranged between the first electrode and the second electrode,
wherein the interlayer comprises an emission layer, and
wherein the interlayer further comprises at least one of the organometallic compound of any of claims 1-11;
preferably wherein
the first electrode is an anode,
the second electrode is a cathode,
the interlayer further comprises a hole transport region arranged between the first electrode and the emission layer, and an electron transport region arranged between the emission layer and the second electrode,
the hole transport region comprises a hole injection layer, a hole transport layer, an electron-blocking layer, a buffer layer, or a combination thereof, and
the electron transport region comprises a hole-blocking layer, an electron transport layer, an electron injection layer, or a combination thereof.

13. The light-emitting device of claim 12, wherein the emission layer comprises at least one of the organometallic compound.

14. The light-emitting device of claim 13, wherein the emission layer emits a green light; and/or
wherein the emission layer further comprises a host, and an amount of the host in the emission layer is greater than an amount of the at least one of the organometallic compound in the emission layer, based on weight.

15. An electronic apparatus, comprising the light-emitting device of any of claims 12-14.
